# EUROPEAN PATENT APPLICATION

(11) **EP 4 790 056 A1**
(43) Date of publication of application: **12.08.2026**
(21) Application number: 26156969.3
(22) Date of filing: 06.02.2026
(51) Int. Cl.: C07F 5/02, C09K 11/06, H10K 85/60

(54) **CONDENSED HETEROCYCLIC COMPOUND, LIGHT-EMITTING DEVICE AND ELECTRONIC DEVICE**

(30) Priority: 11.02.2025 KR 20250017472
(71) Applicant: Samsung Display Co., Ltd., Yongin-si, Gyeonggi-do 17113 (KR)
(72) Inventor: SUNG, Min Jae, Yongin-si (KR); RYOO, Chi Hyun, Yongin-si (KR); KIM, Hyung Jong, Yongin-si (KR); MIYASHITA, Hirokazu, Yongin-si (KR); PARK, Jun Ha, Yongin-si (KR); PAK, Han Kyu, Yongin-si (KR); SIM, Mun Ki, Yongin-si (KR); JUNG, Min Jung, Yongin-si (KR)
(74) Representative: Marks & Clerk LLP

(57) **Abstract**

Aspects provide a condensed heterocyclic compound represented by Chemical Formula 1, a light-emitting device that includes at least one of the condensed heterocyclic compounds represented by Chemical Formula 1, and an electronic device that includes the light-emitting device. The light-emitting device includes a first electrode, a second electrode, and an intermediate layer disposed between the first electrode and the second electrode. The intermediate layer includes at least one of the condensed heterocyclic compounds represented by Chemical Formula 1.

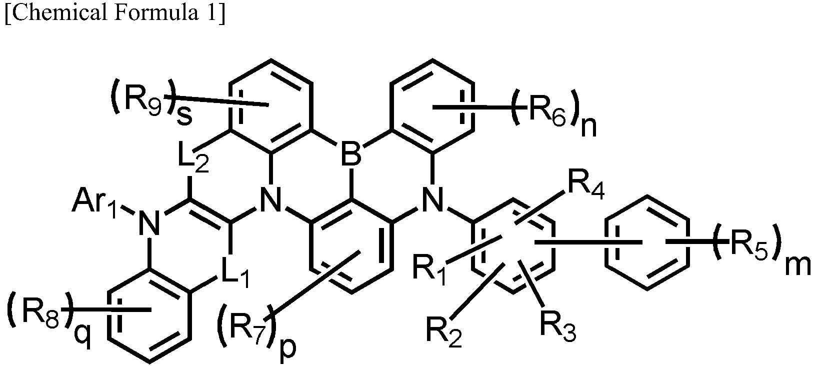

The substituent groups for Chemical Formula 1 are as described herein.

## Description

### TECHNICAL FIELD

Aspects of the present disclosure relate to a condensed heterocyclic compound, a light-emitting device including at least one of the heterocyclic compounds, and an electronic device including the light-emitting device.

### BACKGROUND

An organic light-emitting device (OLED) has a self-luminous property, and may provide improved viewing angle and contrast properties. Additionally, a high response speed and a high luminance may be provided by an OLED.

The light-emitting device may include an emission layer disposed between a first electrode and a second electrode. A hole transferred from the first electrode and an electron transferred from the second electrode may be recombined in the emission layer to generate an exciton. Light emission properties are implemented as the exciton is shifted from an excited state to a ground state.

The emission layer may include a host material and a dopant material for implementing the above-described light-emitting mechanism.

### SUMMARY

According to an aspect, there is provided a condensed heterocyclic compound having improved spectroscopic and luminescent properties.

According to an aspect, there is provided a light-emitting device including at least one of the condensed heterocyclic compounds, and having improved luminescent properties and reliability.

According to an aspect, there is provided an electronic device including the light-emitting device.

According to an aspect, a condensed heterocyclic compound represented by Chemical Formula 1 is provided.

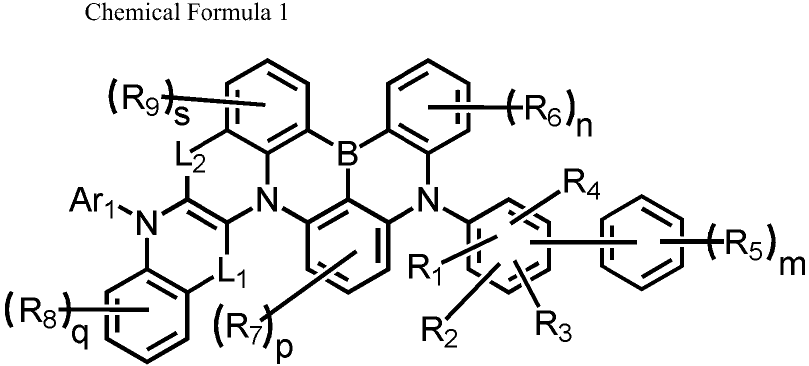

In Chemical Formula 1, L₁ and L₂ are each independently a direct bond or CR₁₀. Ar₁ is a substituted or unsubstituted C₆-C₆₀ aryl group or a substituted or unsubstituted C₁-C₆₀ heteroaryl group.

One of R₁ to R₄ is a substituted or unsubstituted C₆-C₆₀ aryl group, or a substituted or unsubstituted C₁-C₆₀ heteroaryl group; or two adjacent ones of R₁ to R₄ are combined with each other to form a substituted or unsubstituted C₆-C₆₀ aryl group, or a substituted or unsubstituted C₁-C₆₀ (e.g. C₂-C₆₀) heteroaryl group.

A remainder of R₁ to R₄, and R₅ to R₁₀ are each independently hydrogen, deuterium, halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₆-C₆₀ aryloxy group, a substituted or unsubstituted C₆-C₆₀ arylthio group, a substituted or unsubstituted C₁-C₆₀ heteroaryloxy group, a substituted or unsubstituted C₁-C₆₀ heteroarylthio group, a substituted or unsubstituted C₈-C₆₀ condensed polycyclic group, - SiRR'R", -PRR', -P(=O)RR', -NRR', -BRR', -C(=O)R, -S(=O)R, or -S(=O)₂R; two or more adjacent ones of the remainder of R₁ to R₄, and R₅ to R₁₀ are optionally combined with each other to form a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, or a substituted or unsubstituted C₁-C₆₀ heteroaryl group,

R, R', and R" are each independently hydrogen, deuterium, halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₆-C₆₀ aryloxy group, a substituted or unsubstituted C₆-C₆₀ arylthio group, a substituted or unsubstituted C₁-C₆₀ heteroaryloxy group, a substituted or unsubstituted C₁-C₆₀ heteroarylthio group, or a substituted or unsubstituted C₈-C₆₀ condensed polycyclic group.

m is an integer from 0 to 5, n and q are each independently an integer from 0 to 4, and p and s are each independently an integer from 0 to 3. When n, m, p, q, and s are each independently 2 or more, each of R₅ to R₉ is independently the same as or different from each other.

A light-emitting device includes a first electrode, a second electrode, and an intermediate layer disposed between the first electrode and the second electrode. The intermediate layer includes at least one condensed heterocyclic compound represented by Chemical Formula 1.

An electronic device includes the light-emitting device.

A least some of the above and other features of the invention are set out in the claims.

A condensed heterocyclic compound represented by Chemical Formula 1 has a two-nitrogen-containing core structure, for example, a core structure including an indoloindole or quinoloquinoline moiety, and may be used as a green light-emitting material.

The condensed heterocyclic compound represented by Chemical Formula 1 may have a high depth of a HOMO energy level, and may have improved luminous efficiency.

The condensed heterocyclic compound represented by Chemical Formula 1 may have a three-dimensional chemical structure, thereby increasing a distance to a host and reducing a side reaction due to interaction between molecules. Thus, a light-emitting device having improved life-span properties may be implemented by using at least one of the condensed heterocyclic compounds represented by Chemical Formula 1.

### BRIEF DESCRIPTION OF THE DRAWINGS

FIGS. 1 to 6 are schematic cross-sectional views illustrating light-emitting devices in accordance with example embodiments.
FIG. 7 is a schematic cross-sectional view illustrating a display device in accordance with example embodiments.
FIG. 8 is a schematic cross-sectional view illustrating a display device in accordance with example embodiments.
FIG. 9 is a schematic cross-sectional view illustrating a stack construction of light-emitting structure in a display device in accordance with example embodiments.
FIG. 10 is a schematic cross-sectional view illustrating a display device in accordance with example embodiments.
FIG. 11 is a schematic cross-sectional view illustrating a display device in accordance with example embodiments.
FIG. 12 is a schematic exploded perspective view illustrating an electronic device in accordance with example embodiments.
FIG. 13 is a schematic diagram of an electronic device in accordance with various embodiments.
FIG. 14 is a block diagram of an electronic device in accordance with one or more embodiments.
FIG. 15 is a diagram illustrating electronic devices in accordance with example embodiments.

### DETAILED DESCRIPTION

Provided is a condensed heterocyclic compound that includes an aryl group bonded to nitrogen forming a condensed ring group. Further, a light-emitting device and an electronic device including the condensed heterocyclic compound are provided.

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are described below, by referring to the figures, to explain one or more aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity *(i.e.,* the limitations of the measurement system). For example, "about" can mean within one or more standard deviations, or within ± 30%, 20%, 10%, or 5% of the stated value.

As used herein, the term "substituted or unsubstituted" refers to being unsubstituted or substituted by one or more substituents including, e.g., a deuterium atom, a halogen atom, a cyano group, a nitro group, an amino group, an amine group, a silyl group, an oxy group, a thio group, a sulfinyl group, a sulfonyl group, a carbonyl group, an ester group, boron, a phosphine oxide group, a phosphine sulfide group, an alkyl group (e.g., a C₁-C₆₀, C₁-C₁₀ alkyl group, or the like), an alkenyl group (e.g., a C₂-C₆₀, C₂-C₁₀ alkenyl group, or the like), an alkynyl group (e.g., a C₂-C₆₀, C₂-C₁₀ alkynyl group, or the like), an alkoxy group (e.g., a C₁-C₆₀, C₁-C₁₀ alkoxy group, or the like), an alkylthio group, a hydrocarbon ring group, an aryl group (e.g., a C₆-C₆₀ aryl group or the like), or a heterocyclic group (e.g., a C₁-C₆₀ heterocyclic group or the like). For example, the term "substituted alkyl group" may refer to a group in which at least one of the hydrogen atoms of the alkyl group is substituted with one of the above-described substituent groups, and thus the substituent group is further bonded to a carbon atom of the alkyl group.

The substituent group may include a combination of substituent groups selected from the groups described herein. For example, at least one hydrogen atom in the alkyl group, the aryl group, etc., may be substituted with a deuterium atom, a halogen atom, a cyano group, a nitro group, an amino group, an amine group, a silyl group, an oxy group, a thio group, a sulfinyl group, a sulfonyl group, a carbonyl group, an ester group, boron, a phosphine oxide group, a phosphine sulfide group, an alkyl group, an alkenyl group, an alkynyl group, a hydrocarbon ring group, an aryl group, a heterocyclic group, or a combination thereof. In the disclosure, a hydrocarbon ring group may be any functional group or substituent derived from an aliphatic hydrocarbon ring or an aromatic hydrocarbon ring. For example, a hydrocarbon ring group may be a saturated hydrocarbon ring group having 5 to 30 or 5 to 20 ring-forming carbon atoms.

In the disclosure, an amine group may be an alkyl amine group or an aryl amine group. The alkyl group in the alkyl amine group may be linear, branched, or cyclic. The number of carbon atoms in the alkyl amine group is not specifically limited, but may be, for example, 1 to 20 or 1 to 10. The number of carbon atoms in the aryl amine group is not specifically limited, but may be, for example, 6 to 30, 6 to 20, or 6 to 15. Examples of an amine group may include a methylamine group, a dimethylamine group, a phenylamine group, a diphenylamine group, a naphthylamine group, a 9-methyl-anthracenylamine group, etc., but embodiments are not limited thereto.

In the disclosure, a silyl group may be an alkylsilyl group or an arylsilyl group. The alkyl group in the alkylsilyl group may be linear, branched or cyclic. The number of carbon atoms in the alkylsilyl group is not specifically limited, but may be, for example, 1 to 20 or 1 to 10. The number of carbon atoms in the arylsilyl group is not specifically limited, but may be, for example, 6 to 30, 6 to 20, or 6 to 15. Examples of a silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, etc., but embodiments are not limited thereto.

In the disclosure, an oxy group may be the alkyl group or the aryl group as defined herein that is bonded to an oxygen atom. An oxy group may be an alkoxy group or an aryl oxy group. An alkoxy group may be linear, branched, or cyclic. The number of carbon atoms in an alkoxy group is not particularly limited, and may be, for example, 1 to 20 or 1 to 10. The number of carbon atoms in an aryl oxy group is not specifically limited but the number of carbon atoms may be, for example, 6 to 30, 6 to 20, or 6 to 15. Examples of an oxy group may include a methoxy group, an ethoxy group, an n-propoxy group, an isopropoxy group, a butoxy group, a pentyloxy group, a hexyloxy group, an octyloxy group, a nonyloxy group, a decyloxy group, a benzyloxy group, etc., but embodiments are not limited thereto.

In the disclosure, a thio group may be an alkylthio group or an arylthio group. A thio group may be the alkyl group or the aryl group as defined herein that is bonded to a sulfur atom. The alkyl group in the alkylthio group may be linear, branched, or cyclic. The number of carbon atoms in the alkylthio is not specifically limited, but may be, for example, 1 to 20 or 1 to 10. The number of carbon atoms in the arylthio group is not specifically limited, but may be, for example, 6 to 30, 6 to 20, or 6 to 15. Examples of a thio group may include a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, etc., but embodiments are not limited thereto.

In the disclosure, the number of carbon atoms in a carbonyl group is not particularly limited, and may be 1 to 40, 1 to 30, or 1 to 20. For example, a carbonyl group may include one of the following structures, but embodiments are not limited thereto.

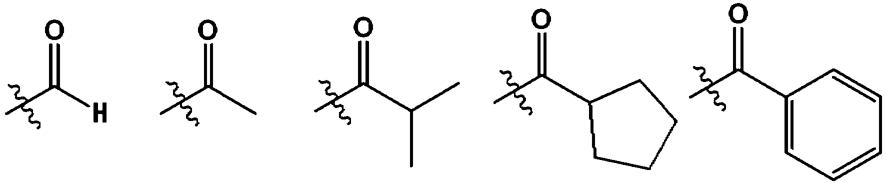

In the disclosure, an ester group may refer to -COOR, wherein R may be, for example, an alkyl group or an aryl group, e.g., a C₁-C₁₀ alkyl group.

In the disclosure, a boron group may be the alkyl group or the aryl group as defined herein that is bonded to a boron atom. A boron group may be an alkyl boron group or an aryl boron group. The alkyl group in the alkyl boron group may be linear, branched, or cyclic. The number of carbon atoms in the alkyl boron group is not specifically limited, but may be, for example, 1 to 20 or 1 to 10. The number of carbon atoms in the aryl boron group is not specifically limited, but may be, for example, 6 to 30, 6 to 20, or 6 to 15. Examples of a boron group may include a dimethylboron group, a diethylboron group, a t-butylmethylboron group, a diphenylboron group, a phenylboron group, etc., but embodiments are not limited thereto.

In the disclosure, the sulfinyl group may be the alkyl group or the aryl group as defined herein that is combined with an -S(=O)-. The number of carbon atoms of the sulfinyl group is not particularly limited, but may be 1 to 30, 1 to 20, or 1 to 10. The sulfinyl group may include an alkyl sulfinyl group and an aryl sulfinyl group. For example, the sulfinyl group may have the structure below, but is not limited thereto.

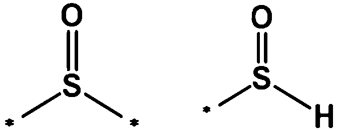

In the disclosure, the sulfonyl group may be the alkyl group or the aryl group as defined herein that is combined with an -S(=O)₂-. The number of carbon atoms of the sulfonyl group is not particularly limited, but may be 1 to 30, 1 to 20, or 1 to 10. The sulfonyl group may include an alkyl sulfonyl group and an aryl sulfonyl group. For example, the sulfonyl group may have the structure below, but is not limited thereto.

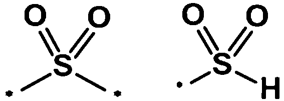

In the disclosure, the phosphine oxide group may be the alkyl group or the aryl group as defined herein that is combined with an -P(=O)-. The number of carbon atoms of the phosphine oxide group is not specifically limited, but may be 1 to 30, 1 to 20, or 1 to 10. The phosphine oxide group may include an alkyl phosphine oxide group and an aryl phosphine oxide group. For example, the phosphine oxide group may have the structure below, but is not limited thereto.

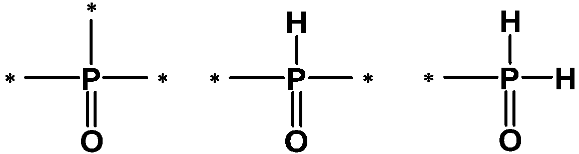

In the disclosure, the phosphine sulfide group may be the alkyl group or the aryl group as defined herein that is combined with an -P(=S)-. The number of carbon atoms of the phosphine sulfide group is not specifically limited, but may be 1 to 30, 1 to 20, or 1 to 10. The phosphine sulfide group may include an alkyl phosphine sulfide group and an aryl phosphine sulfide group. For example, the phosphine sulfide group may have the structure below, but is not limited thereto.

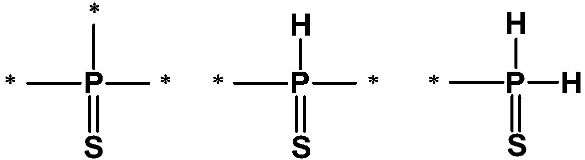

In the disclosure, the symbols 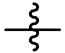 and -* each represent a bond linked to a neighboring atom in a corresponding formula or moiety.

In the substituents described herein, a multivalent substituent such as an amino group, boron, a phosphine sulfide group, a phosphine oxide group, a sulfinyl group, a sulfonyl group, an oxy group, a carbonyl group, an ester group, or the like, may each independently be substituted with a C₁-C₁₀ alkyl group, a C₂-C₁₀ alkenyl group, a C₂-C₁₀ alkynyl group, a C₆-C₁₀ aryl group, or a combination thereof.

As used herein, in the term "substituted or unsubstituted Cₐ-C_{b} Y group", the range of a to b refers to the number of carbon atoms in an unsubstituted Y group, and may not include the number of carbon atoms of a substituent when the Y group is substituted.

As used herein, the term "alkyl group" refers to a monovalent hydrocarbon group in which one hydrogen atom is removed from a linear or branched hydrocarbon group. Non-limiting examples of an alkyl group may include a methyl group, an ethyl group, a propyl group, a sec-butyl group, a tert-butyl group, an iso-butyl group, a pentyl group, a neopentyl group, a 2-ethyl butyl group, a 3,3-dimethyl butyl group, a hexyl group, a heptyl group, an octyl group, or the like.

As used herein, the term "alkylene group" refers to a divalent hydrocarbon group in which two hydrogen atoms are removed from a linear or branched hydrocarbon group.

As used herein, the term "alkenyl group" has the same skeleton as that of an alkyl group, and is a monovalent hydrocarbon group that includes at least one carbon-carbon double bond. As used herein, the term "alkenylene group" refers to a divalent hydrocarbon group in which one hydrogen atom is further removed from an alkenyl group.

As used herein, the term "alkynyl group" has the same skeleton as that of an alkyl group, and is a monovalent hydrocarbon group that includes at least one carbon-carbon triple bond. As used herein, the term "alkynylene group" refers to a divalent hydrocarbon group in which one hydrogen atom is further removed from an alkynyl group.

The term "cycloalkyl group" as used herein refers to a monovalent saturated hydrocarbon group having carbon atoms as ring-forming atoms, and non-limiting examples thereof include a cyclopropyl group, a cyclobutyl group, a cyclopentyl group, a cyclohexyl group, a cycloheptyl group, or the like. The term "cycloalkylene group" as used herein refers to a divalent group having the same structure as the cycloalkyl group.

The term "heterocycloalkyl group" as used herein refers to a monovalent saturated group having at least one heteroatom selected from B, N, O, P, Si, S, Se, and Ge as a ring-forming atom and carbon atom(s) as ring-forming atom(s), and non-limiting examples thereof include a tetrahydrofuranyl group, a tetrahydrothiophenyl group, or the like. The term "heterocycloalkylene group" as used herein refers to a divalent group having the same structure as the heterocycloalkyl group.

The term "cycloalkenyl group" as used herein refers to a monovalent group that has carbon atoms as ring-forming atoms and at least one carbon-carbon double bond in the ring thereof and no aromaticity, and non-limiting examples thereof include a cyclopentenyl group, a cyclohexenyl group, a cycloheptenyl group, or the like. The term "cycloalkenylene group" as used herein refers to a divalent group having the same structure as the cycloalkenyl group.

The term "heterocycloalkenyl group" as used herein refers to a monovalent group that has at least one heteroatom selected from B, N, O, P, Si, Ge, Se, and S as a ring-forming atom, and carbon atom(s) as ring-forming atom(s), and at least one double bond in its ring. Non-limiting examples of the heterocycloalkenyl group include a 2,3-dihydrofuranyl group, a 2,3-dihydrothiophenyl group, or the like. The term "heterocycloalkenylene group" as used herein refers to a divalent group having the same structure as the heterocycloalkenyl group.

The term "alkoxy group" as used herein refers to a monovalent group represented by -OA₁₀₁ (wherein A₁₀₁ is the alkyl group), and non-limiting examples thereof include a methoxy group, an ethoxy group, an isopropyloxy group, or the like.

The term "alkylthio group" as used herein refers to a monovalent group represented by -SA_{101'} (wherein A_{101'} is the alkyl group).

As used herein, the term "aryl group" refers to a monovalent hydrocarbon group in which one hydrogen atom is removed from a hydrocarbon group having an aromatic ring structure. The definition of an aryl group also encompasses a group in which multiple aromatic rings are directly connected, such as a biphenyl group, a terphenyl group, or a quaterphenyl group. Non-limiting examples of an aryl group may include a phenyl group, a naphthyl group, an anthracenyl group, a phenanthrenyl group, a pyrenyl group, a fluorenyl group, a tetracenyl group, a biphenyl group, a terphenyl group, a quaterphenyl group, a chrysenyl group, or the like.

As used herein, a group in which two or more aryl rings are condensed to each other or linked to each other by an alicyclic hydrocarbon ring, such as a fluorenyl group, is also encompassed in the definition of an aryl group.

For example, a biphenyl group may be interpreted as an aryl group, or may be interpreted as a phenyl group that is substituted with a phenyl group.

As used herein, the term "arylene group" refers to a divalent hydrocarbon group in which two hydrogen atoms are removed from an aryl group.

The term "alkyl aryl group" as used herein refers to an aryl group substituted with at least one alkyl group. The term "aryl alkyl group" as used herein refers to an alkyl group substituted with at least one aryl group.

As used herein, the term "heteroaryl group" refers to a monovalent group having a heteroaromatic ring structure that includes at least one heteroatom selected from B, N, O, P, S, Si, Se, and Ge as a ring-forming atom in addition to carbon atom(s). As used herein, the term "heteroarylene group" refers to a divalent group having a heteroaromatic ring structure that includes at least one heteroatom selected from B, N, O, P, S, Si, Se, and Ge as a ring-forming atom in addition to carbon atom(s). When a heteroaryl group or a heteroarylene group includes two or more heteroatoms, the two or more heteroatoms may be the same as or different from each other.

As used herein, a group in which two or more aryl rings are condensed or linked to a non-aromatic heterocyclic ring, such as a carbazole group, is also encompassed in the definition of a heteroaryl group.

The term "alkyl heteroaryl group" as used herein refers to a heteroaryl group substituted with at least one alkyl group. The term "heteroaryl alkyl group" as used herein refers to an alkyl group substituted with at least one heteroaryl group.

The term "aryloxy group" as used herein indicates -OA₁₀₂ (wherein A₁₀₂ is the aryl group), and the term "arylthio group" as used herein indicates -SA₁₀₃ (wherein A₁₀₃ is the aryl group).

The term "heteroaryloxy group" as used herein indicates -OA₁₀₄ (wherein A₁₀₄ is a heteroaryl group), and the term "heteroarylthio group" as used herein indicates -SA₁₀₅ (wherein A₁₀₅ is the heteroaryl group).

As used herein, the term "cyclic group" encompasses a monocyclic group and a polycyclic group, and also encompasses an alicyclic ring group and an aromatic ring group.

As used herein, the term "polycyclic group" refers to a group in which two or more rings are connected to each other or condensed to each other through one or more atoms. For example, a polycyclic structure may include a bicyclic structure through a bridging carbon, a spiro structure, a fused structure, or the like.

The term "condensed polycyclic group" as used herein refers to a monovalent group having two or more rings condensed with each other, optionally a heteroatom selected from B, N, O, P, Si, Ge, Se, and S, other than carbon atoms, as a ring-forming atom, and no aromaticity in its entire molecular structure. Non-limiting examples of the condensed polycyclic group include a fluorenyl group, a carbazolyl group, or the like. The term "divalent condensed polycyclic group" as used herein refers to a divalent group having the same structure as the condensed polycyclic group.

As used herein, the term "condensed group" or "condensed ring structure" refers to a group in which two or more adjacent rings share two or more atoms among the above-described polycyclic structures. Non-limiting examples of a condensed ring structure may include naphthalene, anthracene, phenanthrene, fluorene, pyrene, benzopyrene, pentacene, polyacene, helicene, or the like.

As used herein, the term "carbocyclic group" (e.g., C₃-C₆₀ carbocyclic group) refers to a cyclic group in which carbon atoms are the only ring-forming atoms. As used herein, the term "heterocyclic group" (e.g., a C₁-C₆₀ heterocyclic group) refers a cyclic group that includes at least one heteroatom as a ring-forming atom, in addition to carbon atoms.

As used herein, a carbocyclic group and a heterocyclic group may each independently be a monocyclic group or a polycyclic group.

### Condensed Heterocyclic Compound

According to an aspect, a condensed heterocyclic compound represented by Chemical Formula 1 is provided.

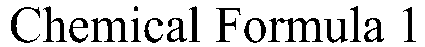

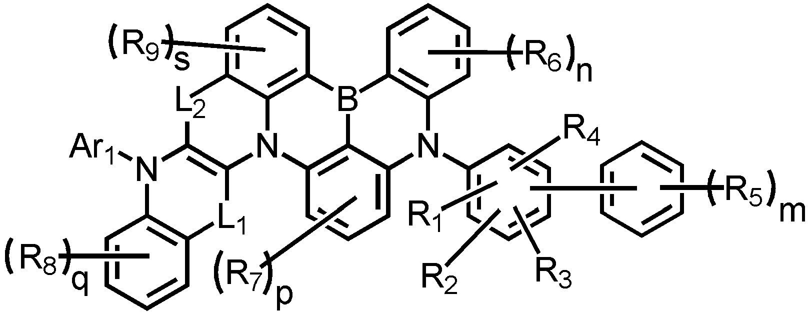

In Chemical Formula 1, L₁ and L₂ are each independently a direct bond or CR₁₀. For example, L₁ and L₂ may each be a direct bond, or L₁ and L₂ may each be CR₁₀. When each of L₁ and L₂ are CR₁₀, then each R₁₀ may be the same or different.

For example, in some embodiments, the condensed heterocyclic compound may be represented by Chemical Formula 1-1 or Chemical Formula 1-2:

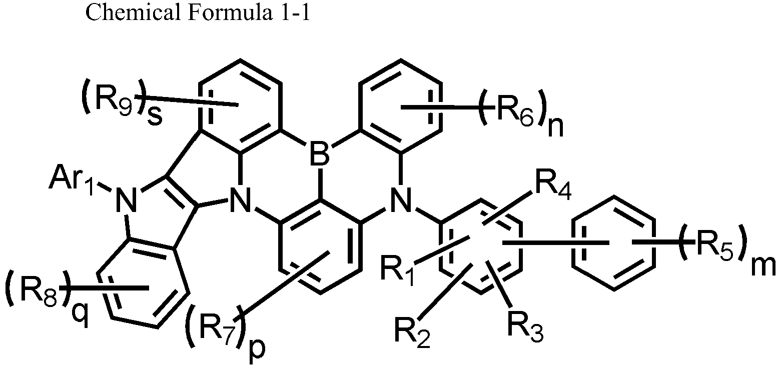

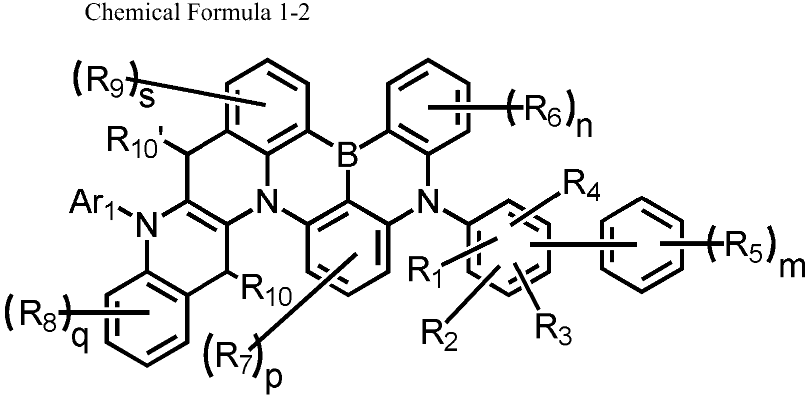

In Chemical Formula 1, Chemical Formula 1-1, and Chemical Formula 1-2, Ar₁ is a substituted or unsubstituted C₆-C₆₀ aryl group or a substituted or unsubstituted C₁-C₆₀ heteroaryl group. According to some embodiments, Ar₁ may be a substituted or unsubstituted C₆-C₄₀ aryl group or a substituted or unsubstituted C₁-C₄₀ heteroaryl group. According to some embodiments, Ar₁ may be a substituted or unsubstituted C₆-C₂₀ aryl group or a substituted or unsubstituted C₁-C₂₀ heteroaryl group.

According to some embodiments, Ar₁ may be a deuterium-substituted or unsubstituted C₆-C₆₀ aryl group, or a deuterium-substituted or unsubstituted C₁-C₆₀ heteroaryl group. In some embodiments, Ar₁ may be a deuterium-substituted or unsubstituted C₆-C₄₀ aryl group, or a deuterium-substituted or unsubstituted C₁-C₄₀ heteroaryl group. For example, Ar₁ may be a deuterium-substituted or unsubstituted C₆-C₂₀ aryl group, or a deuterium-substituted or unsubstituted C₁-C₂₀ heteroaryl group.

For example, in the above Chemical Formula 1, Chemical Formula 1-1, and Chemical Formula 1-2, Ar₁ may be represented by Chemical Formula 2 below.

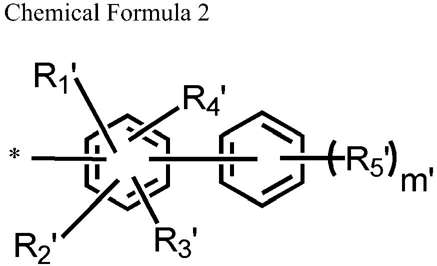

In Chemical Formula 2, one of R₁' to R₄' may be a substituted or unsubstituted C₆-C₆₀ aryl group or a substituted or unsubstituted C₁-C₆₀ heteroaryl group; or two adjacent ones of R₁' to R₄' may be combined with each other to form a substituted or unsubstituted C₆-C₆₀ aryl group or a substituted or unsubstituted C₁-C₆₀ (e.g. C₂-C₆₀) heteroaryl group.

According to some embodiments, one of R₁' to R₄' may be a substituted or unsubstituted C₆-C₆₀ aryl group, or a substituted or unsubstituted C₁-C₆₀ heteroaryl group. In some embodiments, one of R₁' to R₄' may be a substituted or unsubstituted C₆-C₄₀ aryl group, or a substituted or unsubstituted C₁-C₄₀ heteroaryl group. For example, one of R₁' to R₄' may be a substituted or unsubstituted C₆-C₂₀ aryl group, or a substituted or unsubstituted C₁-C₂₀ heteroaryl group.

According to embodiments, one of R₁' to R₄' may be a deuterium-substituted or unsubstituted C₆-C₆₀ aryl group, or a deuterium-substituted or unsubstituted C₁-C₆₀ heteroaryl group. In some embodiments, one of R₁' to R₄' may be a deuterium-substituted or unsubstituted C₆-C₄₀ aryl group, or a deuterium-substituted or unsubstituted C₁-C₄₀ heteroaryl group. For example, one of R₁' to R₄' may be a deuterium-substituted or unsubstituted C₆-C₂₀ aryl group, or a deuterium-substituted or unsubstituted C₁-C₂₀ heteroaryl group.

For example, one of R₁' to R₄' may be a substituted or unsubstituted phenyl group, a substituted or unsubstituted biphenyl group, a substituted or unsubstituted terphenyl group, a substituted or unsubstituted quaterphenyl group, a substituted or unsubstituted quinquephenyl group, a substituted or unsubstituted naphthalene group, a substituted or unsubstituted anthracene group, a substituted or unsubstituted pyridine group, a substituted or unsubstituted pyridazine group, a substituted or unsubstituted pyrazine group, a substituted or unsubstituted triazine group, a substituted or unsubstituted indene group, a substituted or unsubstituted dihydroindene group, a substituted or unsubstituted fluorene group, a substituted or unsubstituted spirobifluorene group, a substituted or unsubstituted indoline group, a substituted or unsubstituted indole group, a substituted or unsubstituted isoindole group, a substituted or unsubstituted indolizine group, a substituted or unsubstituted indazole group, a substituted or unsubstituted benzimidazole group, a substituted or unsubstituted azaindole group, a substituted or unsubstituted benzofuran group, a substituted or unsubstituted dibenzofuran group, a substituted or unsubstituted isobenzofuran group, a substituted or unsubstituted benzothiophene group, a substituted or unsubstituted tetrahydroquinoline group, a substituted or unsubstituted dihydroquinoline group, a substituted or unsubstituted quinoline group, a substituted or unsubstituted isoquinoline group, or a substituted or unsubstituted quinoxaline group.

For example, one of R₁' to R₄' may be a deuterium-substituted or unsubstituted phenyl group, a deuterium-substituted or unsubstituted biphenyl group, a deuterium-substituted or unsubstituted terphenyl group, a deuterium-substituted or unsubstituted quaterphenyl group, a deuterium-substituted or unsubstituted quinquephenyl group, a deuterium-substituted or unsubstituted naphthalene group, a deuterium-substituted or unsubstituted anthracene group, a deuterium-substituted or unsubstituted pyridine group, a deuterium-substituted or unsubstituted pyridazine group, a deuterium-substituted or unsubstituted pyrazine group, a deuterium-substituted or unsubstituted triazine group, a deuterium-substituted or unsubstituted indene group, a deuterium-substituted or unsubstituted dihydroindene group, a deuterium-substituted or unsubstituted fluorene group, a deuterium-substituted or unsubstituted spirobifluorene group, a deuterium-substituted or unsubstituted indoline group, a deuterium-substituted or unsubstituted indole group, a deuterium-substituted or unsubstituted isoindole group, a deuterium-substituted or unsubstituted indolizine group, a deuterium-substituted or unsubstituted indazole group, a deuterium-substituted or unsubstituted benzimidazole group, a deuterium-substituted or unsubstituted azaindole group, a deuterium-substituted or unsubstituted benzofuran group, a deuterium-substituted or unsubstituted dibenzofuran group, a deuterium-substituted or unsubstituted isobenzofuran group, a deuterium-substituted or unsubstituted benzothiophene group, a deuterium-substituted or unsubstituted tetrahydroquinoline group, a deuterium-substituted or unsubstituted dihydroquinoline group, a deuterium-substituted or unsubstituted quinoline group, a deuterium-substituted or unsubstituted isoquinoline group, or a deuterium-substituted or unsubstituted quinoxaline group.

In one or more embodiments, two adjacent ones of R₁' to R₄' may be combined with each other to form a substituted or unsubstituted C₆-C₆₀ aryl group, or a substituted or unsubstituted C₁-C₆₀ (e.g. C₂-C₆₀) heteroaryl group. According to some embodiments, two adjacent ones of R₁' to R₄' may be combined with each other to form a substituted or unsubstituted C₆-C₄₀ aryl group, or a substituted or unsubstituted C₁-C₄₀ (e.g. C₂-C₄₀) heteroaryl group. In some embodiments, two adjacent ones of R₁' to R₄' may be combined with each other to form a substituted or unsubstituted C₆-C₂₀ aryl group, or a substituted or unsubstituted C₁-C₂₀ (e.g. C₂-C₂₀) heteroaryl group.

In one or more embodiments, two adjacent ones of R₁' to R₄' may be combined with each other to form a deuterium-substituted or unsubstituted C₆-C₆₀ aryl group, or a deuterium-substituted or unsubstituted C₁-C₆₀ (e.g. C₂-C₆₀) heteroaryl group. According to some embodiments, two adjacent ones of R₁' to R₄' may be combined with each other to form a deuterium-substituted or unsubstituted C₆-C₄₀ aryl group, or a deuterium-substituted or unsubstituted C₁-C₄₀ (e.g. C₂-C₄₀)heteroaryl group. In some embodiments, two adjacent ones of R₁' to R₄' may be combined with each other to form a deuterium-substituted or unsubstituted C₆-C₂₀ aryl group, or a deuterium-substituted or unsubstituted C₁-C₂₀ (e.g. C₂-C₂₀) heteroaryl group.

For example, two adjacent ones of R₁' to R₄' may be combined with each other to form a group that is a substituted or unsubstituted phenyl group, a substituted or unsubstituted biphenyl group, a substituted or unsubstituted terphenyl group, a substituted or unsubstituted quaterphenyl group, a substituted or unsubstituted quinquephenyl group, a substituted or unsubstituted naphthalene group, a substituted or unsubstituted anthracene group, a substituted or unsubstituted pyridine group, a substituted or unsubstituted pyridazine group, a substituted or unsubstituted pyrazine group, a substituted or unsubstituted triazine group, a substituted or unsubstituted indene group, a substituted or unsubstituted dihydroindene group, a substituted or unsubstituted fluorene group, a substituted or unsubstituted spirobifluorene group, a substituted or unsubstituted indoline group, a substituted or unsubstituted indole group, a substituted or unsubstituted isoindole group, a substituted or unsubstituted indolizine group, a substituted or unsubstituted indazole group, a substituted or unsubstituted benzimidazole group, a substituted or unsubstituted azaindole group, a substituted or unsubstituted benzofuran group, a substituted or unsubstituted dibenzofuran group, a substituted or unsubstituted isobenzofuran group, a substituted or unsubstituted benzothiophene group, a substituted or unsubstituted tetrahydroquinoline group, a substituted or unsubstituted dihydroquinoline group, a substituted or unsubstituted quinoline group, a substituted or unsubstituted isoquinoline group, or a substituted or unsubstituted quinoxaline group.

For example, two adjacent ones of R₁' to R₄' may be combined with each other to form a group that is a deuterium-substituted or unsubstituted phenyl group, a deuterium-substituted or unsubstituted biphenyl group, a deuterium-substituted or unsubstituted terphenyl group, a deuterium-substituted or unsubstituted quaterphenyl group, a deuterium-substituted or unsubstituted quinquephenyl group, a deuterium-substituted or unsubstituted naphthalene group, a deuterium-substituted or unsubstituted anthracene group, a deuterium-substituted or unsubstituted pyridine group, a deuterium-substituted or unsubstituted pyridazine group, a deuterium-substituted or unsubstituted pyrazine group, a deuterium-substituted or unsubstituted triazine group, a deuterium-substituted or unsubstituted indene group, a deuterium-substituted or unsubstituted dihydroindene group, a deuterium-substituted or unsubstituted fluorene group, a deuterium-substituted or unsubstituted spirobifluorene group, a deuterium-substituted or unsubstituted indoline group, a deuterium-substituted or unsubstituted indole group, a deuterium-substituted or unsubstituted isoindole group, a deuterium-substituted or unsubstituted indolizine group, a deuterium-substituted or unsubstituted indazole group, a deuterium-substituted or unsubstituted benzimidazole group, a deuterium-substituted or unsubstituted azaindole group, a deuterium-substituted or unsubstituted benzofuran group, a deuterium-substituted or unsubstituted dibenzofuran group, a deuterium-substituted or unsubstituted isobenzofuran group, a deuterium-substituted or unsubstituted benzothiophene group, a deuterium-substituted or unsubstituted tetrahydroquinoline group, a deuterium-substituted or unsubstituted dihydroquinoline group, a deuterium-substituted or unsubstituted quinoline group, a deuterium-substituted or unsubstituted isoquinoline group, or a deuterium-substituted or unsubstituted quinoxaline group.

Remaining groups (a remainder) of R₁' to R₄' which are not the substituted or unsubstituted C₆-C₆₀ aryl group or the substituted or unsubstituted C₁-C₆₀ heteroaryl group, or remaining groups except for the two adjacent ones combined with each other to form the ring among R₁' to R₄', and R₅' may each be independently hydrogen, deuterium, halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ (e.g. C₁-C₂₀) alkyl group, a substituted or unsubstituted C₂-C₆₀ (e.g. C₂-C₂₀) alkenyl group, a substituted or unsubstituted C₂-C₆₀ (e.g. C₂-C₂₀) alkynyl group, a substituted or unsubstituted C₁-C₆₀ (e.g. C₁-C₂₀) alkoxy group, a substituted or unsubstituted C₁-C₆₀ (e.g. C₁-C₂₀) alkylthio group, a substituted or unsubstituted C₃-C₆₀ (e.g. C₃-C₂₀) cycloalkyl group, a substituted or unsubstituted C₅-C₆₀ (e.g. C₅-C₂₀) cycloalkenyl group, a substituted or unsubstituted C₃-C₆₀ (e.g. C₃-C₂₀) heterocycloalkyl group, a substituted or unsubstituted C₁-C₆₀ (e.g. C₁-C₂₀) heterocycloalkenyl group, a substituted or unsubstituted C₆-C₆₀ (e.g. C₆-C₃₀) aryl group, a substituted or unsubstituted C₇-C₆₀ (e.g. C₇-C₃₀) alkyl aryl group, a substituted or unsubstituted C₇-C₆₀ (e.g. C₇-C₃₀) aryl alkyl group, a substituted or unsubstituted C₁-C₆₀ (e.g. C₁-C₂₀) heteroaryl group, a substituted or unsubstituted C₂-C₆₀ (e.g. C₂-C₃₀) alkyl heteroaryl group, a substituted or unsubstituted C₂-C₆₀ (e.g. C₂-C₃₀) heteroaryl alkyl group, a substituted or unsubstituted C₆-C₆₀ (e.g. C₆-C₃₀) aryloxy group, a substituted or unsubstituted C₆-C₆₀ (e.g. C₆-C₃₀) arylthio group, a substituted or unsubstituted C₁-C₆₀ (e.g. C₁-C₂₀) heteroaryloxy group, a substituted or unsubstituted C₁-C₆₀ (e.g. C₁-C₂₀) heteroarylthio group, a substituted or unsubstituted C₈-C₆₀ (e.g. C₈-C₃₀) condensed polycyclic group, -SiRR'R", -PRR', - P(=O)RR', -NRR', -BRR', -C(=O)R, -S(=O)R, or -S(=O)₂R.

In one or more embodiments, two or more adjacent ones of the remaining groups of R₁' to R₄' and R₅' may be combined with each other to form a substituted or unsubstituted C₃-C₆₀ (e.g. C₃-C₂₀) cycloalkyl group, a substituted or unsubstituted C₅-C₆₀ (e.g. C₅-C₂₀) cycloalkenyl group, a substituted or unsubstituted C₃-C₆₀ (e.g. C₃-C₂₀) heterocycloalkyl group, a substituted or unsubstituted C₁-C₆₀ (e.g. C₁-C₂₀) heterocycloalkenyl group, a substituted or unsubstituted C₆-C₆₀ (e.g. C₆-C₃₀) aryl group or a substituted or unsubstituted C₂-C₆₀ (e.g. C₂-C₃₀) heteroaryl group.

R, R', and R" may each independently be hydrogen, deuterium, halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ (e.g. C₁-C₂₀) alkyl group, a substituted or unsubstituted C₂-C₆₀ (e.g. C₂-C₂₀) alkenyl group, a substituted or unsubstituted C₂-C₆₀ (e.g. C₂-C₂₀) alkynyl group, a substituted or unsubstituted C₁-C₆₀ (e.g. C₁-C₂₀) alkoxy group, a substituted or unsubstituted C₁-C₆₀ (e.g. C₁-C₂₀) alkylthio group, a substituted or unsubstituted C₃-C₆₀ (e.g. C₃-C₂₀) cycloalkyl group, a substituted or unsubstituted C₅-C₆₀ (e.g. C₅-C₂₀) cycloalkenyl group, a substituted or unsubstituted C₃-C₆₀ (e.g. C₃-C₂₀) heterocycloalkyl group, a substituted or unsubstituted C₁-C₆₀ (e.g. C₁-C₂₀) heterocycloalkenyl group, a substituted or unsubstituted C₆-C₆₀ (e.g. C₆-C₃₀) aryl group, a substituted or unsubstituted C₇-C₆₀ (e.g. C₇-C₃₀) alkyl aryl group, a substituted or unsubstituted C₇-C₆₀ (e.g. C₇-C₃₀) aryl alkyl group, a substituted or unsubstituted C₁-C₆₀ (e.g. C₁-C₂₀) heteroaryl group, a substituted or unsubstituted C₂-C₆₀ (e.g. C₂-C₃₀) alkyl heteroaryl group, a substituted or unsubstituted C₂-C₆₀ (e.g. C₂-C₃₀) heteroaryl alkyl group, a substituted or unsubstituted C₆-C₆₀ (e.g. C₆-C₃₀) aryloxy group, a substituted or unsubstituted C₆-C₆₀ (e.g. C₆-C₃₀) arylthio group, a substituted or unsubstituted C₁-C₆₀ (e.g. C₁-C₂₀) heteroaryloxy group, a substituted or unsubstituted C₁-C₆₀ (e.g. C₁-C₂₀) heteroarylthio group, or a substituted or unsubstituted C₈-C₆₀ (e.g. C₈-C₃₀) condensed polycyclic group.

Remaining groups of R₁' to R₄' which are not the substituted or unsubstituted C₆-C₆₀ aryl group or the substituted or unsubstituted C₁-C₆₀ heteroaryl group, or remaining groups except for the two adjacent ones combined with each other to form the ring among R₁' to R₄' may each independently be hydrogen or deuterium.

For example, Ar₁ may be a substituted or unsubstituted phenyl group, a substituted or unsubstituted biphenyl group, a substituted or unsubstituted terphenyl group, a substituted or unsubstituted quaterphenyl group, a substituted or unsubstituted quinquephenyl group, a substituted or unsubstituted naphthalene group, a substituted or unsubstituted substituted anthracene group, a substituted or unsubstituted pyridine group, a substituted or unsubstituted pyridazine group, a substituted or unsubstituted pyrazine group, a substituted or unsubstituted triazine group, a substituted or unsubstituted indene group, a substituted or unsubstituted dihydroindene group, a substituted or unsubstituted fluorene group, a substituted or unsubstituted spirobifluorene group, a substituted or unsubstituted indoline group, a substituted or unsubstituted indole group, a substituted or unsubstituted isoindole group, a substituted or unsubstituted indolizine group, a substituted or unsubstituted indazole group, a substituted or unsubstituted benzimidazole group, a substituted or unsubstituted azaindole group, a substituted or unsubstituted benzofuran group, a substituted or unsubstituted dibenzofuran group, a substituted or unsubstituted isobenzofuran group, a substituted or unsubstituted benzothiophene group, a substituted or unsubstituted tetrahydroquinoline group, a substituted or unsubstituted dihydroquinoline group, a substituted or unsubstituted quinoline group, a substituted or unsubstituted isoquinoline group, or a substituted or unsubstituted quinoxaline group.

For example, Ar₁ may be a deuterium-substituted or unsubstituted phenyl group, a deuterium-substituted or unsubstituted biphenyl group, a deuterium-substituted or unsubstituted terphenyl group, a deuterium-substituted or unsubstituted quaterphenyl group, a deuterium-substituted or unsubstituted quinquephenyl group, a deuterium-substituted or unsubstituted naphthalene group, a deuterium-substituted or unsubstituted anthracene group, a deuterium-substituted or unsubstituted pyridine group, a deuterium-substituted or unsubstituted pyridazine group, a deuterium-substituted or unsubstituted pyrazine group, a deuterium-substituted or unsubstituted triazine group, a deuterium-substituted or unsubstituted indene group, a deuterium-substituted or unsubstituted dihydroindene group, a deuterium-substituted or unsubstituted fluorene group, a deuterium-substituted or unsubstituted spirobifluorene group, a deuterium-substituted or unsubstituted indoline group, a deuterium-substituted or unsubstituted indole group, a substituted or unsubstituted isoindole group, a deuterium-substituted or unsubstituted indolizine group, a deuterium-substituted or unsubstituted indazole group, a deuterium-substituted or unsubstituted benzimidazole group, a deuterium-substituted or unsubstituted azaindole group, a deuterium-substituted or unsubstituted benzofuran group, a deuterium-substituted or unsubstituted dibenzofuran group, a deuterium-substituted or unsubstituted isobenzofuran group, a deuterium-substituted or unsubstituted benzothiophene group, a deuterium-substituted or unsubstituted tetrahydroquinoline group, a deuterium-substituted or unsubstituted dihydroquinoline group, a deuterium-substituted or unsubstituted quinoline group, a deuterium-substituted or unsubstituted isoquinoline group, or a deuterium-substituted or unsubstituted quinoxaline group.

In Chemical Formula 1, Chemical Formula 1-1 and Chemical Formula 1-2, one of R₁ to R₄ is a substituted or unsubstituted C₆-C₆₀ aryl group, or a substituted or unsubstituted C₁-C₆₀ heteroaryl group; or two adjacent ones of R₁ to R₄ are combined with each other to form a substituted or unsubstituted C₆-C₆₀ aryl group, or a substituted or unsubstituted C₁-C₆₀ heteroaryl group.

According to some embodiments, one of R₁ to R₄ may be a substituted or unsubstituted C₆-C₆₀ aryl group or a substituted or unsubstituted C₁-C₆₀ heteroaryl group. In some embodiments, one of R₁ to R₄ may be a substituted or unsubstituted C₆-C₄₀ aryl group, or a substituted or unsubstituted C₁-C₄₀ heteroaryl group. For example, one of R₁ to R₄ may be a substituted or unsubstituted C₆-C₂₀ aryl group, or a substituted or unsubstituted C₁-C₂₀ heteroaryl group.

According to some embodiments, one of R₁ to R₄ may be a deuterium-substituted or unsubstituted C₆-C₆₀ aryl group, or a deuterium-substituted or unsubstituted C₁-C₆₀ heteroaryl group. In some embodiments, one of R₁ to R₄ may be a deuterium-substituted or unsubstituted C₆-C₄₀ aryl group, or a deuterium-substituted or unsubstituted C₁-C₄₀ heteroaryl group. For example, one of R₁ to R₄ may be a deuterium-substituted or unsubstituted C₆-C₂₀ aryl group, or a deuterium-substituted or unsubstituted C₁-C₂₀ heteroaryl group.

For example, one of R₁ to R₄ may be a substituted or unsubstituted phenyl group, a substituted or unsubstituted biphenyl group, a substituted or unsubstituted terphenyl group, a substituted or unsubstituted quaterphenyl group, a substituted or unsubstituted quinquephenyl group, a substituted or unsubstituted naphthalene group, a substituted or unsubstituted anthracene group, a substituted or unsubstituted pyridine group, a substituted or unsubstituted pyridazine group, a substituted or unsubstituted pyrazine group, a substituted or unsubstituted triazine group, a substituted or unsubstituted indene group, a substituted or unsubstituted dihydroindene group, a substituted or unsubstituted fluorene group, a substituted or unsubstituted spirobifluorene group, a substituted or unsubstituted indoline group, a substituted or unsubstituted indole group, a substituted or unsubstituted isoindole group, a substituted or unsubstituted indolizine group, a substituted or unsubstituted indazole group, a substituted or unsubstituted benzimidazole group, a substituted or unsubstituted azaindole group, a substituted or unsubstituted benzofuran group, a substituted or unsubstituted dibenzofuran group, a substituted or unsubstituted isobenzofuran group, a substituted or unsubstituted benzothiophene group, a substituted or unsubstituted tetrahydroquinoline group, a substituted or unsubstituted dihydroquinoline group, a substituted or unsubstituted quinoline group, a substituted or unsubstituted isoquinoline group, or a substituted or unsubstituted quinoxaline group.

For example, one of R₁ to R₄ may be a deuterium-substituted or unsubstituted phenyl group, a deuterium-substituted or unsubstituted biphenyl group, a deuterium-substituted or unsubstituted terphenyl group, a deuterium-substituted or unsubstituted quaterphenyl group, a deuterium-substituted or unsubstituted quinquephenyl group, a deuterium-substituted or unsubstituted naphthalene group, a deuterium-substituted or unsubstituted anthracene group, a deuterium-substituted or unsubstituted pyridine group, a deuterium-substituted or unsubstituted pyridazine group, a deuterium-substituted or unsubstituted pyrazine group, a deuterium-substituted or unsubstituted triazine group, a deuterium-substituted or unsubstituted indene group, a deuterium-substituted or unsubstituted dihydroindene group, a deuterium-substituted or unsubstituted fluorene group, a deuterium-substituted or unsubstituted spirobifluorene group, a deuterium-substituted or unsubstituted indoline group, a deuterium-substituted or unsubstituted indole group, a deuterium-substituted or unsubstituted isoindole group, a deuterium-substituted or unsubstituted indolizine group, a deuterium-substituted or unsubstituted indazole group, a deuterium-substituted or unsubstituted benzimidazole group, a deuterium-substituted or unsubstituted azaindole group, a deuterium-substituted or unsubstituted benzofuran group, a deuterium-substituted or unsubstituted dibenzofuran group, a deuterium-substituted or unsubstituted isobenzofuran group, a deuterium-substituted or unsubstituted benzothiophene group, a deuterium-substituted or unsubstituted tetrahydroquinoline group, a deuterium-substituted or unsubstituted dihydroquinoline group, a deuterium-substituted or unsubstituted quinoline group, a deuterium-substituted or unsubstituted isoquinoline group, or a deuterium-substituted or unsubstituted quinoxaline group.

In some embodiments, two adjacent ones of R₁ to R₄ are combined with each other to form a substituted or unsubstituted C₆-C₆₀ aryl group, or a substituted or unsubstituted C₁-C₆₀ heteroaryl group. In one or more embodiments, two adjacent ones of R₁ to R₄ may be combined with each other to form a substituted or unsubstituted C₆-C₄₀ aryl group, or a substituted or unsubstituted C₁-C₄₀ heteroaryl group. In one or more embodiments, two adjacent ones of R₁ to R₄ may be combined with each other to form a substituted or unsubstituted C₆-C₂₀ aryl group, or a substituted or unsubstituted C₁-C₂₀ heteroaryl group.

Two adjacent ones of R₁ to R₄ may be combined with each other to form a deuterium-substituted or unsubstituted C₆-C₆₀ aryl group, or a deuterium-substituted or unsubstituted C₁-C₆₀ heteroaryl group. According to some embodiments, two adjacent ones of R₁ to R₄ may be combined with each other to form a deuterium-substituted or unsubstituted C₆-C₄₀ aryl group, or a deuterium-substituted or unsubstituted C₁-C₄₀ heteroaryl group. In some embodiments, two adjacent ones of R₁ to R₄ may be combined with each other to form a deuterium-substituted or unsubstituted C₆-C₂₀ aryl group, or a deuterium-substituted or unsubstituted C₁-C₂₀ heteroaryl group.

For example, two adjacent ones of R₁ to R₄ may be combined with each other to form a group that is a substituted or unsubstituted phenyl group, a substituted or unsubstituted biphenyl group, a substituted or unsubstituted terphenyl group, a substituted or unsubstituted quaterphenyl group, a substituted or unsubstituted quinquephenyl group, a substituted or unsubstituted naphthalene group, a substituted or unsubstituted anthracene group, a substituted or unsubstituted pyridine group, a substituted or unsubstituted pyridazine group, a substituted or unsubstituted pyrazine group, a substituted or unsubstituted triazine group, a substituted or unsubstituted indene group, a substituted or unsubstituted dihydroindene group, a substituted or unsubstituted fluorene group, a substituted or unsubstituted spirobifluorene group, a substituted or unsubstituted indoline group, a substituted or unsubstituted indole group, a substituted or unsubstituted isoindole group, a substituted or unsubstituted indolizine group, a substituted or unsubstituted indazole group, a substituted or unsubstituted a benzimidazole group, a substituted or unsubstituted azaindole group, a substituted or unsubstituted benzofuran group, a substituted or unsubstituted dibenzofuran group, a substituted or unsubstituted isobenzofuran group, a substituted or unsubstituted benzothiophene group, a substituted or unsubstituted tetrahydroquinoline group, a substituted or unsubstituted dihydroquinoline group, a substituted or unsubstituted quinoline group, a substituted or unsubstituted isoquinoline group, or a substituted or unsubstituted quinoxaline group.

For example, two adjacent ones of R₁ to R₄ may be combined with each other to form a group that is a deuterium-substituted or unsubstituted phenyl group, a deuterium-substituted or unsubstituted biphenyl group, a deuterium-substituted or unsubstituted terphenyl group, a deuterium-substituted or unsubstituted quaterphenyl group, a deuterium-substituted or unsubstituted quinquephenyl group, a deuterium-substituted or unsubstituted naphthalene group, a deuterium-substituted or unsubstituted anthracene group, a deuterium-substituted or unsubstituted pyridine group, a deuterium-substituted or unsubstituted pyridazine group, a deuterium-substituted or unsubstituted pyrazine group, a deuterium-substituted or unsubstituted triazine group, a deuterium-substituted or unsubstituted indene group, a deuterium-substituted or unsubstituted dihydroindene group, a deuterium-substituted or unsubstituted fluorene group, a deuterium-substituted or unsubstituted spirobifluorene group, a deuterium-substituted or unsubstituted indoline group, a deuterium-substituted or unsubstituted indole group, a deuterium-substituted or unsubstituted isoindole group, a deuterium-substituted or unsubstituted indolizine group, a deuterium-substituted or unsubstituted indazole group, a deuterium-substituted or unsubstituted benzimidazole group, a deuterium-substituted or unsubstituted azaindole group, a deuterium-substituted or unsubstituted benzofuran group, a deuterium-substituted or unsubstituted dibenzofuran group, a deuterium-substituted or unsubstituted isobenzofuran group, a deuterium-substituted or unsubstituted benzothiophene group, a deuterium-substituted or unsubstituted tetrahydroquinoline group, a deuterium-substituted or unsubstituted dihydroquinoline group, a deuterium-substituted or unsubstituted quinoline group, a deuterium-substituted or unsubstituted isoquinoline group, or a deuterium-substituted or unsubstituted quinoxaline group.

Remaining groups of R₁ to R₄ which are not the substituted or unsubstituted C₆-C₆₀ aryl group or the substituted or unsubstituted C₁-C₆₀ heteroaryl group, or remaining groups except for two adjacent ones that are combined with each other to form a substituted or unsubstituted C₆-C₆₀ aryl group, or a substituted or unsubstituted C₁-C₆₀ heteroaryl group among R₁ to R₄ may each independently be hydrogen, deuterium, halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ (e.g. C₁-C₂₀) alkyl group, a substituted or unsubstituted C₂-C₆₀ (e.g. C₂-C₂₀) alkenyl group, a substituted or unsubstituted C₂-C₆₀ (e.g. C₂-C₂₀) alkynyl group, a substituted or unsubstituted C₁-C₆₀ (e.g. C₁-C₂₀) alkoxy group, a substituted or unsubstituted C₁-C₆₀ (e.g. C₁-C₂₀) alkylthio group, a substituted or unsubstituted C₃-C₆₀ (e.g. C₃-C₂₀) cycloalkyl group, a substituted or unsubstituted C₅-C₆₀ (e.g. C₅-C₂₀) cycloalkenyl group, a substituted or unsubstituted C₃-C₆₀ (e.g. C₃-C₂₀) heterocycloalkyl group, a substituted or unsubstituted C₁-C₆₀ (e.g. C₁-C₂₀) heterocycloalkenyl group, a substituted or unsubstituted C₆-C₆₀ (e.g. C₆-C₃₀) aryl group, a substituted or unsubstituted C₇-C₆₀ (e.g. C₇-C₃₀) alkyl aryl group, a substituted or unsubstituted C₇-C₆₀ (e.g. C₇-C₃₀) aryl alkyl group, a substituted or unsubstituted C₁-C₆₀ (e.g. C₁-C₂₀) heteroaryl group, a substituted or unsubstituted C₂-C₆₀ (e.g. C₂-C₃₀) alkyl heteroaryl group, a substituted or unsubstituted C₂-C₆₀ (e.g. C₂-C₃₀) heteroaryl alkyl group, a substituted or unsubstituted C₆-C₆₀ (e.g. C₆-C₃₀) aryloxy group, a substituted or unsubstituted C₆-C₆₀ (e.g. C₆-C₃₀) arylthio group, a substituted or unsubstituted C₁-C₆₀ (e.g. C₁-C₂₀) heteroaryloxy group, a substituted or unsubstituted C₁-C₆₀ (e.g. C₁-C₂₀) heteroarylthio group, a substituted or unsubstituted C₈-C₆₀ (e.g. C₈-C₃₀) condensed polycyclic group, -SiRR'R", -PRR', - P(=O)RR', -NRR', -BRR', -C(=O)R, -S(=O)R, or -S(=O)₂R.

In one or more embodiments, two or more adjacent ones of the remaining groups R₁ to R₄ and R₅ to R₁₀ may be combined with each other to form a substituted or unsubstituted C₃-C₆₀ (e.g. C₃-C₂₀) cycloalkyl group, a substituted or unsubstituted C₅-C₆₀ (e.g. C₅-C₂₀) cycloalkenyl group, a substituted or unsubstituted C₃-C₆₀ (e.g. C₃-C₂₀) heterocycloalkyl group, a substituted or unsubstituted C₁-C₆₀ (e.g. C₁-C₂₀) heterocycloalkenyl group, a substituted or unsubstituted C₆-C₆₀ (e.g. C₆-C₃₀) aryl group, or a substituted or unsubstituted C₁-C₆₀ heteroaryl group (e.g. C₁-C₂₀).

R, R', and R" are each independently hydrogen, deuterium, halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ (e.g. C₁-C₂₀) alkyl group, a substituted or unsubstituted C₂-C₆₀ (e.g. C₂-C₂₀) alkenyl group, a substituted or unsubstituted C₂-C₆₀ (e.g. C₂-C₂₀) alkynyl group, a substituted or unsubstituted C₁-C₆₀ (e.g. C₁-C₂₀) alkoxy group, a substituted or unsubstituted C₁-C₆₀ (e.g. C₁-C₂₀) alkylthio group, a substituted or unsubstituted C₃-C₆₀ (e.g. C₃-C₂₀) cycloalkyl group, a substituted or unsubstituted C₅-C₆₀ (e.g. C₅-C₂₀) cycloalkenyl group, a substituted or unsubstituted C₃-C₆₀ (e.g. C₃-C₂₀) heterocycloalkyl group, a substituted or unsubstituted C₁-C₆₀ (e.g. C₁-C₂₀) heterocycloalkenyl group, a substituted or unsubstituted C₆-C₆₀ (e.g. C₆-C₃₀) aryl group, a substituted or unsubstituted C₇-C₆₀ (e.g. C₇-C₃₀) alkyl aryl group, a substituted or unsubstituted C₇-C₆₀ (e.g. C₇-C₃₀) aryl alkyl group, a substituted or unsubstituted C₁-C₆₀ (e.g. C₁-C₂₀) heteroaryl group, a substituted or unsubstituted C₂-C₆₀ (e.g. C₂-C₃₀) alkyl heteroaryl group, a substituted or unsubstituted C₂-C₆₀ (e.g. C₂-C₃₀) heteroaryl alkyl group, a substituted or unsubstituted C₆-C₆₀ (e.g. C₆-C₃₀) aryloxy group, a substituted or unsubstituted C₆-C₆₀ (e.g. C₆-C₃₀) arylthio group, a substituted or unsubstituted C₁-C₆₀ (e.g. C₁-C₂₀) heteroaryloxy group, a substituted or unsubstituted C₁-C₆₀ (e.g. C₁-C₂₀) heteroarylthio group, or a substituted or unsubstituted C₈-C₆₀ (e.g. C₈-C₃₀) condensed polycyclic group.

For example, remaining groups of R₁ to R₄ which are not the substituted or unsubstituted C₆-C₆₀ aryl group or the substituted or unsubstituted C₁-C₆₀ heteroaryl group, or remaining groups of R₁' to R₄' except for two adjacent ones which are combined with each other to form a substituted or unsubstituted C₆-C₆₀ aryl group, or a substituted or unsubstituted C₁-C₆₀ heteroaryl group may each independently be hydrogen or deuterium.

In Chemical Formula 1, Chemical Formula 1-1, and Chemical Formula 1-2, R₅ to R₁₀ and R₁₀' are each independently hydrogen, deuterium, halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ (e.g. C₁-C₂₀) alkyl group, a substituted or unsubstituted C₂-C₆₀ (e.g. C₂-C₂₀) alkenyl group, a substituted or unsubstituted C₂-C₆₀ (e.g. C₂-C₂₀) alkynyl group, a substituted or unsubstituted C₁-C₆₀ (e.g. C₁-C₂₀) alkoxy group, a substituted or unsubstituted C₁-C₆₀ (e.g. C₁-C₂₀) alkylthio group, a substituted or unsubstituted C₃-C₆₀ (e.g. C₃-C₂₀) cycloalkyl group, a substituted or unsubstituted C₅-C₆₀ (e.g. C₅-C₂₀) cycloalkenyl group, a substituted or unsubstituted C₃-C₆₀ (e.g. C₃-C₂₀) heterocycloalkyl group, a substituted or unsubstituted C₁-C₆₀ (e.g. C₁-C₂₀) heterocycloalkenyl group, a substituted or unsubstituted C₆-C₆₀ (e.g. C₆-C₃₀) aryl group, a substituted or unsubstituted C₇-C₆₀ (e.g. C₇-C₃₀) alkyl aryl group, a substituted or unsubstituted C₇-C₆₀ (e.g. C₇-C₃₀) aryl alkyl group, a substituted or unsubstituted C₁-C₆₀ (e.g. C₁-C₂₀) heteroaryl group, a substituted or unsubstituted C₂-C₆₀ (e.g. C₂-C₃₀) alkyl heteroaryl group, a substituted or unsubstituted C₂-C₆₀ (e.g. C₂-C₃₀) heteroaryl alkyl group, a substituted or unsubstituted C₆-C₆₀ (e.g. C₆-C₃₀) aryloxy group, a substituted or unsubstituted C₆-C₆₀ (e.g. C₆-C₃₀) arylthio group, a substituted or unsubstituted C₁-C₆₀ (e.g. C₁-C₂₀) heteroaryloxy group, a substituted or unsubstituted C₁-C₆₀ (e.g. C₁-C₂₀) heteroarylthio group, a substituted or unsubstituted C₈-C₆₀ (e.g. C₈-C₃₀) condensed polycyclic group, -SiRR'R", -PRR', -P(=O)RR', -NRR', - BRR', -C(=O)R, -S(=O)R, or -S(=O)₂R.

R₁₀' may be optionally combined with an adjacent group to form a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, or a substituted or unsubstituted C₁-C₆₀ heteroaryl group. Two or more adjacent ones R₅ to R₁₀ and R₁₀' may be combined with each other to form a substituted or unsubstituted C₃-C₆₀ (e.g. C₃-C₂₀) cycloalkyl group, a substituted or unsubstituted C₅-C₆₀ (e.g. C₅-C₂₀) cycloalkenyl group, a substituted or unsubstituted C₃-C₆₀ (e.g. C₃-C₂₀) heterocycloalkyl group, a substituted or unsubstituted C₁-C₆₀ (e.g. C₁-C₂₀) heterocycloalkenyl group, a substituted or unsubstituted C₆-C₆₀ (e.g. C₆-C₃₀) aryl group, or a substituted or unsubstituted C₁-C₆₀ (e.g. C₂-C₆₀ or C₂-C₂₀) heteroaryl group.

R, R', and R" are each as described herein.

In Chemical Formula 1, R₅ to R₁₀ are each independently hydrogen, deuterium, halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ (e.g. C₁-C₂₀) alkyl group, a substituted or unsubstituted C₂-C₆₀ (e.g. C₂-C₂₀) alkenyl group, a substituted or unsubstituted C₂-C₆₀ (e.g. C₂-C₂₀) alkynyl group, a substituted or unsubstituted C₁-C₆₀ (e.g. C₁-C₂₀) alkoxy group, a substituted or unsubstituted C₁-C₆₀ (e.g. C₁-C₂₀) alkylthio group, a substituted or unsubstituted C₃-C₆₀ (e.g. C₃-C₂₀) cycloalkyl group, a substituted or unsubstituted C₅-C₆₀ (e.g. C₅-C₂₀) cycloalkenyl group, a substituted or unsubstituted C₃-C₆₀ (e.g. C₃-C₂₀) heterocycloalkyl group, a substituted or unsubstituted C₁-C₆₀ (e.g. C₁-C₂₀) heterocycloalkenyl group, a substituted or unsubstituted C₆-C₆₀ (e.g. C₆-C₃₀) aryl group, a substituted or unsubstituted C₇-C₆₀ (e.g. C₇-C₃₀) alkyl aryl group, a substituted or unsubstituted C₇-C₆₀ (e.g. C₇-C₃₀) aryl alkyl group, a substituted or unsubstituted C₁-C₆₀ (e.g. C₁-C₂₀) heteroaryl group, a substituted or unsubstituted C₂-C₆₀ (e.g. C₂-C₃₀) alkyl heteroaryl group, a substituted or unsubstituted C₂-C₆₀ (e.g. C₂-C₃₀) heteroaryl alkyl group, a substituted or unsubstituted C₆-C₆₀ (e.g. C₆-C₃₀) aryloxy group, a substituted or unsubstituted C₆-C₆₀ (e.g. C₆-C₃₀) arylthio group, a substituted or unsubstituted C₁-C₆₀ (e.g. C₁-C₂₀) heteroaryloxy group, a substituted or unsubstituted C₁-C₆₀ (e.g. C₁-C₂₀) heteroarylthio group, a substituted or unsubstituted C₈-C₆₀ (e.g. C₈-C₃₀) condensed polycyclic group, -SiRR'R", -PRR', - P(=O)RR', -NRR', -BRR', -C(=O)R, -S(=O)R, or -S(=O)₂R.

According to embodiments, R₅ may be hydrogen, deuterium, a substituted or unsubstituted C₁-C₄₀ (e.g. C₁-C₂₀) alkyl group, or a substituted or unsubstituted C₆-C₄₀ (e.g. C₆-C₃₀) aryl group.

For example, R₅ may be hydrogen, deuterium, a substituted or unsubstituted phenyl group, a substituted or unsubstituted biphenyl group, a substituted or unsubstituted tert-butyl group, a deuterium-substituted or unsubstituted phenyl group, a deuterium-substituted or unsubstituted biphenyl group, or a deuterium-substituted or unsubstituted tert-butyl group.

In some embodiments, R₆ and R₇ may each independently be hydrogen, deuterium, a substituted or unsubstituted tert-butyl group, a substituted or unsubstituted phenyl group, a substituted or unsubstituted biphenyl group, a substituted or unsubstituted terphenyl group, a substituted or unsubstituted quaterphenyl group, a substituted or unsubstituted quinquephenyl group, a substituted or unsubstituted naphthalene group, a substituted or unsubstituted anthracene group, a substituted or unsubstituted pyridine group, a substituted or unsubstituted pyridazine group, a substituted or unsubstituted pyrazine group, a substituted or unsubstituted triazine group, a substituted or unsubstituted indene group, a substituted or unsubstituted dihydroindene group, a substituted or unsubstituted fluorene group, a substituted or unsubstituted spirobifluorene group, a substituted or unsubstituted indoline group, a substituted or unsubstituted indole group, a substituted or unsubstituted isoindole group, a substituted or unsubstituted indolizine group, a substituted or unsubstituted indazole group, a substituted or unsubstituted benzimidazole group, a substituted or unsubstituted azaindole group, a substituted or unsubstituted benzofuran group, a substituted or unsubstituted isobenzofuran group, a substituted or unsubstituted dibenzofuran group, a substituted or unsubstituted benzothiophene group, a substituted or unsubstituted tetrahydroquinoline group, a substituted or unsubstituted dihydroquinoline group, a substituted or unsubstituted quinoline group, a substituted or unsubstituted isoquinoline group, a substituted or unsubstituted quinoxaline group, a substituted or unsubstituted triphenylsilylphenyl group, a substituted or unsubstituted carbazole group, a substituted or unsubstituted benzocarbazole group, a substituted or unsubstituted dihydrobenzocarbazole group, a substituted or unsubstituted tetrahydrobenzocarbazole group, a substituted or unsubstituted dihydroacridine group, a substituted or unsubstituted spiroacridinexanthene group, a substituted or unsubstituted diphenylamine group, or a substituted or unsubstituted diphenyltriazine group.

For example, R₆ and R₇ may each independently be hydrogen, deuterium, a deuterium-substituted or unsubstituted tert-butyl group, a deuterium-substituted or unsubstituted phenyl group, a deuterium-substituted or unsubstituted biphenyl group, a deuterium-substituted or unsubstituted terphenyl group, a deuterium-substituted or unsubstituted quaterphenyl group, a deuterium-substituted or unsubstituted quinquephenyl group, a deuterium-substituted or unsubstituted naphthalene group, a deuterium-substituted or unsubstituted anthracene group, a deuterium-substituted or unsubstituted pyridine group, a deuterium-substituted or unsubstituted pyridazine group, a deuterium-substituted or unsubstituted pyrazine group, a deuterium-substituted or unsubstituted triazine group, a deuterium-substituted or unsubstituted indene group, a deuterium-substituted or unsubstituted dihydroindene group, a deuterium-substituted or unsubstituted fluorene group, a deuterium-substituted or unsubstituted spirobifluorene group, a deuterium-substituted or unsubstituted indoline group, a deuterium-substituted or unsubstituted indole group, a deuterium-substituted or unsubstituted isoindole group, a deuterium-substituted or unsubstituted indolizine group, a deuterium-substituted or unsubstituted indazole group, a deuterium-substituted or unsubstituted benzimidazole group, a deuterium-substituted or unsubstituted azaindole group, a deuterium-substituted or unsubstituted benzofuran group, a deuterium-substituted or unsubstituted dibenzofuran group, a deuterium-substituted or unsubstituted isobenzofuran group, a deuterium-substituted or unsubstituted benzothiophene group, a deuterium-substituted or unsubstituted tetrahydroquinoline group, a deuterium-substituted or unsubstituted dihydroquinoline group, a deuterium-substituted or unsubstituted quinoline group, a deuterium-substituted or unsubstituted isoquinoline group, a deuterium-substituted or unsubstituted quinoxaline group, a deuterium-substituted or unsubstituted triphenylsilylphenyl group, a deuterium-substituted or unsubstituted carbazole group, a deuterium-substituted or unsubstituted benzocarbazole group, a deuterium-substituted or unsubstituted dihydrobenzocarbazole group, a deuterium-substituted or unsubstituted tetrahydrobenzocarbazole group, a deuterium-substituted or unsubstituted dihydroacridine group, a deuterium-substituted or unsubstituted spiroacridinexanthene group, a deuterium-substituted or unsubstituted diphenyl dihydrodibenzoazacilline group, a deuterium-substituted or unsubstituted diphenylamine group, or a deuterium-substituted or unsubstituted diphenyltriazine group.

For example, R₈, R₉, R₁₀, and R₁₀' may each independently be hydrogen or deuterium.

In Chemical Formula 1, Chemical Formula 1-1, and Chemical Formula 1-2, m is an integer from 0 to 5, n and q are each independently an integer from 0 to 4, and p and s are each independently an integer from 0 to 3. For example, n, m, p, q and s may each independently be 0, 1 or 2.

In Chemical Formula 1, Chemical Formula 1-1, and Chemical Formula 1-2, when n, m, p, q, and s are each independently 2 or more, a plurality of each of R₅ to R₉ may each independently be the same as or different from each other.

When m is 2 or more, a plurality of R₅ may each independently be the same as or different from each other. When n is 2 or more, a plurality of R₆ may each independently be the same as or different from each other. When p is 2 or more, a plurality of R₇ may each independently be the same as or different from each other. When q is 2 or more, a plurality of R₈ may each independently be the same as or different from each other. When s is 2 or more, a plurality of R₉ may each independently be the same as or different from each other.

In some embodiments, the condensed heterocyclic compound represented by Chemical Formula 1 can be represented by the following Chemical Formula 1-3.

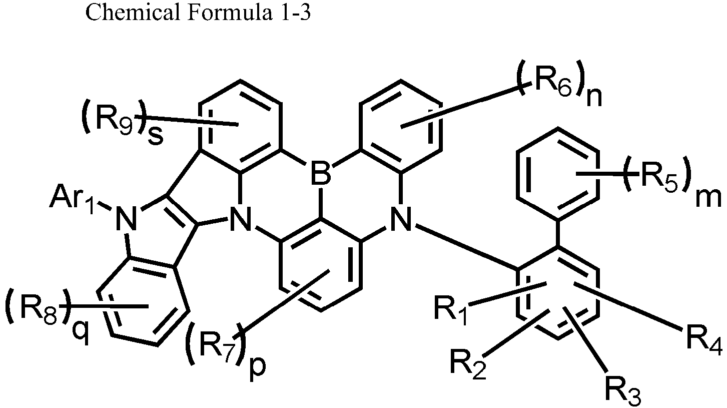

In Chemical Formula 1-3, Ar₁, R₁ to R₉, n, m, p, q and s may be the same as those described herein.

The condensed heterocyclic compound represented by Chemical Formula 1 may be represented by Chemical Formula 1-4 or Chemical Formula 1-5:

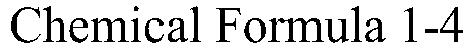

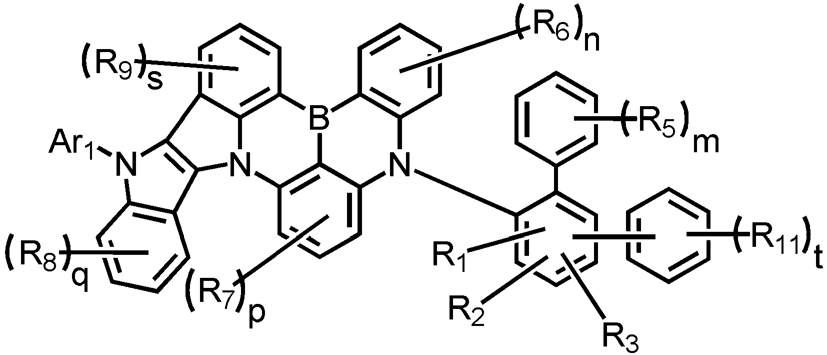

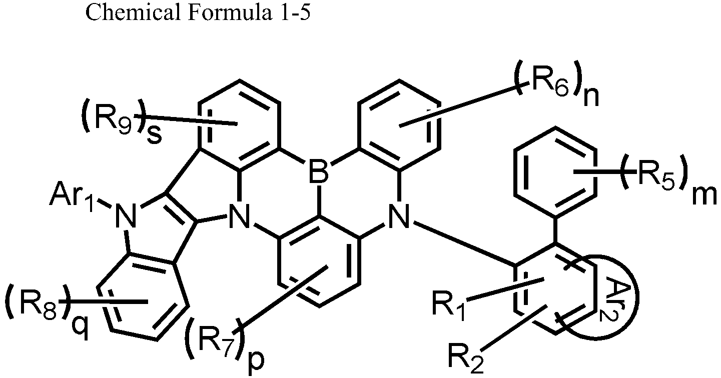

In Chemical formulae 1-4 and 1-5, Ar₁, R₁ to R₃, R₅ to R₉, , n, m, p, q and s may be the same as those described herein.

In Chemical Formula 1-4, R₁₁ may be hydrogen, deuterium, halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ (e.g. C₁-C₂₀) alkyl group, a substituted or unsubstituted C₂-C₆₀ (e.g. C₂-C₂₀) alkenyl group, a substituted or unsubstituted C₂-C₆₀ (e.g. C₂-C₂₀) alkynyl group, a substituted or unsubstituted C₁-C₆₀ (e.g. C₁-C₂₀) alkoxy group, a substituted or unsubstituted C₁-C₆₀ (e.g. C₁-C₂₀) alkylthio group, a substituted or unsubstituted C₃-C₆₀ (e.g. C₃-C₂₀) cycloalkyl group, a substituted or unsubstituted C₅-C₆₀ (e.g. C₅-C₂₀) cycloalkenyl group, a substituted or unsubstituted C₃-C₆₀ (e.g. C₃-C₂₀) heterocycloalkyl group, a substituted or unsubstituted C₁-C₆₀ (e.g. C₁-C₂₀) heterocycloalkenyl group, a substituted or unsubstituted C₆-C₆₀ (e.g. C₆-C₃₀) aryl group, a substituted or unsubstituted C₇-C₆₀ (e.g. C₇-C₃₀) alkyl aryl group, a substituted or unsubstituted C₇-C₆₀ (e.g. C₇-C₃₀) aryl alkyl group, a substituted or unsubstituted C₁-C₆₀ (e.g. C₁-C₂₀) heteroaryl group, a substituted or unsubstituted C₂-C₆₀ (e.g. C₂-C₃₀) alkyl heteroaryl group, a substituted or unsubstituted C₂-C₆₀ (e.g. C₂-C₃₀) heteroaryl alkyl group, a substituted or unsubstituted C₆-C₆₀ (e.g. C₆-C₃₀) aryloxy group, a substituted or unsubstituted C₆-C₆₀ (e.g. C₆-C₃₀) arylthio group, a substituted or unsubstituted C₁-C₆₀ (e.g. C₁-C₂₀) heteroaryloxy group, a substituted or unsubstituted C₁-C₆₀ (e.g. C₁-C₂₀) heteroarylthio group, a substituted or unsubstituted C₈-C₆₀ (e.g. C₈-C₃₀) condensed polycyclic group, -SiRR'R", -PRR', - P(=O)RR', -NRR', -BRR', -C(=O)R, -S(=O)R, or -S(=O)₂R; or may be combined with an adjacent group to form a substituted or unsubstituted C₃-C₆₀ (e.g. C₃-C₂₀) cycloalkyl group, a substituted or unsubstituted C₅-C₆₀ (e.g. C₅-C₂₀) cycloalkenyl group, a substituted or unsubstituted C₃-C₆₀ (e.g. C₃-C₂₀) heterocycloalkyl group, a substituted or unsubstituted C₁-C₆₀ (e.g. C₁-C₂₀) heterocycloalkenyl group, a substituted or unsubstituted C₆-C₆₀ (e.g. C₆-C₃₀) aryl group, or a substituted or unsubstituted C₂-C₆₀ (e.g. C₂-C₂₀) heteroaryl group.

R, R', and R" may be the same as those described herein.

For example, R₁₁ may be hydrogen, deuterium, a substituted or unsubstituted phenyl group, a substituted or unsubstituted biphenyl group, a substituted or unsubstituted tert-butyl group, a deuterium-substituted or unsubstituted phenyl group, a deuterium-substituted or unsubstituted biphenyl group, or a deuterium-substituted or unsubstituted tert-butyl group.

In Chemical Formula 1-4, t may be an integer from 0 to 5. For example, t may be 0, 1 or 2.

In Chemical Formula 1-4, when t is 2 or more, a plurality of R₁₁ may be the same as or different from each other.

In Chemical Formula 1-5, Ar₂ may be a substituted or unsubstituted C₆-C₆₀ aryl group, or a substituted or unsubstituted C₂-C₆₀ heteroaryl group. According to embodiments, Ar₂ may be a substituted or unsubstituted C₆-C₄₀ aryl group, or a substituted or unsubstituted C₂-C₄₀ heteroaryl group. In some embodiments, Ar₂ may be a substituted or unsubstituted C₆-C₂₀ aryl group, or a substituted or unsubstituted C₂-C₂₀ heteroaryl group.

According to embodiments, Ar₂ may be a deuterium-substituted or unsubstituted C₆-C₆₀ aryl group, or a deuterium-substituted or unsubstituted C₂-C₆₀ heteroaryl group. In some embodiments, Ar₂ may be a deuterium-substituted or unsubstituted C₆-C₄₀ aryl group, or a deuterium-substituted or unsubstituted C₂-C₄₀ heteroaryl group. For example, Ar₂ may be a deuterium-substituted or unsubstituted C₆-C₂₀ aryl group, or a deuterium-substituted or unsubstituted C₂-C₂₀ heteroaryl group.

For example, Ar₂ may be a substituted or unsubstituted phenyl group, a substituted or unsubstituted biphenyl group, a substituted or unsubstituted terphenyl group, a substituted or unsubstituted quaterphenyl group, a substituted or unsubstituted quinquephenyl group, a substituted or unsubstituted naphthalene group, a substituted or unsubstituted anthracene group, a substituted or unsubstituted pyridine group, a substituted or unsubstituted pyridazine group, a substituted or unsubstituted pyrazine group, a substituted or unsubstituted triazine group, a substituted or unsubstituted indene group, a substituted or unsubstituted dihydroindene group, a substituted or unsubstituted fluorene group, a substituted or unsubstituted spirobifluorene group, a substituted or unsubstituted indoline group, a substituted or unsubstituted indole group, a substituted or unsubstituted isoindole group, a substituted or unsubstituted indolizine group, a substituted or unsubstituted indazole group, a substituted or unsubstituted benzimidazole group, a substituted or unsubstituted azaindole group, a substituted or unsubstituted benzofuran group, a substituted or unsubstituted dibenzofuran group, a substituted or unsubstituted isobenzofuran group, a substituted or unsubstituted benzothiophene group, a substituted or unsubstituted tetrahydroquinoline group, a substituted or unsubstituted dihydroquinoline group, a substituted or unsubstituted quinoline group, a substituted or unsubstituted isoquinoline group, or a substituted or unsubstituted quinoxaline group.

For example, Ar₂ may be a deuterium-substituted or unsubstituted phenyl group, a deuterium-substituted or unsubstituted biphenyl group, a deuterium-substituted or unsubstituted terphenyl group, a deuterium-substituted or unsubstituted quaterphenyl group, a deuterium-substituted or unsubstituted quinquephenyl group, a deuterium-substituted or unsubstituted naphthalene group, a deuterium-substituted or unsubstituted anthracene group, a deuterium-substituted or unsubstituted pyridine group, a deuterium-substituted or unsubstituted pyridazine group, a deuterium-substituted or unsubstituted pyrazine group, a deuterium-substituted or unsubstituted triazine group, a deuterium-substituted or unsubstituted indene group, a deuterium-substituted or unsubstituted dihydroindene group, a deuterium-substituted or unsubstituted fluorene group, a deuterium-substituted or unsubstituted spirobifluorene group, a deuterium-substituted or unsubstituted indoline group, a deuterium-substituted or unsubstituted indole group, a deuterium-substituted or unsubstituted isoindole group, a deuterium-substituted or unsubstituted indolizine group, a deuterium-substituted or unsubstituted indazole group, a deuterium-substituted or unsubstituted benzimidazole group, a deuterium-substituted or unsubstituted azaindole group, a deuterium-substituted or unsubstituted benzofuran group, a deuterium-substituted or unsubstituted dibenzofuran group, a deuterium-substituted or unsubstituted isobenzofuran group, a deuterium-substituted or unsubstituted benzothiophene group, a deuterium-substituted or unsubstituted tetrahydroquinoline group, a deuterium-substituted or unsubstituted dihydroquinoline group, a deuterium-substituted or unsubstituted quinoline group, a deuterium-substituted or unsubstituted isoquinoline group, or a deuterium-substituted or unsubstituted quinoxaline group.

In some embodiments, the condensed heterocyclic compound represented by Chemical Formula 1 may be represented by Chemical Formula 1-6 or Chemical Formula 1-7.

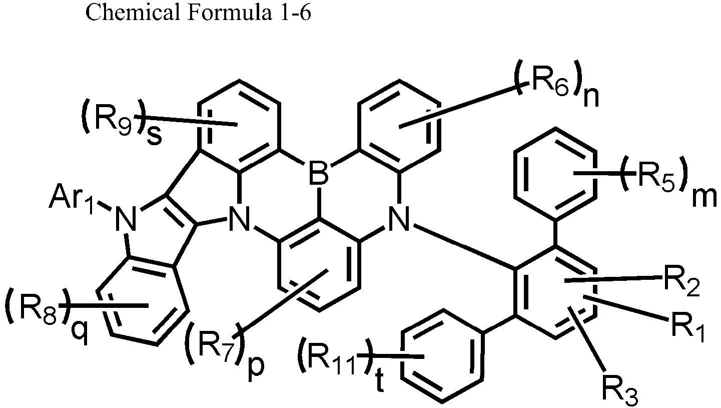

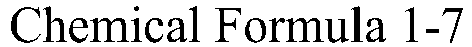

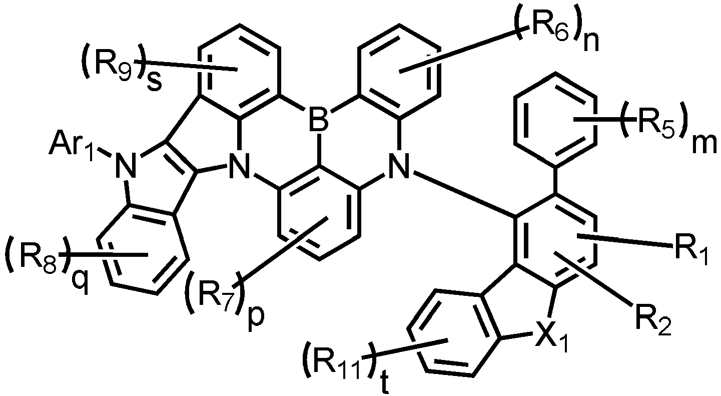

In Chemical Formulae 1-6 and 1-7, Ar₁, R₁ to R₃, R₅ to R₉, R₁₁, n, m, p, q, s, and t may be the same as those described herein. In Chemical Formula 1-7, X₁ may be O or S.

A degree of deuterium substitution of the condensed heterocyclic compound represented by Chemical Formula 1 according to some embodiments may be from 0% to 100%. The degree of deuterium substitution may be a value calculated as a percentage of the number of deuterium atoms relative to the sum of the number of hydrogen atoms and the number of deuterium atoms included in the compound. For example, the degree of deuterium substitution of benzene substituted with 5 deuterium atoms may be about 83.33%.

The degree of deuterium substitution of the condensed heterocyclic compound represented by Chemical Formula 1 according to some embodiments may be from 1% to 100%, from 5% to 100%, from 20% to 100%, from 30% to 100%, from 40% to 100%, or from 50% to 100%.

The degree of deuterium substitution of the condensed heterocyclic compound represented by Chemical Formula 1 according to some embodiments may be from 0% to 90%, from 0% to 80%, from 0% to 70%, from 0% to 60%, or from 0% to 50%.

The condensed heterocyclic compound represented by Chemical Formula 1 according to some embodiments may include at least one of the compounds represented by the chemical formulae below:

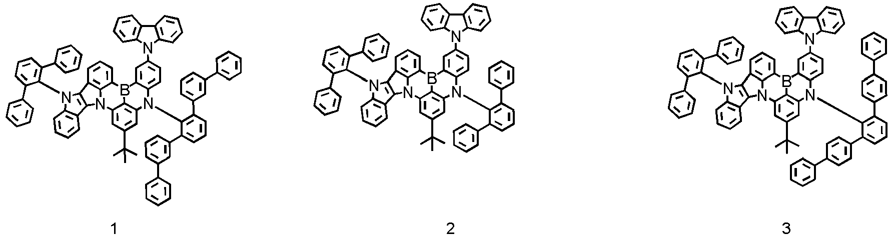

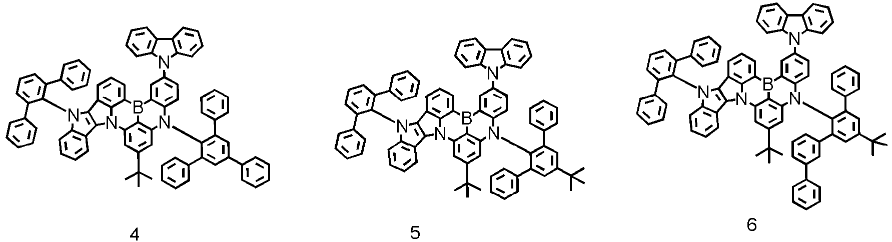

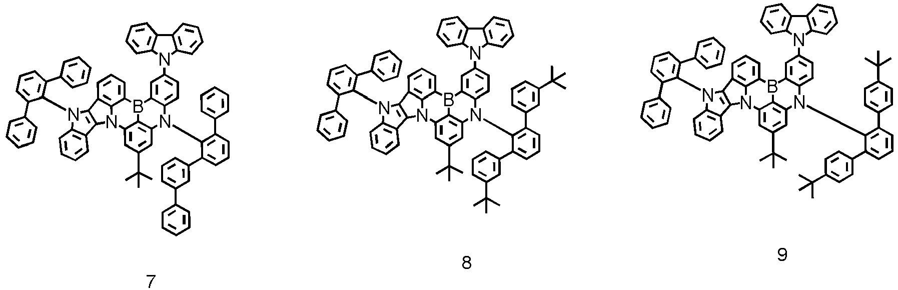

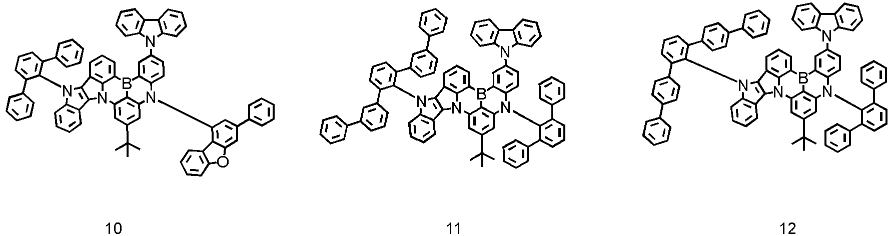

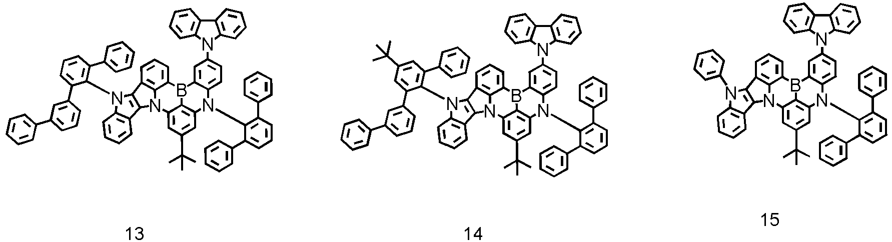

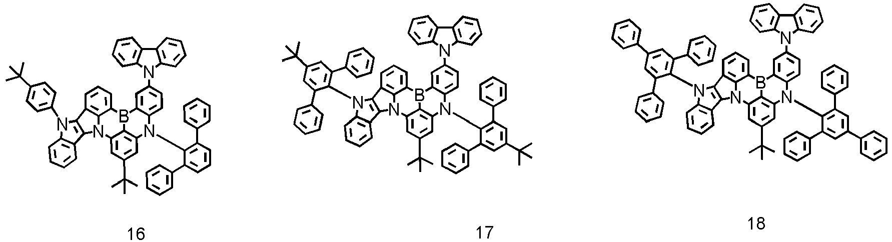

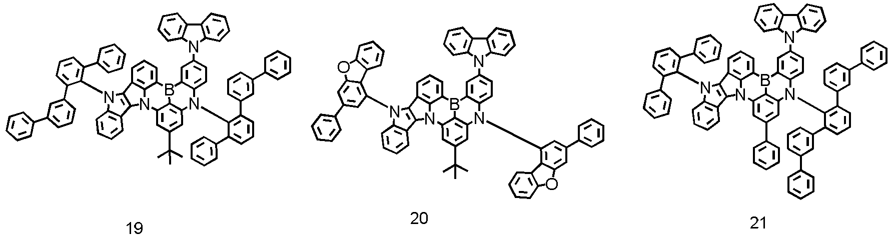

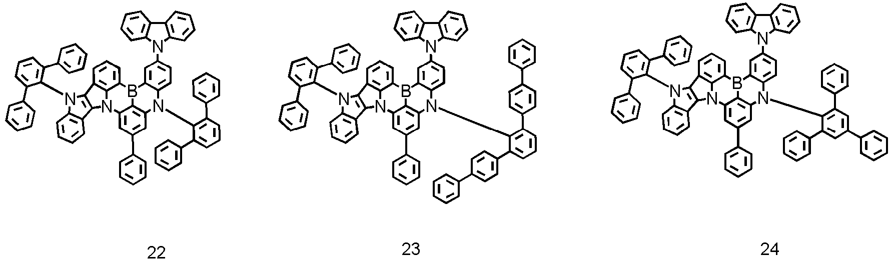

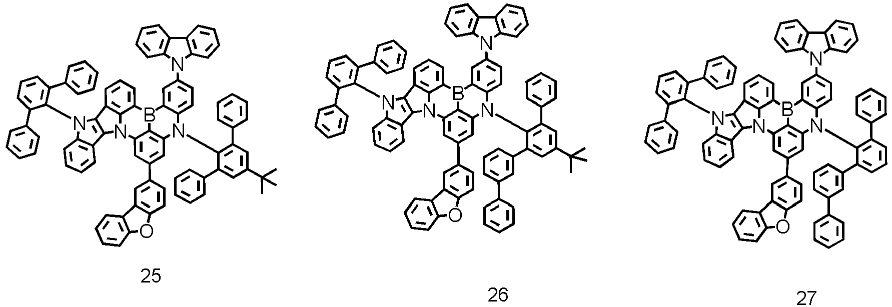

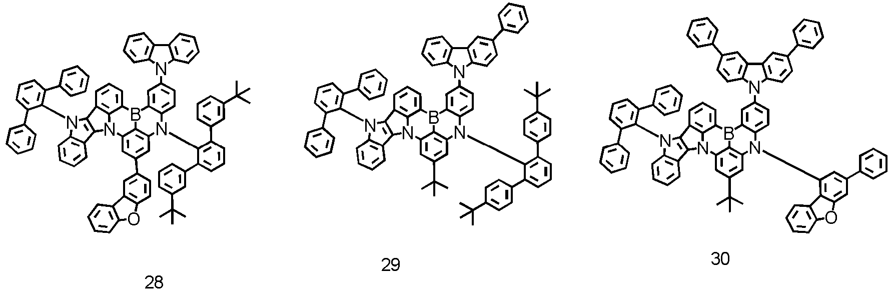

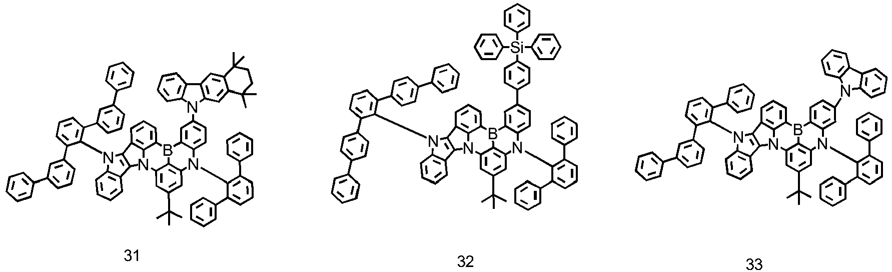

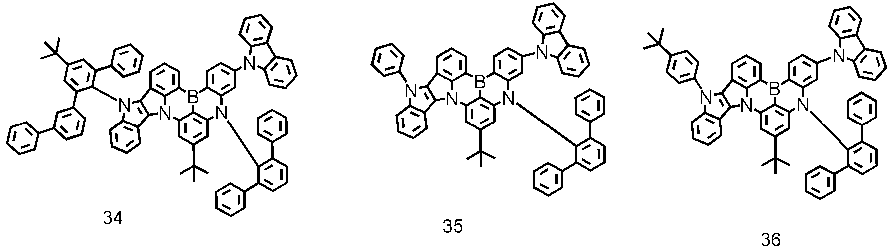

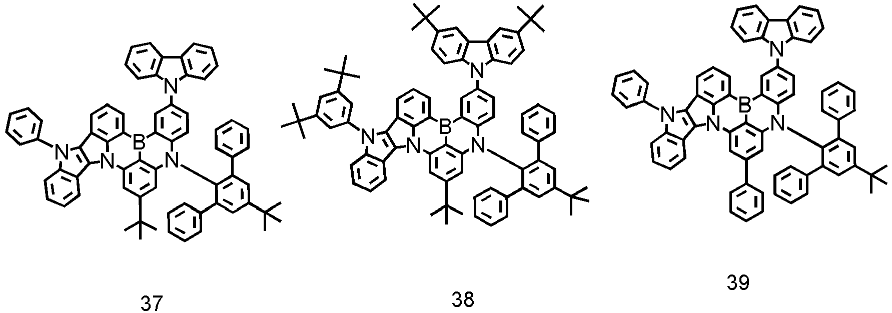

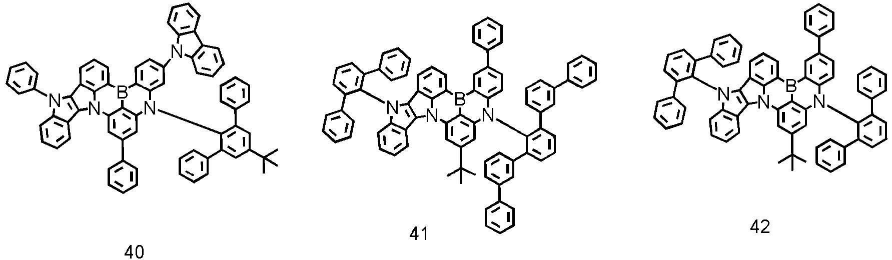

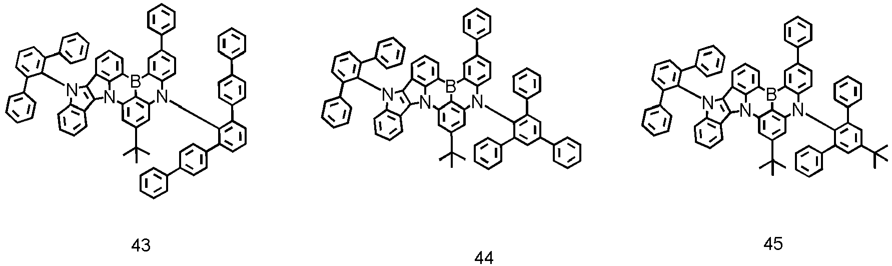

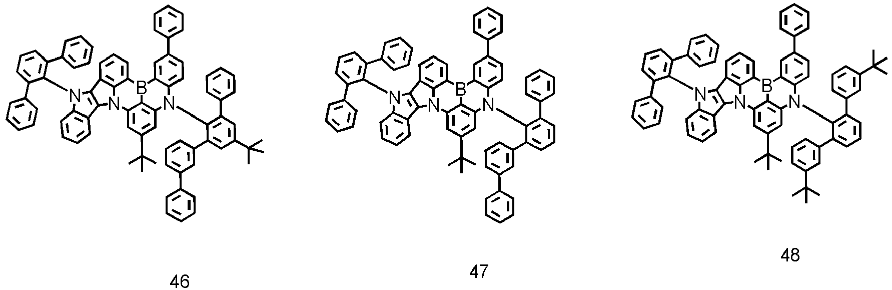

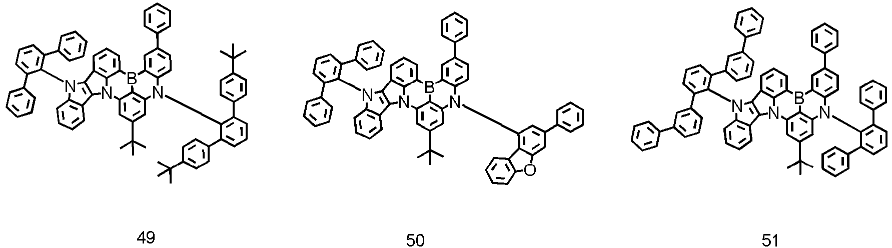

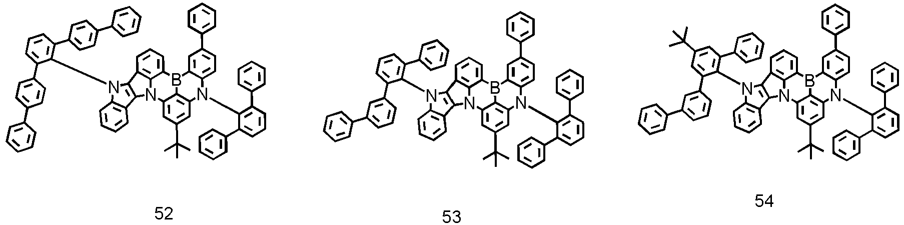

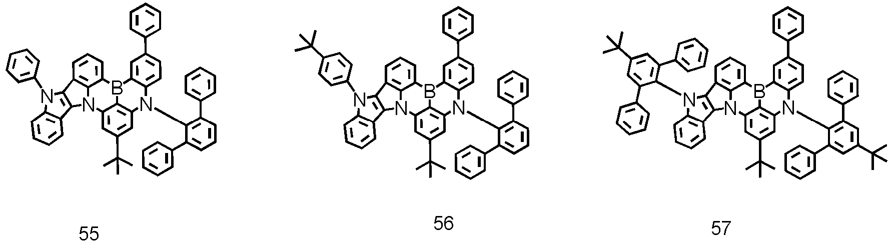

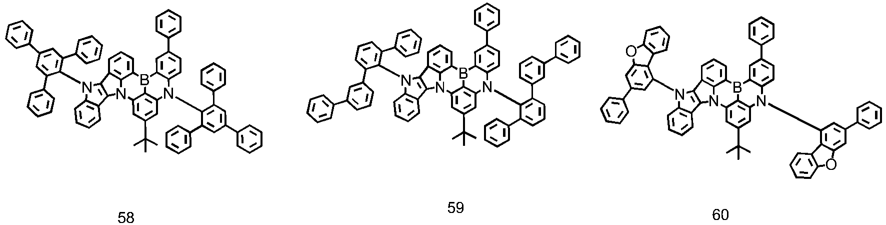

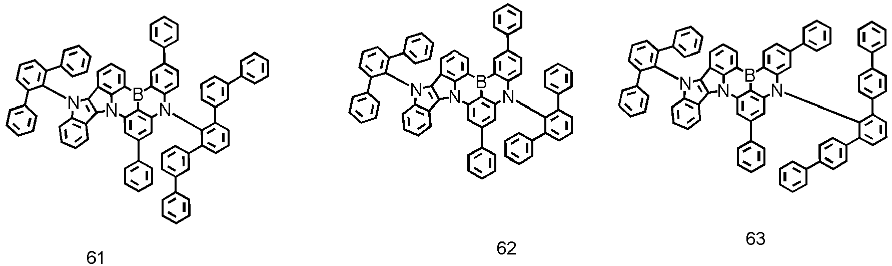

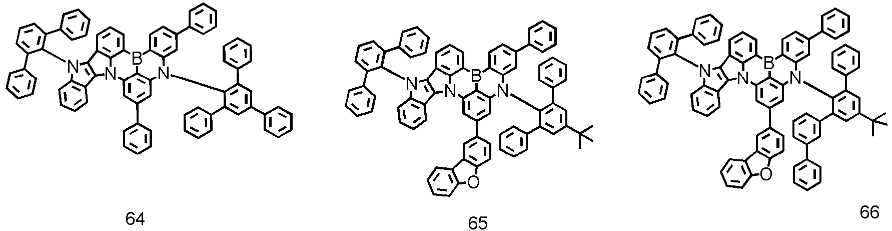

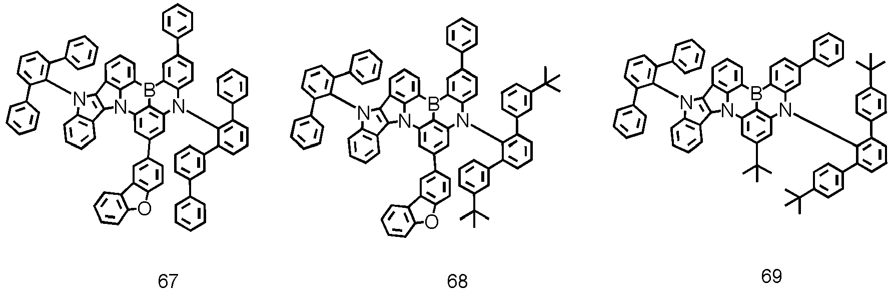

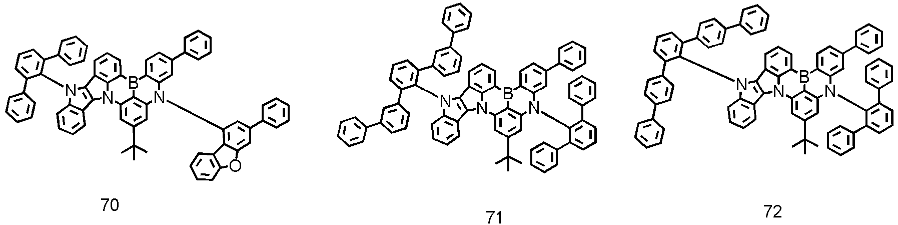

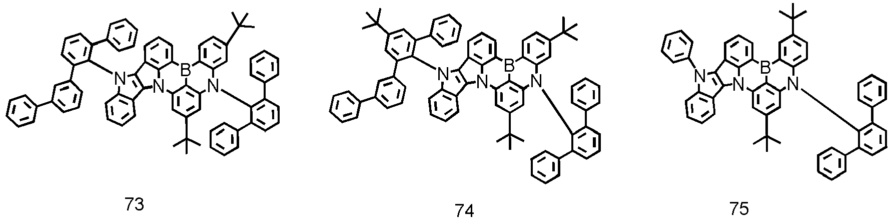

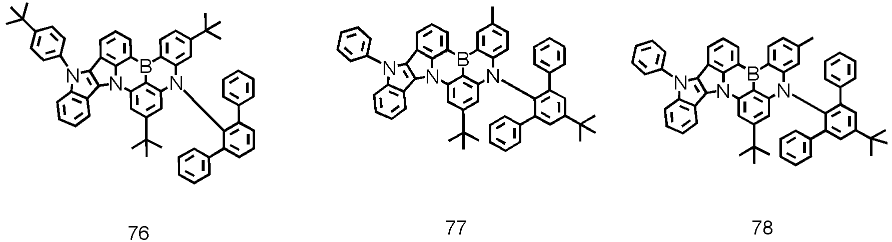

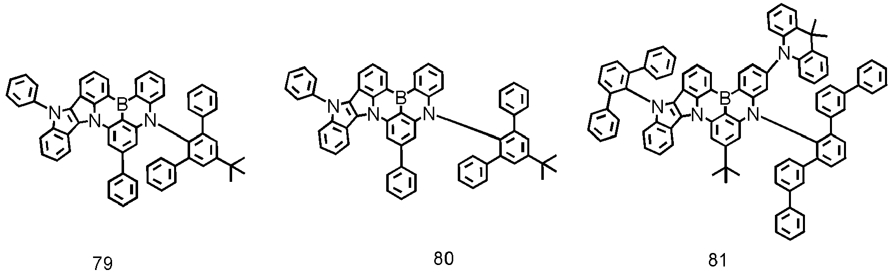

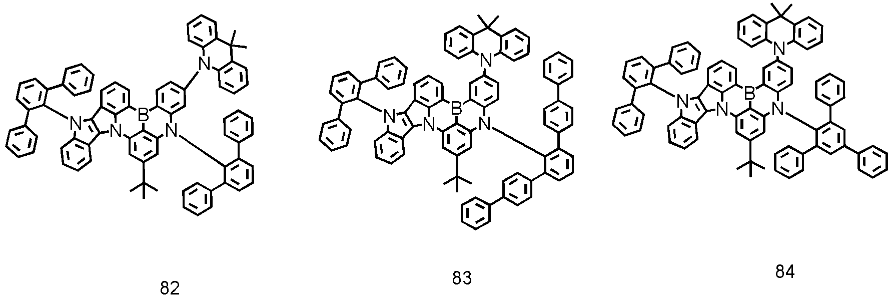

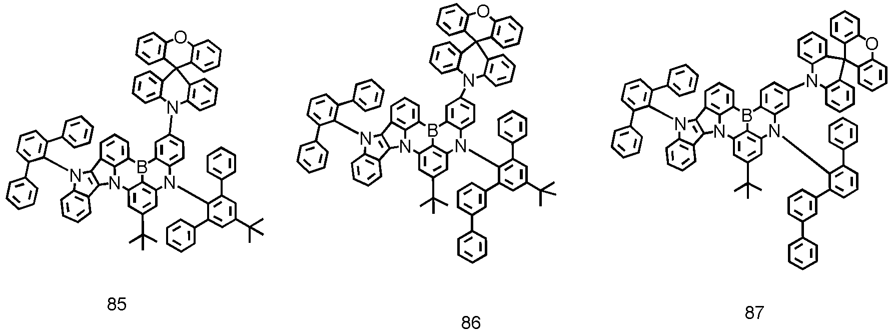

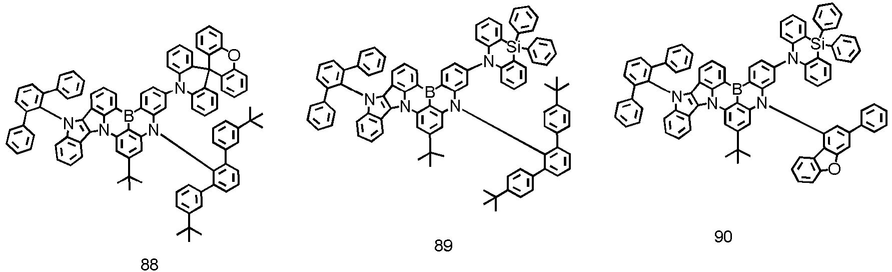

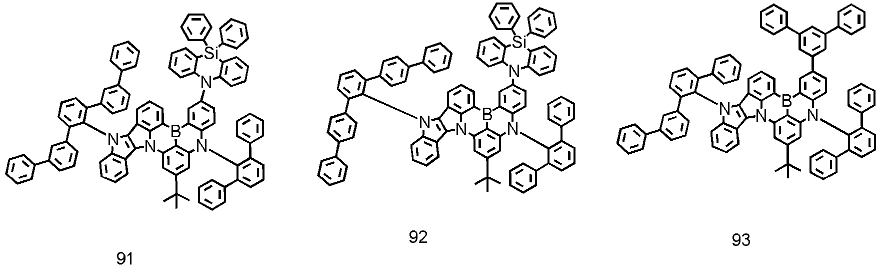

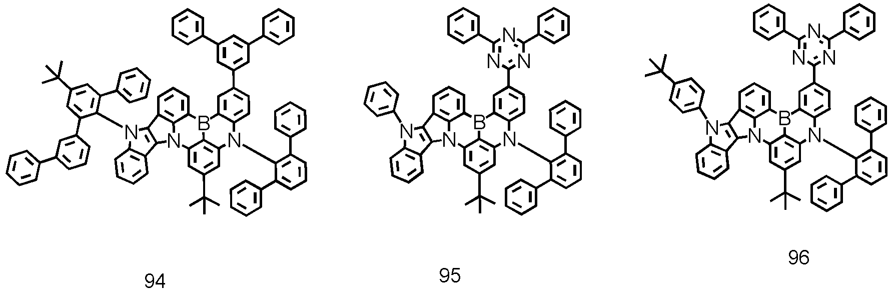

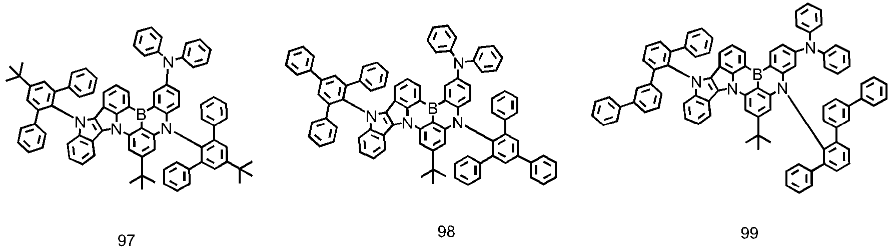

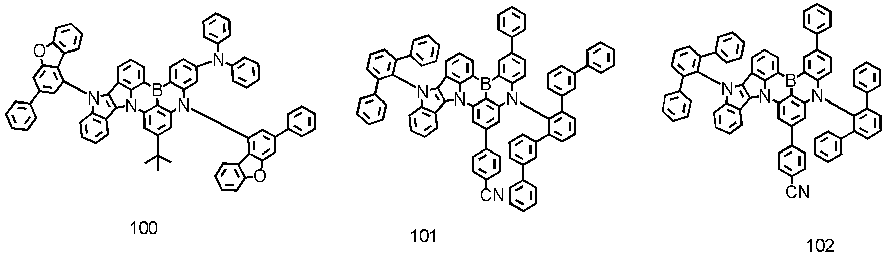

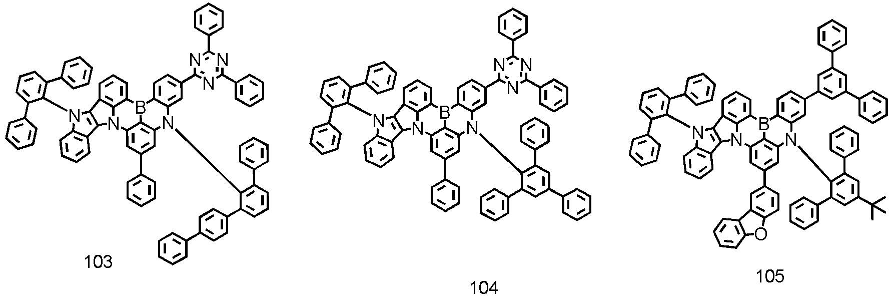

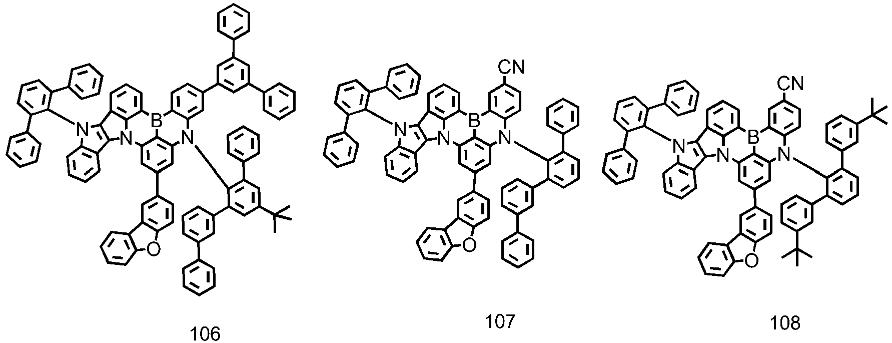

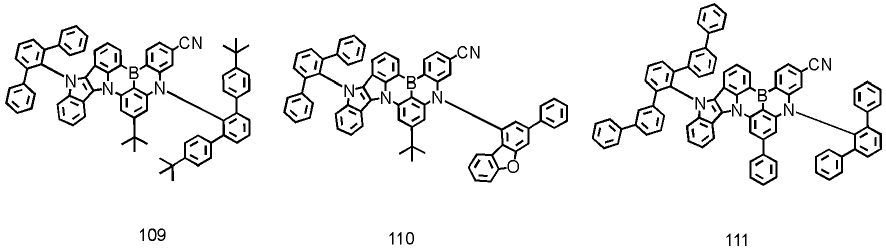

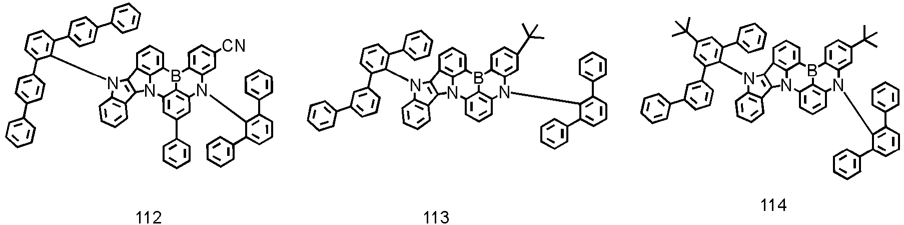

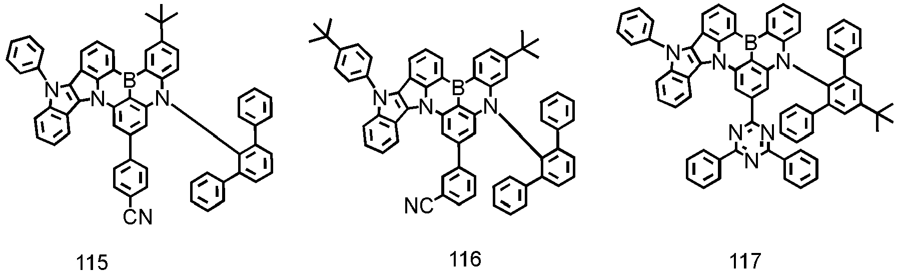

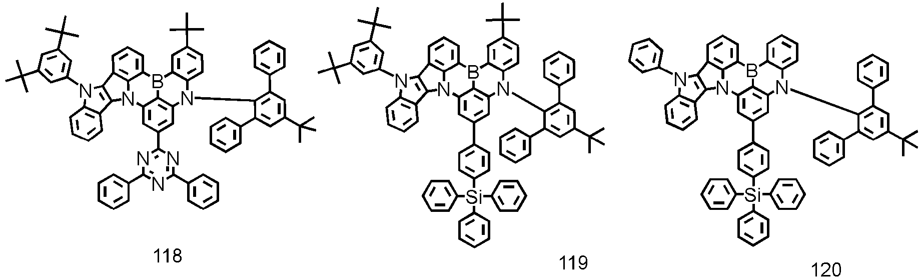

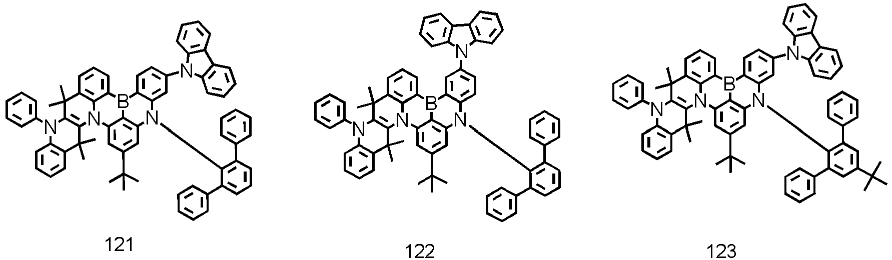

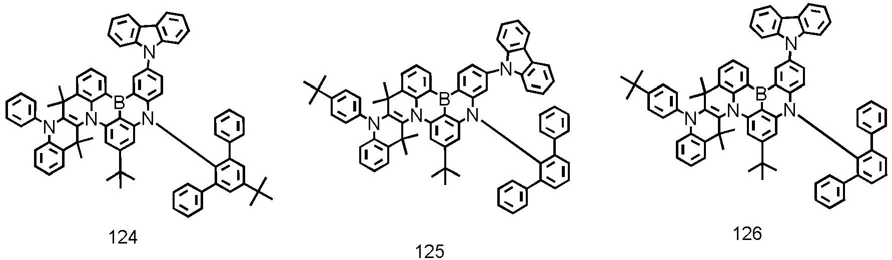

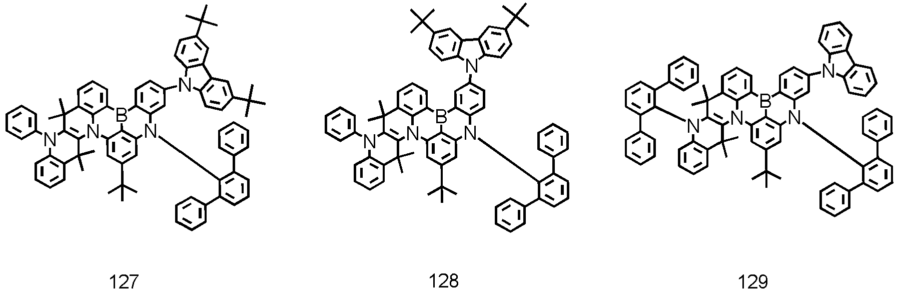

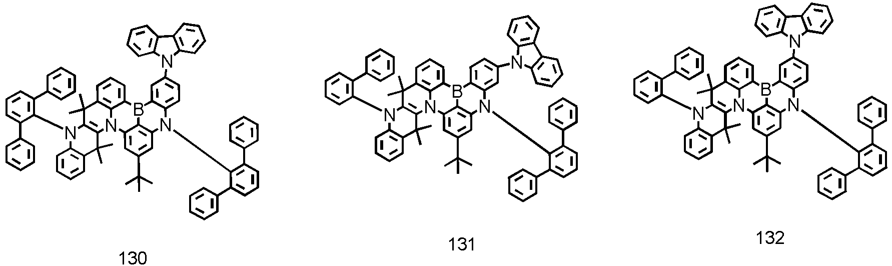

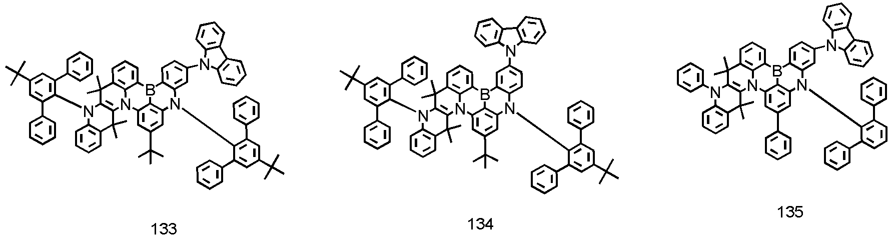

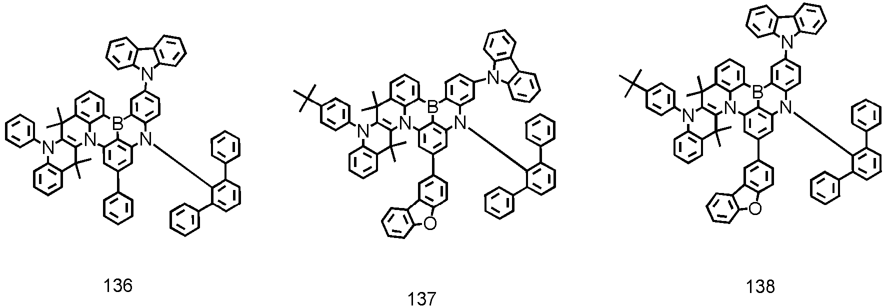

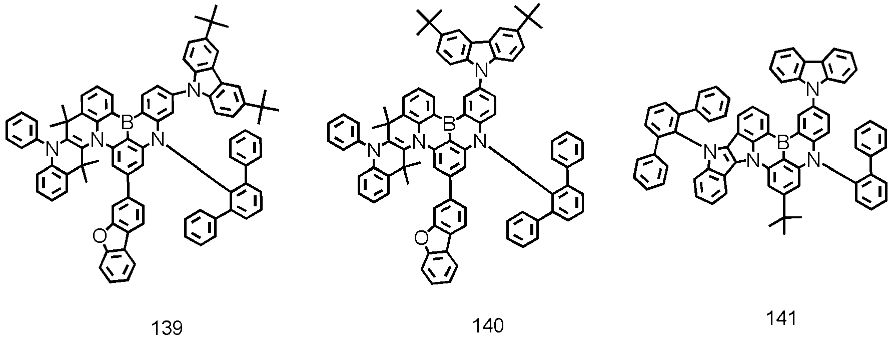

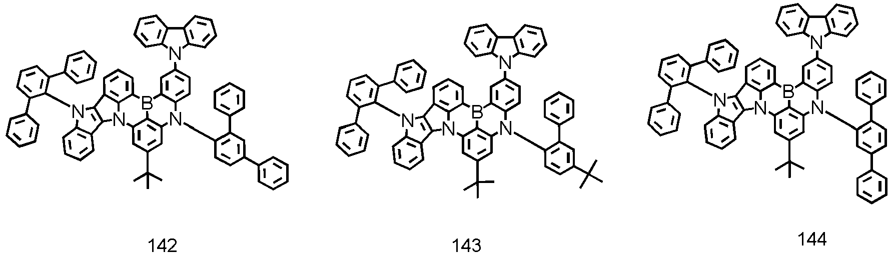

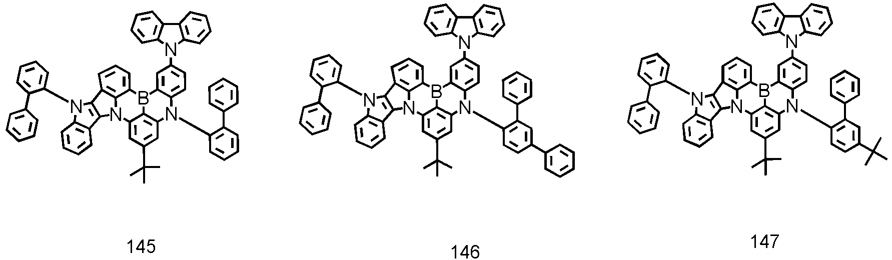

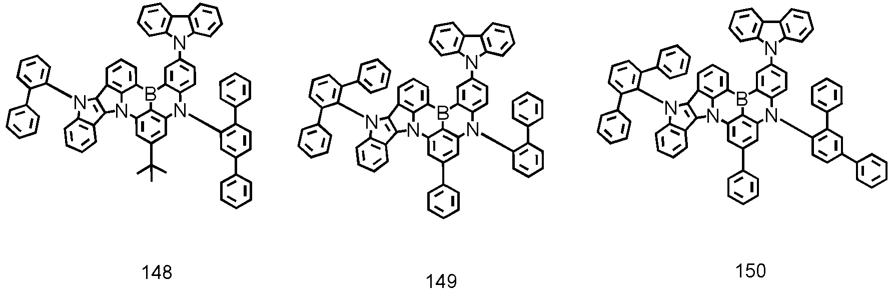

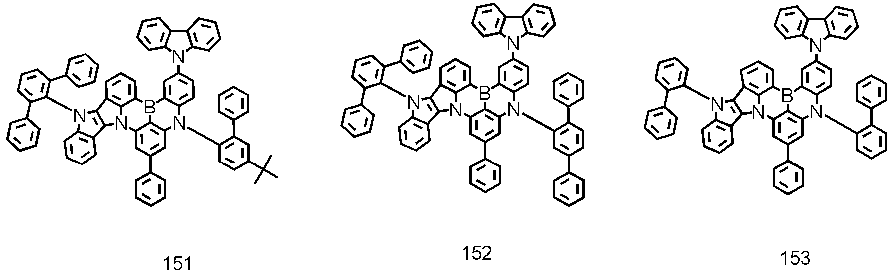

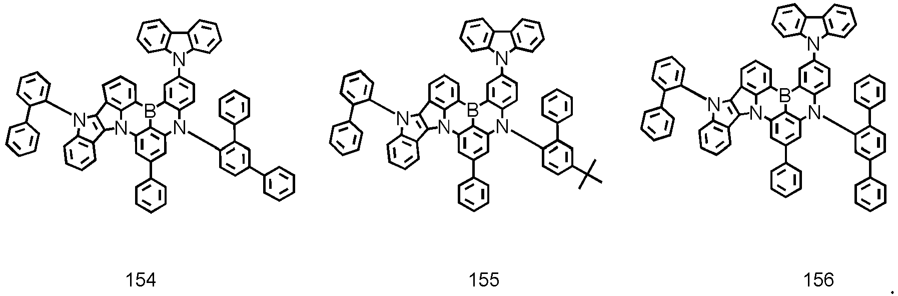

The condensed heterocyclic compound represented by Chemical Formula 1 has a condensed heterocyclic structure containing boron and nitrogen as a core. The core has a condensed ring structure in which two nitrogen atoms are arranged in a staggered form. For example, the core may have a structure containing an indoloindole or quinoloquinoline moiety.

According to some embodiments, the condensed heterocyclic compound represented by Chemical Formula 1 may be used as a dopant in an emission layer of a light-emitting device as described herein.

Without wishing to be bound to theory, the aryl groups bonded to nitrogen of the core structure may increase a distance between the condensed heterocyclic compound represented by Chemical Formula 1 and a host, so that side reactions due to interactions between molecules may be reduced. Thus, life-span properties of the light-emitting device including the condensed heterocyclic compound represented by Chemical Formula 1 may be improved.

The condensed heterocyclic compound represented by Chemical Formula 1 according to the present disclosure may have a stable molecular structure, and may have improved chemical stability. Accordingly, the compound structure may be maintained for a long period in the light-emitting device, and the life-span properties of the light-emitting device may be further improved.

According to some embodiments, the condensed heterocyclic compound represented by Chemical Formula 1 may be used as a compound for a hole injection layer, a compound for a hole transport layer, a compound for an emission layer, a compound for an auxiliary emission layer, a compound for a hole blocking layer, a compound for an electron transport layer, a compound for an electron injection layer, and/or a compound for a charge generation layer.

In some embodiments, the condensed heterocyclic compound represented by Chemical Formula 1 may be used as a host in the emission layer of the light-emitting device, as described herein.

According to some embodiments, the condensed heterocyclic compound represented by Chemical Formula 1 may be used as a green light-emitting dopant.

### Light-Emitting Device

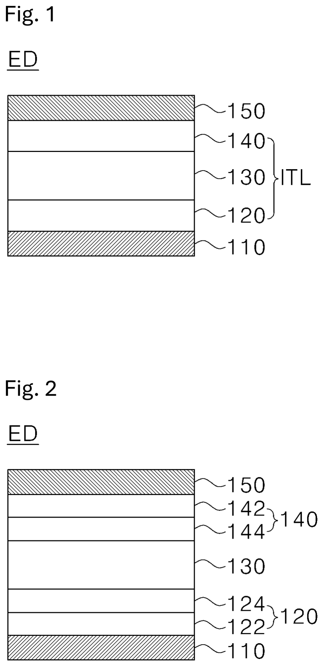

FIGS. 1 to 6 are schematic cross-sectional views illustrating light-emitting devices in accordance with example embodiments.

Referring to FIG. 1, a light-emitting device ED includes a first electrode 110, a second electrode 150, and an intermediate layer ITL interposed between the first electrode 110 and the second electrode 150. The intermediate layer ITL may include an emission layer 130. The intermediate layer ITL may further include an organic layer including a hole transfer region 120 and an electron transfer region 140.

The first electrode 110 may be an anode or a cathode. In some embodiments, embodiments, the first electrode 110 may be an anode, and may serve as a pixel electrode. In this case, the first electrode 110 may include a conductive material with a high work function that promotes hole injection.

In one or more embodiments, the first electrode 110 may be a transmissive electrode. The first electrode 110 may include a transparent conductive oxide such as indium tin oxide (ITO), indium zinc oxide (IZO), zinc oxide (ZnO), indium tin zinc oxide (ITZO), or the like.

In one or more embodiments, the first electrode 110 may be a translucent electrode or a reflective electrode. The first electrode 110 may include a metal such as Ag, Mg, Cu, Al, Pt, Pd, Au, Ni, Nd, Ir, Cr, Li, Ca, LiF, Mo, Ti, W, In, Sn, Zn, or the like, or an alloy or a compound (e.g., LiF) including at least one thereof. For example, the first electrode 110 may include Li, Ca, LiF/Ca (a stacked structure of LiF and Ca), LiF/Al (a stacked structure of LiF and Al), a mixture of Ag and Mg, or the like.

The first electrode 110 may have a single-layered structure or a multi-layered structure. For example, the first electrode 110 may have a triple-layered structure of ITO/Ag/ITO.

A thickness of the first electrode 110 may be about 700 angstroms (Å) to about 10,000 Å. For example, the thickness of the first electrode 110 may be about 1,000 Å to about 3,000 Å.

The second electrode 150 may be a cathode or an anode. In some embodiments, the second electrode 150 may serve as an electron injection electrode or as a cathode. The second electrode 150 may include a metal, an alloy, an electrically conductive compound, or the like, having a low work function.

For example, the second electrode 150 may include lithium (Li), silver (Ag), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), ITO, IZO, or the like. The second electrode 150 may include one of the aforementioned materials, or a combination thereof.

The second electrode 150 may be a transmissive electrode, a translucent electrode, or a reflective electrode. The second electrode 150 may have a single-layered structure or a multi-layered structure.

The emission layer 130 includes a host and a dopant, and the dopant may include at least one of the above-described condensed heterocyclic compounds represented by Chemical Formula 1.

In some embodiments, the condensed heterocyclic compound represented by Chemical Formula 1 may be provided as a fluorescent dopant or a phosphorescent dopant. For example, the condensed heterocyclic compound represented by Chemical Formula 1 may be provided as a thermally activated delayed fluorescence (TADF) dopant.

In one or more embodiments, the condensed heterocyclic compound represented by Chemical Formula 1 may be included as a green light-emitting dopant.

The emission layer 130 may further include a host material different from the condensed heterocyclic compound represented by Chemical Formula 1. For example, the emission layer 130 may include a host material such as an anthracene derivative, a pyrene derivative, a fluoranthene derivative, a chrysene derivative, a dihydrobenzanthracene derivative, a triphenylene derivative, or the like.

In some embodiments, the emission layer 130 may include, e.g., a host material represented by Chemical Formula FH. For example, the compound represented by Chemical Formula FH may be used as a fluorescent host material.

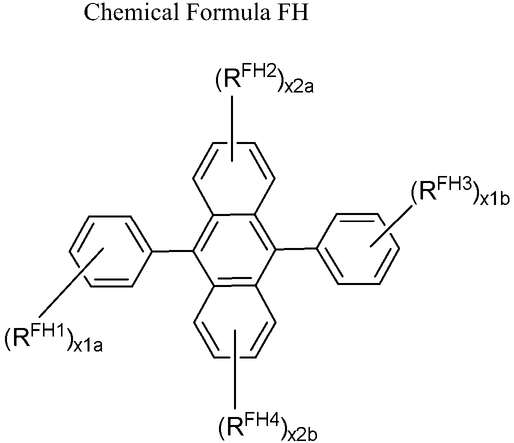

In Chemical Formula FH, R^{FH1} to R^{FH4} may each independently be a hydrogen atom, a deuterium atom, a halogen atom, a substituted or unsubstituted silyl group, a substituted or unsubstituted thio group, a substituted or unsubstituted oxy group, a substituted or unsubstituted C₁-C₁₀ alkyl group, a substituted or unsubstituted C₂-C₁₀ alkenyl group, a substituted or unsubstituted C₆-C₃₀ aryl group, a substituted or unsubstituted C₁-C₃₀ heteroaryl group, or a cyclic group formed through a combination thereof. In one or more embodiments, in Chemical Formula FH, at least one of R^{FH1} to R^{FH4} may form a condensed ring group with a bonded benzene ring.

In Chemical Formula FH, x1a and x1b may each independently be an integer from 0 to 5; and x2a and x2b may each independently be an integer from 0 to 4. When x1a, x1b, x2a, and x2b are each 2 or more, two or more of each of R^{FH1} to R^{FH4} may be the same as or different from each other.

In some embodiments, the emission layer 130 may include, e.g., a host material represented by Chemical Formula PH. For example, the compound represented by Chemical Formula PH may be used as a host material for a phosphorescent emission layer or a phosphorescent device.

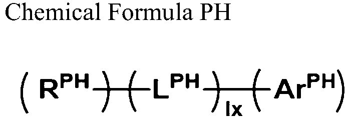

In Chemical Formula PH, R^{PH} may be a substituted or unsubstituted carbazole group. L^{PH} may be a direct linkage, a substituted or unsubstituted C₆-C₃₀ arylene group, or a substituted or unsubstituted C₁-C₃₀ heteroarylene group. Ar^{PH} may be a substituted or unsubstituted C₆-C₃₀ aryl group, or a substituted or unsubstituted C₁-C₃₀ heteroaryl group.

As described herein, the term "C₆-C₃₀ aryl group" may encompass a group in which multiple aryl rings are condensed or bonded through a cyclic group (e.g., an alicyclic hydrocarbon ring). For example, a C₆-C₃₀ aryl group may be a fluorenyl group.

As described herein, the term "C₁-C₃₀ heteroaryl group" may encompass a group in which multiple aryl rings are condensed or bonded through a heterocyclic ring. For example, a C₁-C₃₀ heteroaryl group may be a carbazole group, a dibenzofuran group, a dibenzothiophene group, or the like. In one or more embodiments, a C₁-C₃₀ heteroaryl group may be a group in which multiple aryl rings are condensed or bonded to each other through the same or different heterocyclic rings.

In one or more embodiments, a substituent included in Ar^{PH} may be a silyl group represented by -Si(R^{sa})(R^{sb})(R^{sc}); and R^{sa}, R^{sb}, and R^{sc} may each independently be hydrogen, a halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₁-C₆₀ alkoxy group, a C₁-C₆₀ alkylthio group, a C₆-C₆₀ aryl group, or a C₁-C₃₀ heteroaryl group. At least one of R^{sa}, R^{sb}, and R^{sc} may be a C₆-C₆₀ aryl group or a C₁-C₃₀ heteroaryl group. For example, R^{sa}, R^{sb} and R^{sc} may each independently be a C₆-C₆₀ aryl group or a C₁-C₃₀ heteroaryl group.

In Chemical Formula PH, lx may be an integer from 0 to 10. When lx is 2 or more, two or more of L^{PH} may be the same as or different from each other.

The emission layer 130 may include, for example, at least one of BCPDS (bis (4-(9H-carbazol-9-yl) phenyl) diphenylsilane), POPCPA ((4-(1-(4-(diphenylamino) phenyl) cyclohexyl) phenyl) diphenyl-phosphine oxide), DPEPO (bis[2-(diphenylphosphino)phenyl] ether oxide), mCBP (3,3'-di(9H-carbazol-9-yl)-1,1'-biphenyl), CBP (4,4'-bis(N-carbazolyl)-1,1'-biphenyl), mCP (1,3-bis(carbazol-9-yl)benzene), PPF (2,8-bis(diphenylphosphoryl) dibenzo[b,d]furan), TCTA (4,4',4"-tris(carbazol-9-yl)-triphenylamine), TPBi (1,3,5-tris(1-phenyl-1H-benzo[d]imidazole-2-yl)benzene), Alq3 (tris(8-hydroxyquinolino) aluminium), ADN (9,10-di(naphthalene-2-yl)anthracene), TBADN (2-tert-butyl-9,10-di(naphth-2-yl)anthracene), DSA (distyrylarylene), CDBP (4,4'-bis(9-carbazolyl)-2,2'-dimethyl-biphenyl), MADN (2-methyl-9,10-bis(naphthalen-2-yl)anthracene), CP1 (hexaphenyl cyclotriphosphazene), UGH2 (1,4-bis(triphenylsilyl)benzene), DPSiO3 (hexaphenylcyclotrisiloxane), DPSiO4 (octaphenylcyclotetrasiloxane), BPCbzCbz (9-([1,1'-biphenyl]-3-yl)-9H-3,9'-bicarbazole) or the like, as a host material.

In one or more embodiments, in the emission layer 130, the host may include one of the materials as described herein, or any combination thereof.

In some embodiments, the emission layer 130 may further include a dopant represented by Chemical Formula FD below. For example, a compound represented by Chemical Formula FD may be used as a fluorescent dopant.

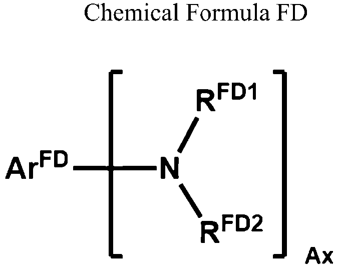

In Chemical Formula FD, Ar^{FD}, R^{FD1}, and R^{FD2} may each independently be a substituted or unsubstituted C₅-C₆₀ carbocyclic group, or a substituted or unsubstituted C₁-C₆₀ heterocyclic group. Ax may be an integer from 1 to 6.

In some embodiments, Ar^{FD} may include a condensed ring structure in which three or more aryl rings or benzene rings are condensed together (e.g., an anthracene group, a chrysene group, a pyrene group, or the like).

In some embodiments, the emission layer 130 may include a phosphorescent dopant. The phosphorescent dopant may include an organometallic compound that includes a central metal and at least one ligand bonded to the central metal via a coordination bond. The central metal may include, e.g., a transition metal, and the ligand may include, e.g., a monodentate ligand, a bidentate ligand, a tridentate ligand, a tetradentate ligand, a pentadentate ligand, a hexadentate ligand, or a combination thereof.

The phosphorescent dopant may include, e.g., a compound represented by Chemical Formula PD.

Chemical Formula PD M(L_{d}¹)_{dx1}(L_{d}²)_{dx2}

In Chemical Formula PD, M may be a transition metal atom, e.g., iridium (Ir), platinum (Pt), palladium (Pd), osmium (Os), titanium (Ti), gold (Au), hafnium (Hf), europium (Eu), terbium (Tb), rhodium (Rh), rhenium (Re), ruthenium (Ru), copper (Cu), or thulium (Tm).

In Chemical Formula PD, L_{d}¹ may be a ligand represented by Chemical Formula LD1.

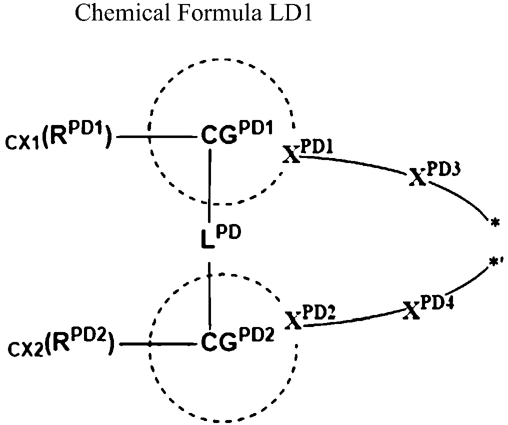

In Chemical Formula LD1, X^{PD1} and X^{PD2} may each independently be C or N.

In one or more embodiments, one of X^{PD1} and X^{PD2} may be C, and the other may be N. In one or more embodiments, X^{PD1} and X^{PD2} may each be N.

In Chemical Formula LD1, CG^{PD1}, and CG^{PD2} may each independently be a substituted or unsubstituted C₅-C₆₀ carbocyclic group, or a substituted or unsubstituted C₁-C₆₀ heterocyclic group.

For example, CG^{PD1} and CG^{PD2} may each independently be a pyrrole group, a pyrazole group, an imidazole group, a triazole group, an oxazole group, an isoxazole group, a thiazole group, an isothiazole group, an oxadiazole group or a thiadiazole group, a benzene group, a pyridine group, a pyrimidine group, a naphthalene group, a dibenzofuran group, a dibenzothiophene group, a carbazole group, a fluorene group, a dibenzosilole group, a naphthobenzofuran group, a naphthobenzothiophene group, a benzocarbazole group, a benzofluorene group, a naphthobenzosilole group, a dinaphthofuran group, a dinaphthothiophene group, a dibenzocarbazole group, a dibenzofluorene group, a dinaphthosilole group, an azadibenzofuran group, an azadibenzothiophene group, an azacarbazole group, an azafluorene group, an azadibenzosilole group, an azanaphthobenzofuran group, an azanaphthobenzothiophene group, an azabenzocarbazole group, an azabenzofluorene group, an azanaphthobenzosilole group, an azadinaphthofuran group, an azadinaphthothiophene group, an azadibenzocarbazole group, an azadibenzofluorene group, or an azadinaphthosilole group.

In Chemical Formula LD1, L^{PD} may be a single bond, a substituted or unsubstituted methylene group, a substituted or unsubstituted ethylene group, *-O-*', *-S-*', *-C(=O)-*', *-N(R^{PD3})-*', *-C(R^{PD4})=*', or *=C(R^{PD5})-*'.

In Chemical Formula LD1, X^{PD3} and X^{PD4} may each independently be a chemical bond, O, S, N(R^{PD6}), B(R^{PD7}), P(R^{PD8}), C(R^{PD9})(R^{PD10}), or Si(R^{PD11})(R^{PD12}). The chemical bond may be, e.g., a covalent bond or a coordination bond.

In Chemical Formula LD1, R^{PD1} and R^{PD2} may each independently be hydrogen, deuterium, -F, -Cl, -Br, -I, -SF₅, -OH, -CN, -NO₂, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₆-C₆₀ aryloxy group, a substituted or unsubstituted C₆-C₆₀ arylthio group, a substituted or unsubstituted C₁-C₆₀ heteroaryloxy group, a substituted or unsubstituted C₁-C₆₀ heteroarylthio group, a substituted or unsubstituted C₈-C₆₀ condensed polycyclic group, a substituted or unsubstituted silyl group, a substituted or unsubstituted amine group, a substituted or unsubstituted aniline group, -B(R^{PD13})(R^{PD14}), -C(=O)(R^{PD15}), -S(-O)(R^{PD16}), - S(=O)₂(R^{PD16}), -P(R^{PD17})(R^{PD18}), or -P(=O)(R^{PD17})(R^{PD18}). The silyl group may be represented by -Si(R^{sa})(R^{sb})(R^{sc}) as explained herein.

R^{PD3} to R^{PD18} may each independently be hydrogen, deuterium, -F, -Cl, -Br, - I, -SF₅, -OH, -CN, -NO₂, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₆-C₆₀ aryloxy group, a substituted or unsubstituted C₆-C₆₀ arylthio group, a substituted or unsubstituted C₁-C₆₀ heteroaryloxy group, a substituted or unsubstituted C₁-C₆₀ heteroarylthio group, or a substituted or unsubstituted C₈-C₆₀ condensed polycyclic group.

In Chemical Formula LD1, cx1 and cx2 may each independently be an integer from 0 to 10. When at least one of cx1 and cx2 is 2 or more, two or more of R^{PD1} or two or more of R^{PD2} may be the same as or different from each other.

The symbols -* and -*' each represent a binding site where the ligand represented by Chemical Formula LD1 bonds to M.

In Chemical Formula PD, dx1 may be an integer from 1 to 3. When dx1 is 2 or 3, two or three of L_{d}¹ may be the same as or different from each other. Among two or three of L_{d}¹, CG^{PD1} and/or CG^{PD2} adjacent to each other may be connected to each other through a connecting group such as L^{PD1}, L^{PD2}, or the like. The connecting group such as L^{PD1}, L^{PD2}, or the like, may each independently be the same as defined herein in connection with L^{PD}.

In Chemical Formula PD, L_{d}² may be an organic ligand. L_{d}² may include, e.g., a halogen group, CO, NO, CS, picolinate, acetate, oxalate, a diketone group, an isonitrile group, isothiocyanato-N, thiosulphato-S, an alkyl phosphine, phenylphosphine, an aryl phosphine, phosphine oxide, phosphite, or a combination thereof.

In Chemical Formula PD, dx2 is an integer of 0 to 4. When dx2 is 2 or more, two or more of L_{d}² may be the same as or different from each other.

In some embodiments, the emission layer 130 may include a at least one of styryl derivative (e.g., 1,4-bis[2-(3-N-ethylcarbazoryl)vinyl]benzene (BCzVB), 4-(di-p-tolylamino)-4'-[(di-p-tolylamino)styryl]stilbene (DPAVB), N-(4-((E)-2-(6-((E)-4-(diphenylamino)styryl)naphthalen-2-yl)vinyl)phenyl)-N-phenylbenzenamine (NBDAVBi), etc.), 4,4'-bis[2-(4-(N,N-diphenylamino)phenyl)vinyl]biphenyl (DPAVBi), perylene or a derivative thereof (e.g., 2,5,8,11-tetra-t-butylperylene (TBP)), pyrene or a derivative thereof (e.g., 1,1-dipyrene, 1,4-dipyrenylbenzene, 1,4-bis(N,N-diphenylamino)pyrene), etc.), or the like, as a fluorescent dopant material.

The emission layer 130 may include a metal complex that includes iridium (Ir), platinum (Pt), osmium (Os), gold (Au), titanium (Ti), zirconium (Zr), hafnium (Hf), europium (Eu), terbium (Tb), or thulium (Tm) as a phosphorescent dopant, in addition to the materials described herein. For example, at least one of FIrpic (iridium(III) bis(4,6-difluorophenylpyridinato-N,C2')picolinate), FIr6 (bis(2,4-difluorophenylpyridinato)-tetrakis(1-pyrazolyl)borate iridium(III)), PtOEP (platinum octaethyl porphyrin), or the like, may be used as a phosphorescent dopant.

In some embodiments, the emission layer 130 may include two or more host materials. For example, the emission layer 130 may include a hole transporting host and an electron transporting host. In this case, the emission layer 130 may include a hole transporting host, an electron transporting host, a photosensitive agent, and a dopant. In example embodiments, the hole transporting host and the electron transporting host may form an exciplex, and energy may be transferred from the exciplex to the photosensitive agent and from the photosensitive agent to the dopant, thereby inducing a light emission.

In a non-limiting example, the hole transporting host may include a compound represented by Chemical Formula HT described herein. In a non-limiting example, the electron transporting host may include a compound represented by Chemical Formula ET described herein.

In some embodiments, the emission layer 130 may include quantum dots. A quantum dot may include a Group II-VI compound, a Group III-VI compound, a Group I-III-VI compound, a Group III-V group compound, a Group III-II-V group compound, a Group IV-VI compound, a Group IV element, a Group IV compound, or a combination thereof.

The quantum dot may include a core that includes the compound as described herein, and a shell surrounding the core. The shell may include an inorganic oxide or a semiconductor compound. Examples of the semiconductor compound may include CdS, CdSe, CdTe, ZnS, ZnSe, ZnTe, ZnSe, ZnTeS, GaAs, GaP, GaSb, HgS, HgSe, HgTe, InAs, InP, InGaP, InSb, AlAs, AlP, AlSb, or the like, or a combination thereof.

For example, a color of light from a quantum dot may be adjusted according to a particle size of the quantum dot. The quantum dot may be a blue quantum dot, a red quantum dot, or a green quantum dot.

The hole transfer region 120 may be formed between the first electrode 110 and the emission layer 130. The hole transfer region 120 may have a single-layered structure or a multi-layered structure including different materials.

The hole transfer region 120 may include a hole injection layer, a hole transport layer, and/or an electron blocking layer, and may further include an auxiliary emission layer.

In some embodiments, as illustrated in FIG. 2, the hole transfer region 120 may include a hole injection layer 122 and a hole transport layer 124, sequentially stacked from the first electrode 110.

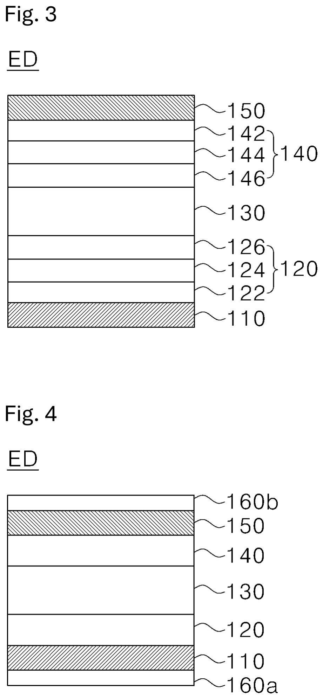

In some embodiments, as illustrated in FIG. 3, the hole transfer region 120 may include a hole injection layer 122, a hole transport layer 124, and an electron blocking layer 126, sequentially stacked from the first electrode 110. The electron blocking layer 126 may block electrons from the electron transfer region 140 to the hole transfer region 120. Accordingly, the generation of excitons in the emission layer 130 may be increased, and light-emission efficiency may be further increased.

For example, the hole transfer region 120 may include a compound represented by Chemical Formula HT, but embodiments are not limited thereto:

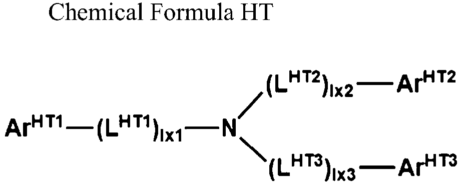

In Chemical Formula HT, L^{HT1}, L^{HT2}, and L^{HT3} may each independently be a direct linkage, a substituted or unsubstituted C₆-C₃₀ arylene group, or a substituted or unsubstituted C₁-C₃₀ heteroarylene group.

In Chemical Formula HT, lx1 to lx3 may each independently be an integer from 0 to 10. When 1x1, lx2, or lx3 is 2 or more, two or more of each of L^{HT1}, L^{HT2}, or L^{HT3}, respectively, may be directly connected by, e.g., carbon atoms (e.g., sp2 carbons) of each aryl ring, to form a substituted or unsubstituted C₆-C₃₀ arylene group, or a substituted or unsubstituted C₁-C₃₀ heteroarylene group.

In Chemical Formula HT, Ar^{HT1}, and Ar^{HT2} may each independently be a substituted or unsubstituted C₆-C₃₀ aryl group, or a substituted or unsubstituted C₁-C₃₀ heteroaryl group. Ar^{HT3} may be a substituted or unsubstituted C₆-C₃₀ aryl group.

In one or more embodiments, the compound represented by Chemical Formula HT may be a monoamine compound. In one or more embodiments, the compound represented by Chemical Formula HT may be a diamine compound in which at least one of Ar^{HT1} to Ar^{HT3} includes an amine group as a substituent.

In some embodiments, the compound represented by Chemical Formula HT may be a carbazole-containing compound in which at least one of Ar^{HT1} or Ar^{HT2} includes a substituted or unsubstituted carbazole group, or a fluorene-containing compound in which at least one of Ar^{HT1} and Ar^{HT2} includes a substituted or unsubstituted fluorene group.

In some embodiments, two adjacent groups among Ar^{HT1} to Ar^{HT3} may be condensed together to form a ring group.

For example, the hole transfer region 120 may include at least one of m-MTDATA (4,4',4"-[tris(3-methylphenyl)phenylamino] triphenylamine), TDATA (4,4'4"-tris(N,N- diphenylamino)triphenylamine), 2-TNATA (4,4',4"-tris[N(2-naphthyl)-N-phenylamino]-triphenylamine), NPB (N,N'-di(naphthalene-1-yl)-N,N'-diphenyl-benzidine), TPD (N,N'-bis(3-methylphenyl)-N,N'-diphenyl-[1,1'-biphenyl]-4,4'-diamine), Spiro-TPD, Spiro-NPB, DNTPD (N¹,N^{1'}-([1,1'-biphenyl]-4,4'-diyl)bis(N¹-phenyl-N⁴,N⁴-di-m-tolylbenzene-1,4-diamine), TAPC (4,4'-cyclohexylidene bis[N,N-bis(4-methylphenyl)benzenamine]), HMTPD (4,4'-bis[N,N'-(3-tolyl)amino]-3,3'-dimethylbiphenyl), TCTA (4,4',4"-tris(N-carbazolyl)triphenylamine), PANI/DBSA (polyaniline/dodecylbenzenesulfonic acid), PEDOT/PSS (poly(3,4-ethylenedioxythiophene)/poly(4-styrenesulfonate)), PANI/CSA(Polyaniline/Camphor sulfonicacid), PANI/PSS (polyaniline/poly(4-styrenesulfonate)), a phthalocyanine compound, a carbazole compound (N-phenylcarbazole, polyvinylcarbazole, or the like), a fluorene compound, or the like. The hole transfer region 120 may include one of the hole transfer materials described above, or a combination thereof.

The hole transfer materials described above may be included in at least one of the hole injection layer 122, the hole transport layer 124, and/or the electron blocking layer 126.

The hole transfer region 120 may further include a charge generating material. The charge generating material may be a dopant material such as a p-dopant, so that conductivity of the hole transfer region 120 may be improved.

Examples of dopant materials may include a halogenated metal compound such as LiF, NaCl, CsF, RbCl, RbI, CuI, KI, or the like; a quinone derivative such as TCNQ (tetracyanoquinodimethane), F4-TCNQ (2,3,5,6-tetrafluoro-7,7,8,8-tetracyanoquinodimethane), or the like; a cyano-containing compound such as HATCN (dipyrazino[2,3-f: 2',3'-h] quinoxaline-2,3,6,7,10,11-hexacarbonitrile), NDP9 (4-[[2,3-bis[cyano-(4-cyano-2,3,5,6-tetrafluorophenyl)methylidene]cyclopropylidene]-cyanomethyl]-2,3,5,6-tetrafluorobenzonitrile), or the like; a tungsten (W) oxide; a molybdenum (Mo) oxide; or the like. The hole transfer region 120 may include one of the dopant materials described above, or a combination thereof.

A thickness of the hole transfer region 120 may be about 100 Å to about 10,000 Å. For example, the thickness of the hole transfer region 120 may be about 100 Å to about 1,500 Å.

When the hole transfer region 120 includes the hole injection layer 122 or the hole transport layer 124, a thickness of the hole injection layer 122 may be from about 100 Å to about 9,000 Å, from about 100 Å to about 3,000 Å, or from about 100 Å to about 1,000 Å. A thickness of the hole transport layer 124 may be from 50 Å to about 2,000 Å, from about 100 Å to about 1,500 Å, from about 100 Å to about 1,000 Å, or from about 100 Å to about 600 Å.

In the thickness ranges described above, hole transfer properties may be enhanced even at a low voltage operation, and a life-span of the device may be further improved.

Each layer of the hole transfer region 120 may be formed by a process such as a vacuum deposition, a spin coating, an inkjet printing, a laser printing, a casting, a laser thermal transfer, or the like, but embodiments are not limited thereto.

The electron transfer region 140 is located between the second electrode 150 and the emission layer 130. The electron transfer region 140 may have a single-layered structure, or a multi-layered structure including different materials.

The electron transfer region 140 may include an electron injection layer, an electron transport layer, and/or a hole blocking layer, and may further include an auxiliary emission layer.

In embodiments, as illustrated in FIG. 2, the electron transfer region 140 may include an electron injection layer 142 and an electron transport layer 144, stacked from the second electrode 150 to the emission layer 130.

In some embodiments, as illustrated in FIG. 3, the electron transfer region 140 may include an electron injection layer 142, an electron transport layer 144, and a hole blocking layer 146, stacked from the second electrode 150 to the emission layer 130. The hole blocking layer 146 may block or suppress holes from the hole transfer region 120. Accordingly, emission energy and luminescence efficiency in the emission layer 130 may be further improved.

For example, the electron transfer region 140 may include a compound represented by Chemical Formula ET, but embodiments are not limited thereto:

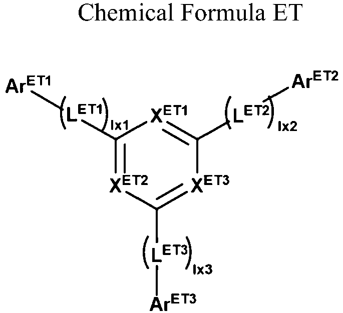

In Chemical Formula ET, at least one of X^{ET1} to X^{ET3} may be N; and the remainder of X^{ET1} to X^{ET3} may each independently be C(R^{ET}). R^{ET} may be a hydrogen atom, a deuterium atom, a substituted or unsubstituted C₁-C₂₀ alkyl group, a substituted or unsubstituted C₆-C₆₀ aryl group, or a substituted or unsubstituted C₁-C₆₀ heteroaryl group.

When one of X^{ET1} to X^{ET3} is N, the compound represented by Chemical Formula ET may include a pyridine group. When two of X^{ET1} to X^{ET3} are N, the compound represented by Chemical Formula ET may include a pyrimidine group. When X^{ET1} to X^{ET3} are each N, the compound represented by Chemical Formula ET may include a triazine group.

In Chemical Formula ET, lx1 to lx3 may each independently be an integer from 0 to 10. L^{ET1} to L^{ET3} may each independently be a direct linkage, a substituted or unsubstituted C₆-C₃₀ arylene group, or a substituted or unsubstituted C₁-C₃₀ heteroarylene group.

When lx1, lx2, or lx3 is 2 or more, two or more of each of L^{ET1}, L^{ET2}, or L^{ET3}, respectively, may be directly linked together, e.g., by carbon atoms of each aryl ring (e.g., sp2 carbons), to form a substituted or unsubstituted C₆-C₃₀ arylene group, or a substituted or unsubstituted C₁-C₃₀ heteroarylene group.

In Chemical Formula ET, Ar^{ET1} to Ar^{ET3} may each independently be a hydrogen atom, a deuterium atom, a substituted or unsubstituted C₁-C₂₀ alkyl group, a substituted or unsubstituted C₆-C₃₀ aryl group, or a substituted or unsubstituted C₁-C₃₀ heteroaryl group, or a substituted or unsubstituted silyl group. For example, Ar^{ET1} to Ar^{ET3} may each independently be a substituted or unsubstituted phenyl group, a substituted or unsubstituted carbazole group, a substituted or unsubstituted fluorene group, or a substituted or unsubstituted silyl group. The silyl group may be represented by - Si(R^{sa})(R^{sb})(R^{sc}), as explained herein.

For example, the electron transfer region 140 may include an anthracene compound, Alq₃ (tris(8-hydroxyquinolinato) aluminium), 1,3,5-tri[(3-pyridyl)-phen-3-yl] benzene, 2,4,6-tris (3'-(pyridin-3-yl)biphenyl-3-yl)-1,3,5-triazine, 2-(4-(N-phenylbenzoimidazol-1-yl)phenyl)-9,10-dinaphthylanthracene, TPBi (1,3,5-tri(1-phenyl-1H-benzo[d]imidazol-2-yl)benzene), BCP (2,9-dimethyl-4,7-diphenyl-1,10-phenanthroline), Bphen (4,7-diphenyl-1,10-phenanthroline), TAZ (3-(4-biphenylyl)-4-phenyl-5-tert-butylphenyl-1,2,4-triazole), NTAZ (4-(naphthalen-1-yl)-3,5-diphenyl-4H-1,2,4-triazole), tBu-PBD (2-(4-biphenylyl)-5-(4-tert-butylphenyl)-1,3,4-oxadiazole), BAlq (bis(2-methyl-8-quinolinolato-N1,O8)-(1,1'-biphenyl-4-olato)aluminium), Bebq₂ (beryllium bis(benzoquinolin-10-olate)), ADN (9,10-di(naphthalene-2-yl)anthracene), BmPyPhB (1,3-bis[3,5-di(pyridin-3-yl)phenyl]benzene), or the like. The electron transfer region 140 may include one of the electron transfer materials described above, or a combination thereof.

The above-mentioned materials may be included in at least one of the electron injection layer 142, the electron transport layer 144, and/or the hole blocking layer 146.

The electron transfer region 140 may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or a combination thereof. In one or more embodiments, the above-mentioned materials may be included in the electron injection layer 142.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may include an oxide, a halide (e.g., a fluoride, a chloride, a bromide, an iodide, etc.), a telluride, or a combination thereof of the alkali metal, the alkaline earth metal, and the rare earth metal, respectively.

The alkali metal complex, the alkaline earth metal complex, and the rare earth metal complex may include a metal ion such as an alkali metal ion, an alkaline earth metal ion or a rare earth metal ion, and a ligand bonded to the metal ion. The ligand may include, e.g., hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenylbenzimidazole, hydroxyphenylbenzothiazole, bipyridine, phenanthroline, cyclopentadiene, or a combination thereof.

A thickness of the electron transfer region 140 may be from about 100 Å to about 1,000 Å, e.g., from about 150 Å to about 500 Å.

When the electron transfer region 140 includes an electron injection layer 142 or an electron transport layer 144, a thickness of the electron injection layer 142 may be about 1 Å to about 100 Å, from 1 Å to about 90 Å or from about 5 Å to about 50 Å, and a thickness of the electron transport layer 144 may be from about 10 Å to about 900 Å, from about 10 Å to about 500 Å, or from about 100 Å to about 400 Å.

Within any of the thickness ranges described above, electron injection and electron transport properties may be further improved without an excessive increase in driving voltage, and stability of the electron transfer region 140 may be improved.

Each layer of the electron transfer region 140 may be formed by a process such as a vacuum deposition, a spin coating, an inkjet printing, a laser printing, a casting, a laser thermal transfer, or the like, but embodiments are not limited thereto.

The light-emitting device ED may further include a capping layer. Light emission efficiency to outside of the light-emitting device ED may be improved through the capping layer.

As illustrated in FIG. 4, a second capping layer 160b may be formed on an outer surface of the second electrode 150. In some embodiments, a first capping layer 160a may be formed on an outer surface of the first electrode 110.

A refractive index of the first capping layer 160a and/or the second capping layer 160b may be about 1.6 or more. For example, the refractive index of the first capping layer 160a and/or the second capping layer 160b may be about 1.6 or more, about 1.8 or more, or about 2.0 or more for a light in a wavelength range of 550 nanometers (nm) to 660 nm.

The first capping layer 160a and the second capping layer 160b may each be formed as an organic capping layer including an organic material, an inorganic capping layer including an inorganic material, or an organic-inorganic hybrid capping layer including both the organic and inorganic materials.

The first capping layer 160a and/or the second capping layer 160b may each have a single-layered structure or a multi-layered structure including different materials.

In some embodiments, the first capping layer 160a and the second capping layer 160b may each independently include a carbocyclic compound, a heterocyclic compound, an amine group-containing compound, a porphine derivative, a phthalocyanine derivative, a naphthalocyanine derivative, an alkaline metal complex, an alkaline earth metal complex, or the like. The first capping layer 160a and the second capping layer 160b may each independently include one of the aforementioned materials, or a combination thereof.

In one or more embodiments, the first capping layer 160a and/or the second capping layer 160b may each independently include an amine group-containing compound.

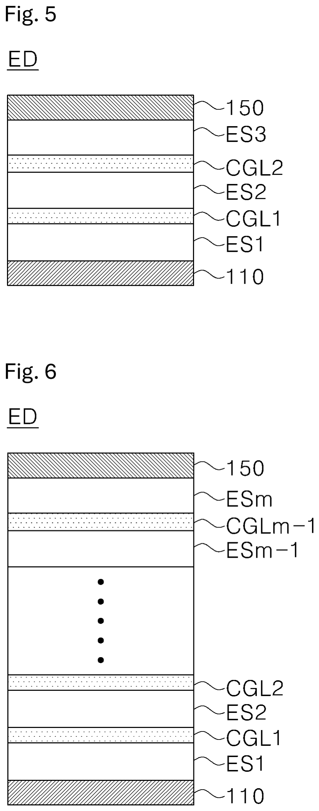

Referring to FIG. 5, the light-emitting device ED may include a plurality of light-emitting structures (e.g., the light-emitting structures ES1, ES2, and ES3). The light-emitting structures ES1, ES2, and ES3 may each include a stacked structure of the hole transfer region 120, the emission layer 130, and the electron transfer region 140, as described with reference to FIGS. 1 to 4. In example embodiments, the light-emitting device ED of FIG. 5 may be a light-emitting device having a tandem structure.

Charge generation layers CGL1 and CGL2 may each be disposed between adjacent structures among the light-emitting structures ES1, ES2, and ES3. Charge generation layers CGL1 and CGL2 may each independently include a p-type charge generation layer and/or an n-type charge generation layer.

The p-type charge generation layer may include a hole transport host compound, such as NPB. For example, the p-type charge generation layer may include a compound represented by Chemical Formula HT as described herein. The p-type charge generation layer may further include a p-type dopant, such as TCNQ, but embodiments are not limited thereto.

The n-type charge generation layer may include an electron transport host compound. For example, the n-type charge generation layer may include a compound represented by Chemical Formula ET as described herein. In one or more embodiments, the n-type charge generation layer may include a phenanthroline-containing compound.

The charge generation layers CGL1 and CGL2 may include a first charge generation layer CGL1 disposed between the first light-emitting structure ES1 and the second light-emitting structure ES2, and a second charge generation layer CGL2 disposed between the second light-emitting structure ES2 and the third-light emitting structure ES3.

In example embodiments, the first light-emitting structure ES1, the first charge generation layer CGL1, the second light-emitting structure ES2, the second charge generation layer CGL2, the third light-emitting structure ES3, and the second electrode 150 may be sequentially stacked on a top surface of the first electrode 110.

Colors emitted from the first light-emitting structure ES1, the second light-emitting structure ES2, and the third light-emitting structure ES3 may be the same or different from each other. In some embodiments, the first light-emitting structure ES1, the second light-emitting structure ES2, and the third light-emitting structure ES3 may include a red light-emitting layer, a green light-emitting layer, and a blue light-emitting layer, respectively, and a white light-emitting structure may be implemented through the tandem structure, but embodiments are not limited thereto.

In FIG. 5, the 3-stack tandem structure in which three light-emitting structures are stacked is illustrated as an example, but the tandem structure of the light-emitting device of the present disclosure is not limited to the structure illustrated in FIG. 5. For example, a 2-stack structure, or a 4-stack structure, a 5-stack structure, or more stacked structures as will be described with reference FIG. 6 may also be implemented.

Referring to FIG. 6, as described with reference to FIG. 5, a tandem structure in which the light-emitting structure and a charge generation layer are alternately and repeatedly stacked may be disposed between the first electrode 110 and the second electrode 150.

In example embodiments, first to mth light-emitting structures ES1 to ESm may be sequentially stacked from the top surface of the first electrode 110 with the charge generation layers interposed therebetween. The charge generation layers may include a first charge generation layer CGL1 to an (m-1)th charge generation layer CGLm-1, which are sequentially stacked from the top surface of the first electrode 110.

As illustrated in FIG. 6, the first light-emitting structure ES1, the first charge generation layer CGL1, the second light-emitting structure ES2, the second charge generation layer CGL2, ... , an (m-1)th light-emitting structure ESm-1, an (m-1)th charge generation layer CGLm-1, an mth light-emitting structure ESm, and the second electrode 150 may be sequentially stacked from the top surface of the first electrode 110.

In some embodiments, m is 4, and the intermediate layer ITL of the light-emitting device may have a 4-stack tandem structure, and may include first to fourth light-emitting structures ES1, ES2, ES3, and ES4, and first to third charge generation layers CGL1, CGL2, and CGL3. Colors of light generated from the first to fourth light-emitting structures ES1, ES2, ES3, and ES4 may be the same or different from each other.

In one or more embodiments, the first to fourth light emitting structures ES1, ES2, ES3, and ES4 may include at least one blue light-emitting structure and at least one green-light emitting structure. In a non-limiting example, the first to third light emitting structures ES1, ES2, and ES3 may correspond to the blue light-emitting structure, and the fourth light emitting structure ES4 may correspond to the green-light emitting structure.

In some embodiments, m is 5, and the intermediate layer ITL of the light-emitting device may have a 5-stack tandem structure, and may include first to fifth light-emitting structures ES1, ES2, ES3, ES4, and ES5, and first to fourth charge generation layers CGL1, CGL2, CGL3, and CGL4. Colors of light generated from the first to fifth light-emitting structures ES1, ES2, ES3, ES4, and ES5 may be the same or different from each other.

In one or more embodiments, the first to fifth light-emitting structures ES1, ES2, ES3, ES4, and ES5 may include at least one blue light emitting structure and at least one green light emitting structure. In a non-limiting example, the first to fifth light-emitting structures ES1, ES2, ES3, ES4, and ES5 may include three blue light-emitting structures and two green light-emitting structures. For example, the first, third, and fifth light-emitting structures ES1, ES3, and ES5 may correspond to the blue light-emitting structures, and the second and fourth light-emitting structures ES2 and ES4 may correspond to the green light-emitting structures.

### Electronic Device

The above-described light-emitting device ED may be applied to an electronic device and may be provided as a light-emitting portion or a light-emitting unit of the electronic device.

Examples of an electronic device may include a display device, a billboard, a signboard, a light source, a lighting device, a personal computer such as a laptop computer or a desktop computer, a mobile phone, an electronic book, an electronic dictionary, an electronic notebook, a health-care device including a diagnostic device and various sensors, various display parts for transportation means (automobile, aircraft, ship, train, or the like), but embodiments are not limited thereto.

In example embodiments, the light-emitting device ED may be applied to an organic light emitting diode (OLED) display device or a quantum dot (QD)-OLED display device.

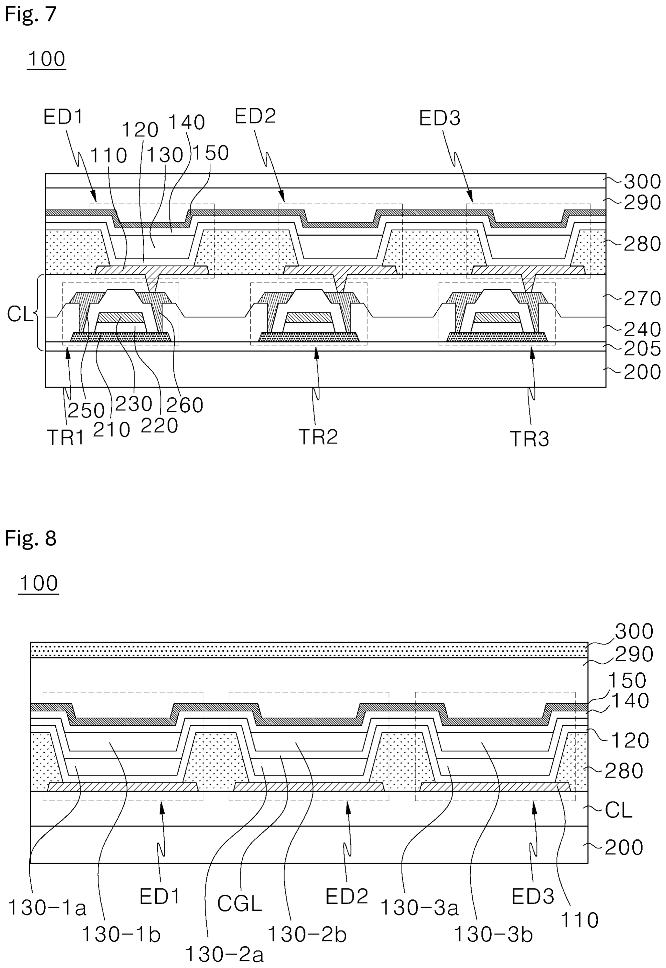

FIG. 7 is a schematic cross-sectional view illustrating a display device in accordance with example embodiments.

Referring to FIG. 7, the display device 100 may include a circuit layer CL disposed on a base substrate 200, and light-emitting devices ED1, ED2, and ED3 disposed on the circuit layer CL.

The base substrate 200 may serve as a supporting substrate or as a back-plane substrate of a display device. The base substrate 200 may be a glass substrate or a plastic substrate.

In some embodiments, the base substrate 200 may include a polymer material having transparent and flexible properties. When the base substrate 200 includes a polymer material, the base substrate 200 may be used in a transparent flexible display device. For example, the base substrate 200 may include a polymer material such as polyimide, polysiloxane, an epoxy resin, an acrylic resin, polyester, or the like. In one or more embodiments, the base substrate 200 may include polyimide.

The circuit layer CL may include transistors TR1, TR2, and TR3. The circuit layer CL may include wiring layers and insulating layers that form a thin film transistor array (TFT-Array).

The circuit layer CL may further include a buffer layer 205 on a top surface of the base substrate 200. The buffer layer 205 may block the penetration of moisture through the base substrate 200, and may also block the diffusion of impurities between the base substrate 200 and the structures formed thereon.

The buffer layer 205 may include, e.g., silicon oxide, silicon nitride, or silicon oxynitride. The buffer layer 205 may include one of the aforementioned materials, or a combination thereof. In some embodiments, the buffer layer 205 may have a stacked structure that includes a silicon oxide layer and a silicon nitride layer.

The transistors TR1, TR2, and TR3 may be disposed on the buffer layer 205. A first transistor TR1, a second transistor TR2, and a third transistor TR3 may be electrically connected to a first light-emitting device ED1, a second light-emitting device ED2, and a third light-emitting device ED3, respectively.

The transistors TR1, TR2, and TR3 may each include an active layer 210, a gate insulation layer 220, and a gate electrode 230.

The active layer 210 may be disposed on the buffer layer 205, and may be patterned for each pixel. The active layer 210 may include a silicon compound such as amorphous silicon or polysilicon. A p-type dopant or an n-type dopant may be doped in a region of the active layer 210, and the active layer 210 may include a source region, a drain region, and a channel region.

The active layer 210 may include an oxide semiconductor, such as indium gallium zinc oxide (IGZO), zinc tin oxide (ZTO), or indium tin zinc oxide (ITZO).

The gate insulation layer 220 may be formed on the active layer 210, and the gate electrode 230 may be stacked on the gate insulation layer 220. As illustrated in FIG. 7, the gate insulation layer 220 may be patterned to partially cover each active layer 210. Alternatively, the gate insulation layer 220 may extend continuously over multiple pixels or light-emitting regions, and may be provided as a common layer for the first, second, and third transistors TR1, TR2, and TR3.

The gate electrode 230 may overlap the channel region of the active layer 210 in a thickness direction.

An insulating interlayer 240 may be formed on the active layer 210 to cover the gate electrode 230 and the gate insulation layer 220. Connection electrodes 250 and 260 which may be in contact with or electrically connected to the active layer 210 may each be disposed on the insulating interlayer 240.

The connection electrodes 250 and 260 may extend through the insulating interlayer 240 to be in contact with or electrically connected to the active layer 210. When the gate insulation layer 220 is provided as a common layer for multiple light-emitting regions, the connection electrodes 250 and 260 may also extend through the gate insulation layer 220.

The connection electrodes 250 and 260 may include a source electrode 250 that may be in contact with or connected to the source region of the active layer 210, and a drain electrode 260 that may be in contact with or connected to the drain region of the active layer 210.

The gate insulation layer 220 and the insulating interlayer 240 may each independently include silicon oxide, silicon nitride, or silicon oxynitride, and may each have a stacked structure that includes a silicon oxide layer and a silicon nitride layer.

The gate electrode 230 and the connection electrodes 250 and 260 may include a metal such as Ag, Mg, Al, W, Cu, Ni, Cr, Mo, Ti, Pt, Ta, Nd, Sc, an alloy thereof, a nitride thereof, or a combination thereof.

A via insulation layer 270 may be formed on the insulating interlayer 240 to cover the connection electrodes 250 and 260.

The via insulation layer 270 may accommodate a via structure electrically connecting the first electrode 110 and the drain electrode 260. The via insulation layer 270 may serve as a planarization layer of the circuit layer CL. In some embodiments, the via insulation layer 270 may include an organic material such as polyimide, an epoxy resin, an acrylic resin, polyester, or the like.

The light-emitting devices ED1, ED2, and ED3 may be disposed on the via insulation layer 270. For example, as described with reference to FIGS. 1 to 4, the light-emitting devices ED1, ED2, and ED3 may include the first electrode 110, the hole transfer region 120, the emission layer 130, the electron transfer region 140, and the second electrode 150 which are sequentially stacked from the via insulation layer 270.

The first electrode 110 may be electrically connected to the transistors TR1, TR2, and TR3, or the connection electrodes 250 and 260 in the circuit layer CL through the via structure. As illustrated in FIG. 7, the first electrode 110 may be in contact with or connected to the drain electrode 260 to serve as a pixel electrode patterned for each light-emitting region or pixel.

A pixel defining layer 280 may be formed on the via insulation layer 270 to define each light-emitting region or pixel. A red light-emitting region, a green light-emitting region, and a blue light-emitting region may be separated and defined by the pixel defining layer 280, and the light-emitting devices ED1, ED2, and ED3 may respectively correspond to a red light-emitting device, a green light-emitting device, and a blue light-emitting device.

The pixel defining layer 280 may partially cover the first electrode 110 of each light-emitting region.

As illustrated in FIG. 7, the hole transfer region 120 and the electron transfer region 140 may each be provided as a common layer that continuously extends over the pixel defining layer 280 and the first electrodes 110. The emission layer 130 may be formed within each light emitting-region or pixel, and may be separated by the pixel defining layer 280.

In some embodiments, the emission layer 130 may also be provided as a common layer that continuously extends over the light emitting-regions or pixels. In some embodiments, the hole transfer region 120, the emission layer 130, and the electron transfer region 140 may each be patterned and separately formed for each light-emitting region or pixel.

The second electrode 150 may be provided as a common electrode that continuously extends over the light-emitting regions or the pixels.

An encapsulation layer 290 may be disposed on the pixel defining layer 280 and the light-emitting devices ED1, ED2, and ED3 to protect the light-emitting devices ED1, ED2, and ED3 from moisture and/or oxygen. The encapsulation layer 290 may be a thin film encapsulation (TFE) having a single-layered structure or multi-layered structure.

The encapsulation layer 290 may include an inorganic layer that includes silicon nitride (SiNₓ), silicon oxide (SiOₓ), indium tin oxide, indium zinc oxide, or any combination thereof; an organic layer that includes polyethylene terephthalate, polyethylene naphthalate, polycarbonate, polyimide, polyethylene sulfonate, polyoxymethylene, polyarylate, hexamethyldisiloxane, an acrylic resin (e.g., polymethylmethacrylate, polyacrylic acid, etc.), an epoxy resin (e.g., an aliphatic glycidyl ether (AGE)), or any combination thereof; or a combination of the inorganic layer and the organic layer.

The display device may further include a functional layer 300 disposed on the encapsulation layer 290. The functional layer 300 may include a sensor layer such as a touch sensor layer, an optical layer such as a polarizing layer, a color conversion layer, a color filter layer, a window film, or any combination thereof.

FIG. 8 is a schematic cross-sectional view illustrating a display device 100 in accordance with example embodiments.

Referring to FIG. 8, each of the light-emitting devices ED1, ED2, and ED3 may have a tandem structure, e.g., a 2-stack tandem structure.

In some embodiments, the hole transfer region 120 and the electron transfer region 140 may be continuously and commonly formed and included in an intermediate layer of each light-emitting structure. Additionally, a charge generation layer CGL may continuously extend across a plurality of pixels and may be commonly included in the intermediate layer of each light-emitting structure.

The first light-emitting device ED1 may include a first lower emission layer 130-1a disposed between the hole transfer region 120 and the charge generation layer CGL, and a first upper emission layer 130-1b disposed between the charge generation layer CGL and the electron transfer region 140.

The second light-emitting device ED2 may include a second lower emission layer 130-2a disposed between the hole transfer region 120 and the charge generation layer CGL, and a second upper emission layer 130-2b disposed between the charge generation layer CGL and the electron transfer region 140.

The third light-emitting device ED3 may include a third lower emission layer 130-3a disposed between the hole transfer region 120 and the charge generation layer CGL, and a third upper emission layer 130-3b disposed between the charge generation layer CGL and the electron transfer region 140.

The lower and upper emission layers included in each light-emitting structure may generate light of the same color. In one or more embodiments, each of the first lower emission layer 130-1a and the first upper emission layer 130-1b included in the first light-emitting device ED1 may correspond to a red emission layer. Each of the second lower emission layer 130-2a and the second upper emission layer 130-2b included in the second light-emitting device ED2 may correspond to a green emission layer. Each of the third lower emission layer 130-3a and the third upper emission layer 130-3b included in the third light-emitting device ED3 may correspond to a blue emission layer.

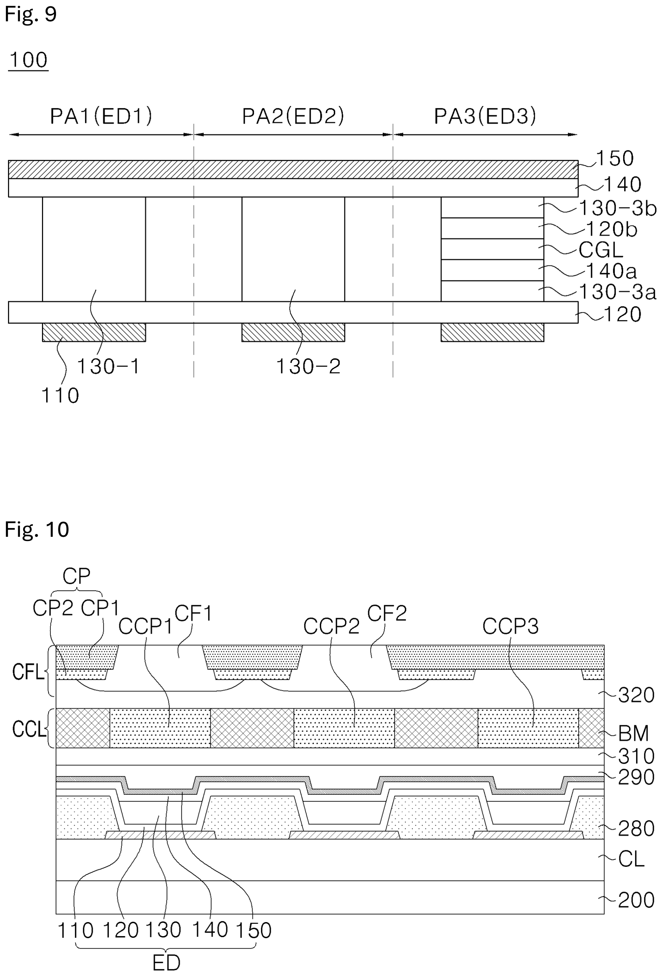

FIG. 9 is a schematic cross-sectional view illustrating a stack construction of light-emitting structure in a display device 100 in accordance with example embodiments. For convenience of illustration and description, illustrations of the circuit layer, the base substrate, the pixel defining layer, etc., are omitted from FIG. 9, and a shape of each layer or element in the light-emitting structure is briefly shown as a rectangle.

Referring to FIG. 9, at least one of the light-emitting devices ED1, ED2, or ED3 or pixel areas PA1, PA2, and PA3 may have a tandem structure including a plurality of emission layers, and at least one of the remainder may have a single emission layer structure.

In some embodiments, one of the light-emitting devices ED1, ED2, or ED3 or the pixel areas PA1, PA2, or PA3 may have a tandem structure, and the remainder may have a single emission layer structure.

As illustrated in FIG. 9, the first light-emitting device ED1, the second light-emitting device ED2, and the third light-emitting device ED3 may be included in the first pixel area PA1, the second pixel area PA2, and the third pixel area PA3, respectively. In some embodiments, the first pixel area PA1, the second pixel area PA2, and the third pixel area PA3 may correspond to a red pixel area, a green pixel area, and a blue pixel area, respectively.

The hole transfer region 120, the electron transfer region 140, and the second electrode 150 may each be provided as a common layer continuously extending over the first pixel area PA1, the second pixel area PA2, and the third pixel area PA3.

The first-light emitting device ED1 included in the first pixel area PA1 may include a first emission layer 130-1, and the second light-emitting device ED2 included in the second pixel area PA2 may include a second emission layer 130-2. Each of the first emission layer 130-1 and the second emission layer 130-2 may be a single-layered emission layer.

The third light-emitting device ED3 included in the third pixel area PA3 may have, e.g., a 2-stack tandem structure. The third light-emitting device ED3 may include a third lower emission layer 130-3a and a third upper emission layer 130-3b separated with the charge generation layer CGL interposed therebetween. Each of the third lower emission layer 130-3a and the third upper emission layer 130-3b may correspond to a blue emission layer.

A lower electron transfer region 140a may be disposed between the charge generation layer CGL and the third lower emission layer 130-3a. An upper hole transfer region 120b may be disposed between the charge generation layer CGL and the third upper emission layer 130-3b.

Accordingly, a tandem light-emitting structure in which the first electrode 110, the hole transfer region 120, the third lower emission layer 130-3a, the lower electron transfer region 140a, the charge generation layer CGL, the upper hole transfer region 120b, the third upper emission layer 130-3b, the electron transfer region 140, and the second electrode 150 are sequentially stacked may be disposed in the third pixel area PA3.

FIG. 10 is a schematic cross-sectional view illustrating a display device in accordance with example embodiments.

FIG. 10 illustrates a display device 100 having a QD-OLED structure according to one or more embodiments. Detailed descriptions regarding elements and structures that are the same as or substantially similar to those described with reference to FIG. 7 will not be repeated here.

Referring to FIG. 10, the pixel defining layer 280 and the light-emitting device ED may be disposed on the circuit layer CL, as described above with reference to FIG. 7. In example embodiments, each pixel may emit light of the same wavelength region. In one or more embodiments, each light-emitting device ED may emit a blue light.

In some embodiments, each light-emitting region may include the light-emitting device having the tandem structure, as described above with respect to FIG. 5. In this case, the intermediate layer ITL of each light-emitting device ED may be provided as a common layer that continuously extends over a plurality of the light-emitting regions.

A color control layer CCL may be disposed on the encapsulation layer 290, and the color control layer CCL may include color control portions CCP1, CCP2, and CCP3.

The color control portions CCP1, CCP2, and CCP3 may each include a light transformer such as a quantum dot or a phosphor. In each of the color control portions CCP1, CCP2, and CCP3, the light transformer may convert a wavelength of a provided light and emit a resulting light.

The color control portions CCP1, CCP2, and CCP3 may be separated or spaced apart from each other by a bank BM. The bank BM may substantially overlap the pixel defining layer 280, and the color control portions CCP1, CCP2, and CCP3 may substantially overlap each of the emission layers 130.

The color control layer CCL may include a first color control portion CCP1 including a first quantum dot that converts a first color light provided from the light-emitting device ED into a second color light, a second color control portion CCP2 including a second quantum dot that converts the first color light into a third color light, and a third color control portion CCP3 that transmits the first color light.

In some embodiments, the first color light, the second color light, and the third color light may be a blue light, a red light, and a green light, respectively. The first quantum dot and the second quantum dot may respectively be a red quantum dot and a green quantum dot.

The color control portions CCP1, CCP2, and CCP3 may each further include a scattering material such as inorganic particles. The third color control portion CCP3 may not include quantum dots and may include the scattering material. The scattering material may include TiO₂, ZnO, Al₂O₃, SiO₂, hollow silica, or the like. The scattering material may be one of the aforementioned materials or a combination thereof.

The color control portions CCP1, CCP2, and CCP3 may each further include a binder resin that disperses the quantum dot and the scattering material. The binder resin may include an acrylic resin, a urethane resin, a silicone resin, an epoxy resin, or the like, but embodiments are not limited thereto.

A color filter layer CFL that includes color filters CF1 and CF2, and a light-shielding portion CP may be disposed on the color control layer CCL.

The color filter layer CFL may include a first filter CF1 that transmits the second color light, a second filter CF2 that transmits the third color light, and a third filter that transmits the first color light. For example, the first filter CF1 may be a red filter, the second filter CF2 may be a green filter, and the third filter may be a blue filter.

The color filters CF1 and CF2 may each include a photosensitive binder resin and a colorant including a pigment and/or a dye. The first filter CF1 may include a red pigment or dye, and the second filter CF2 may include a green pigment or dye.

The light-shielding portion CP may be disposed between the color filters. In some embodiments, the light-shielding portion may include a first light-shielding portion CP1 and a second light-shielding portion CP2 that includes colorants of different colors.

In some embodiments, the first light-shielding portion CP1 may include a blue colorant, and the second light-shielding portion CP2 may include a red colorant or a black colorant. In one or more embodiments, in the blue light-emitting region, a portion of the first light-shielding portion CP1 may be provided as a blue color filter and may be exposed between the second light-shielding portions CP2, so that an additional color filter (e.g., the third filter) may be omitted.

A first barrier layer 310 may be disposed between the color control layer CCL and the light-emitting device ED (or the encapsulation layer 290). A second barrier layer 320 may be disposed between the color control layer CCL and the color filter layer CFL.

The barrier layers 310 and 320 may each include at least one inorganic layer. For example, the barrier layers 310 and 320 may each independently include silicon nitride, aluminium nitride, zirconium nitride, titanium nitride, hafnium nitride, tantalum nitride, silicon oxide, aluminium oxide, titanium oxide, tin oxide, cerium oxide, silicon oxynitride, or the like, or a combination thereof.

In one or more embodiments, the barrier layers 310 and 320 may each have a multi-layered structure that further includes an organic layer.

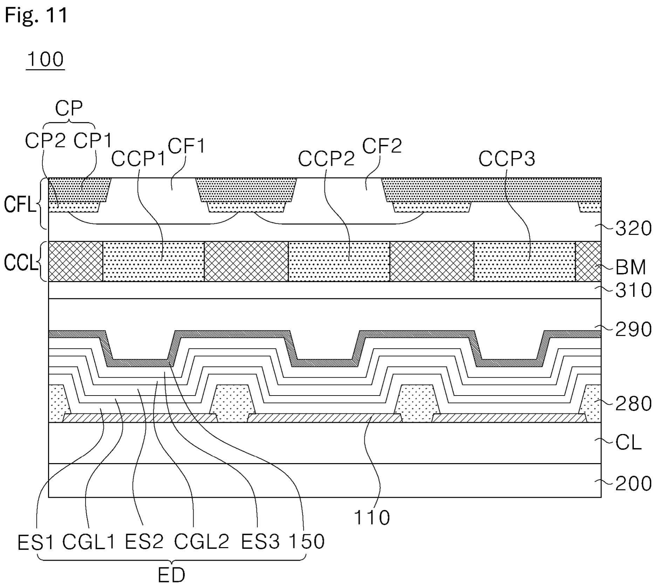

FIG. 11 is a schematic cross-sectional view illustrating a display device 100 in accordance with example embodiments. Detailed descriptions of elements and structures substantially the same as or similar to those described with reference to FIG. 10 are omitted herein.

Referring to FIG. 11, the light-emitting device ED corresponding to the color control portions CCP1, CCP2, and CCP3 may be disposed on the first electrode 110 serving as the pixel electrode, and the light-emitting device ED may have a tandem structure.

In some embodiments, as described with reference to FIG. 5, the first light-emitting structure ES1, the first charge generation layer CGL1, the second light-emitting structure ES2, the second charge generation layer CGL2, and the third light-emitting structure ES3 may be sequentially stacked between the first electrode 110 and the second electrode 150. The first light-emitting structure ES1, the first charge generation layer CGL1, the second light-emitting structure ES2, the second charge generation layer CGL2, and the third light-emitting structure ES3 may be continuously and commonly formed in a plurality of pixel areas or light-emitting regions.

In one or more embodiments, the first light-emitting structure ES1, the second light-emitting structure ES2, and the third light-emitting structure ES3 may generate different color light, and the light-emitting device ED may generate a white light. In one or more embodiments, the first light-emitting structure ES1, the second light-emitting structure ES2, and the third light-emitting structure ES3 may all generate a blue light.

In some embodiments, as described with reference to FIG. 6, the light-emitting device ED may include a tandem structure of 4-stack, 5-stack, or more of the stacked number.

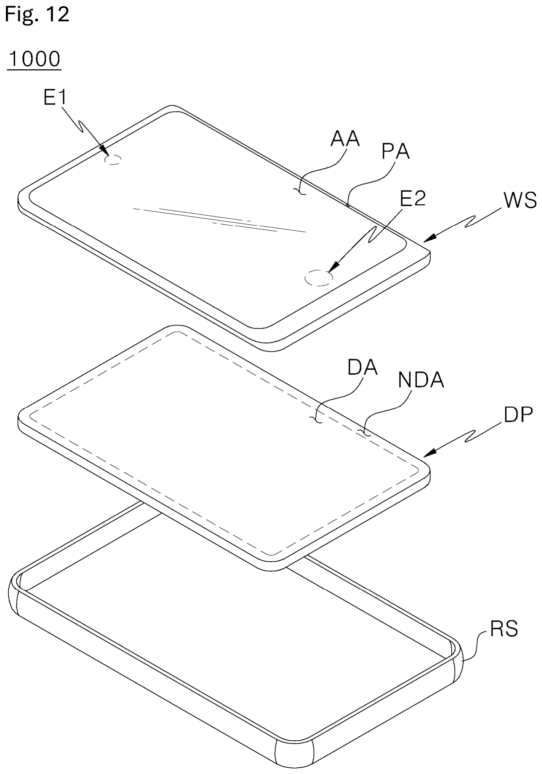

FIG. 12 is a schematic exploded perspective view illustrating an electronic device 1000 in accordance with example embodiments.

According to example embodiments, the electronic device 1000 may be implemented in the form of a mobile phone (smart phone), a tablet, a PC, or the like, including the above-described display device.

Referring to FIG. 12, the electronic device 1000 may include a window structure WS, a display panel DP, and a rear structure RS.

The window structure WS may provide an external display surface recognized by a user, such as a viewing surface of a mobile phone, and may include a transparent material film. For example, the window structure WS may include glass (e.g., ultra-thin glass (UTG)), a hard coating film, a plastic film, or the like.

An outer surface of the window structure WS may include an active area AA and a peripheral area PA. The active area AA may provide a surface from which an image of the display device is substantially displayed and to which a user's touch/command is input. The peripheral area PA may substantially correspond to a bezel area of the display device.

The display panel DP may include the above-described display device and may have a display area DA and a non-display area NDA. The display area DA of the display panel DP may substantially correspond to or overlap the active area AA of the window structure WS. The non-display area NDA of the display panel DP may substantially correspond to or overlap the peripheral area PA of the window structure WS.

In some embodiments, functional device areas E1 and E2 may be included in the active area AA of the window structure WS. For example, a first functional device area E1 may be included at one end portion of the active area AA and may be implemented, e.g., in the form of a camera hole. The second functional device area E2 may serve as a fingerprint sensing area.

For example, a sensor structure for touch sensing or fingerprint sensing may be disposed in the display panel DP or between the window structure WS and the display panel DP.

The rear structure RS may serve as a frame structure or a housing of the display device or the electronic device. A cover panel may be disposed between the rear structure RS and the display panel DP.

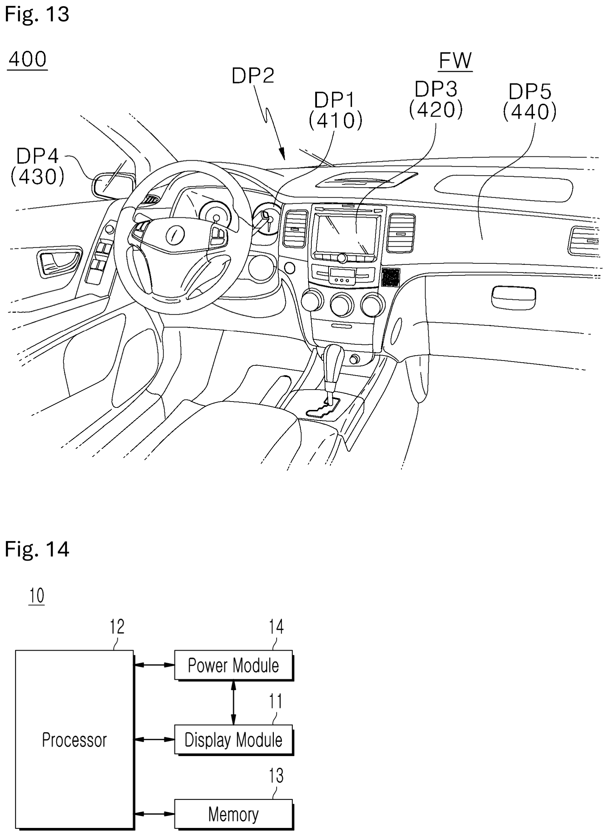

FIG. 13 is a schematic cross-sectional view illustrating an electronic device in accordance with an example embodiment.

The electronic device may be installed in, embedded in, attached to, or integrated with a vehicle 400. However, the vehicle 400 is not limited to the embodiment illustrated in FIG. 13. Further examples of the vehicle 400 may include a transportation means such as a three-wheeled or four-wheeled vehicle, a construction machine, a two-wheeled vehicle, a motor vehicle, a bicycle, a train, or the like. Other examples of the vehicle 400 may include an electric vehicle, a hybrid vehicle, or the like.

Referring to FIG. 13, at least one of first to fifth display devices DP1, DP2, DP3, DP4, and DP5 may be applied to the vehicle 400.

In example embodiments, the first display device DP1 may be disposed in a cluster area 410. Driving information such as a driving distance and speed, and various warning lights may be displayed in the cluster area 410.

The second display device DP2 may be disposed on a front window FW of the vehicle 400. For example, the second display device DP2 may be installed as a head-up display (HUD).

The third display device DP3 may be disposed on a center fascia 420 of the vehicle 400. In the center fascia 420, a button or a switch for controlling an image display or a music player, an air conditioner, a heater, or the like, may be displayed, and vehicle information may be displayed thereon.

The fourth display device DP4 may be applied to side mirrors 430 of the vehicle 400. A side mirror 430 may be installed at each of both sides of an exterior and/or an interior of the vehicle 400, and the fourth display device DP4 may be applied to at least one of the side mirrors 430 installed at each of the both sides.

The fifth display device DP5 may be disposed on a passenger seat dashboard 440. Information/images identical to or different from information/images displayed on the cluster area 410 and/or the center fascia 420 may be displayed at the passenger seat dashboard 440.

The display device according to the embodiments of the present disclosure may be applied to various electronic devices. The electronic device according to one or more embodiments includes the above-described display device, and may further include a module or device having another additional function in addition to the display device.

FIG. 14 is a block diagram of an electronic device in accordance with one or more embodiments.

Referring to FIG. 14, an electronic device 10 according to one or more embodiments may include a display module 11, a processor 12, a memory 13 and a power module 14.

The display module 11 may include the above-described display device.

The processor 12 may include a central processing unit (CPU), an application processor (AP), a graphic processing unit (GPU), a communication processor (CP), an image signal processor (ISP), and/or a controller.

Data information for an operation of the processor 12 or the display module 11 may be stored in the memory 13. When the processor 12 executes an application stored in the memory 13, an image data signal and/or an input control signal may be transmitted to the display module 11, and the display module 11 may process the received signal and output image information through a display screen.

The power module 14 may include a power supply module such as a power adapter or a battery device, and a power conversion module that converts a power supplied by the power supply module to a generate power required for the operation of the electronic device 10.

At least one of components of the electronic device 10 as described above may be included in the display device according to the above-described embodiments. Additionally, some of individual modules functionally included in one module may be included in the display device, and others may be provided separately from the display device. For example, the display module 11 may include the display device, and the processor 12, the memory 13, and the power module 14 may be provided in the form of another device in the electronic device 10 different from the display device.

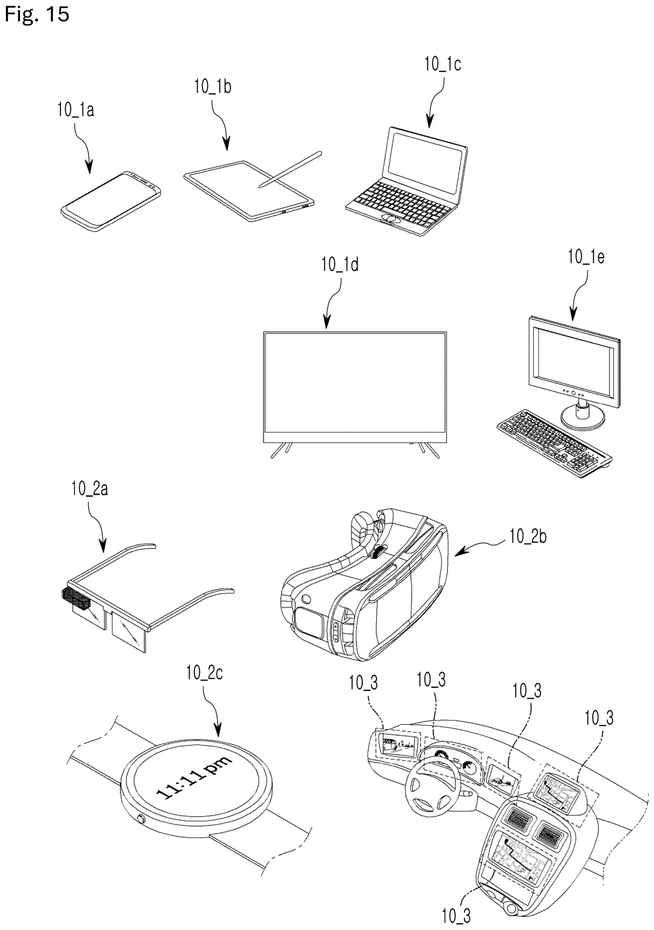

FIG. 15 shows schematic diagrams of electronic devices in accordance with various embodiments.

Referring to FIG. 15, non-limiting examples of various electronic devices to which the display device according to the above-described embodiments may be applied include an electronic device for displaying an image such as a smartphone 10_1a, a tablet PC 10_1b, a laptop 10_1c, a TV 10_1d, a desk monitor 10_1e, or the like; a wearable electronic device including a display module such as smart glasses 10_2a, a head mounted display 10_2b, a smart watch 10_2c, or the like; a vehicle electronic device 10_3 including a display module such as a center information display (CID) disposed at a vehicle instrument panel, a center fascia, a dashboard, or the like, a room mirror display, a head-up display, or the like. The electronic device may include a virtual reality glass or an augmented reality glass.

The electronic device may include, e.g., a flat panel display, a curved display, a computer monitor, a medical monitor, a television, a billboard, a light for indoor or outdoor lighting, a signal light, a head-up display, a full or partial transparent display, a flexible display, a rollable display, a foldable display, a stretchable display, a laser printer, a phone, a mobile phone, a tablet, a phablet, a personal digital assistant (PDA), a wearable device, a laptop computer, a digital camera, a camcorder, a viewfinder, a micro display, a 3D display, a virtual reality or augmented reality display, a vehicle, a video wall including multiple displays tiled together, a theater or stadium screen, a phototherapy device, or a signage.

Hereinafter, experimental examples will be described in further detail with reference to Examples and Comparative Examples. The Examples are provided to assist in understanding the disclosure, but they are provided as non-limiting examples, and the scope of the disclosure is not limited thereto. It will be clear to those skilled in the art that various changes and modifications to disclosed examples can be made within the scope of the disclosure.

### EXAMPLES

### Synthesis Example 1: Synthesis of Compound 13

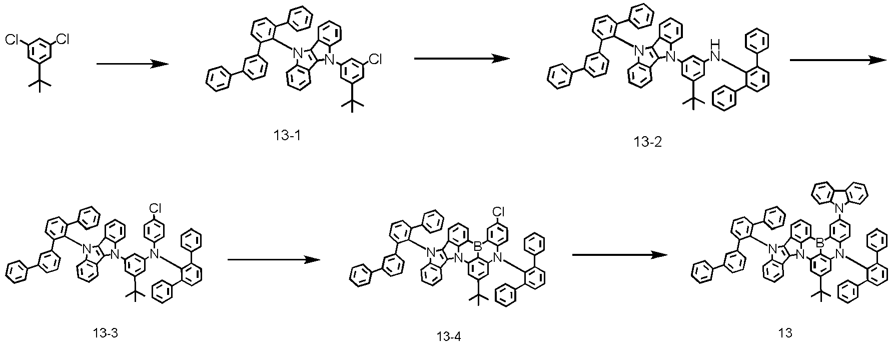

### (1) Synthesis of intermediate 13-1

5-([1,1':3',1":3",1‴-quaterphenyl]-2'-yl)-5,10-dihydroindolo[3,2-b]indole (1 equivalent (eq)), 1-(tert-butyl)-3,5-dichlorobenzene (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and an organic layer was separated.

The obtained organic layer was dried over MgSO₄, and then dried under reduced pressure. Intermediate 13-1 was obtained by purification with column chromatography using methylene chloride (MC) and n-hexane (yield: 73%).

### (2) Synthesis of intermediate 13-2

The intermediate 13-1 (1 eq), [1,1':3',1"-terphenyl]-2'-amine (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and an organic layer was separated

The obtained organic layer was dried over MgSO₄, and then dried under reduced pressure. Intermediate 13-2 was obtained by purification with column chromatography using MC and n-hexane (yield: 83%).

### (3) Synthesis of intermediate 13-3

The intermediate 13-2 (1 eq), 1-chloro-4-iodobenzene (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and an organic layer was separated.

The obtained organic layer was dried over MgSO₄, and then dried under reduced pressure. Intermediate 13-3 was obtained by purification with column chromatography using MC and n-hexane (yield: 54%).

### (4) Synthesis of Intermediate 13-4

After dissolving the intermediate 13-3 (1 eq) in ortho-dichlorobenzene and cooling at 0 °C, BBr₃ (3 eq) was slowly added under a nitrogen atmosphere. After completion of the dropwise addition, the temperature was raised to 180 °C and the contents were stirred for 48 hours. Thereafter, triethylamine was slowly added dropwise into the flask containing the reactants to terminate the reaction, and ethyl alcohol was added so that the product was precipitated and filtered.

The obtained solid was purified by column chromatography using MC and n-hexane, and then recrystallized using toluene and acetone to obtain intermediate 13-4 (yield: 15%).

### (5) Synthesis of compound 13

The intermediate 13-4 (1 eq), carbazole (1 eq), tris(dibenzylideneacetone)dipalladium(0) (0.05 eq), tri-tert-butylphosphine (0.1eq), and sodium tert-butoxide (1.2 eq) were dissolved in toluene and stirred at 100 °C for 10 hours. After cooling, the mixture was washed three times with ethyl acetate and water, and an organic layer was separated.

The obtained organic layer was dried over MgSO₄, and then dried under reduced pressure. Compound 13 was obtained by purification with column chromatography using MC and n-hexane (yield: 76%).

### Synthesis Example 2: synthesis of compound 35

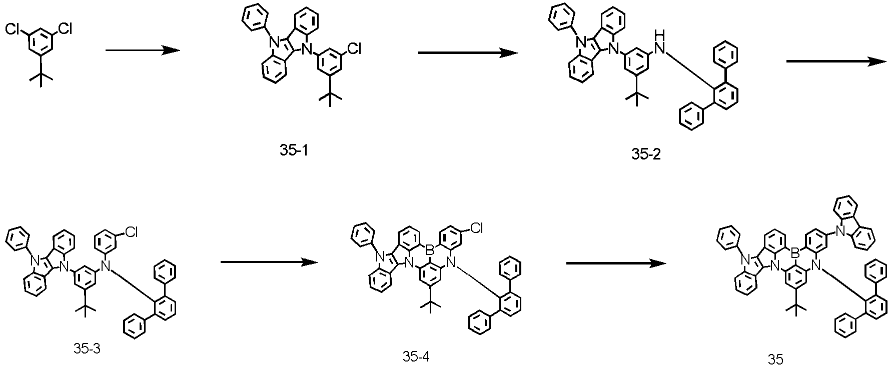

### (1) Synthesis of intermediate 35-1

5-phenyl-5,10-dihydroindolo[3,2-b]indole (1 eq), 1-(tert-butyl)-3,5-dichlorobenzene (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and an organic layer was separated.

The obtained organic layer was dried over MgSO₄, and then dried under reduced pressure. Intermediate 35-1 was obtained by purification with column chromatography using MC and n-hexane (yield: 75%).

### (2) Synthesis of intermediate 35-2

The intermediate 35-1 (5-(3-(tert-butyl)-5-chlorophenyl)-10-phenyl-5,10-dihydroindolo[3,2-b]indole) (1 eq), [1,1':3',1"-terphenyl]-2'-amine (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and an organic layer was separated.

The obtained organic layer was dried over MgSO₄, and then dried under reduced pressure. Intermediate 35-2 was obtained by purification with column chromatography using MC and n-hexane (yield: 82%).

### (3) Synthesis of intermediate 35-3

The intermediate 35-2 (N-(3-(tert-butyl)-5-(10-phenylindolo[3,2-b]indol-5(10H)-yl)phenyl)-[1,1':3',1"-terphenyl]-2'-amine) (1 eq), 1-chloro-3-iodobenzene (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and an organic layer was separated.

The obtained organic layer was dried with MgSO₄, and then dried under reduced pressure. Intermediate 35-3 was obtained by purification with column chromatography using MC and n-hexane (yield: 52%).

### (4) Synthesis of intermediate 35-4

The intermediate 35-3 (1 eq) was dissolved in ortho-dichlorobenzene and cooled to 0 °C. BBr₃ (3 eq) was slowly added thereto under a nitrogen atmosphere. Thereafter, the temperature was increased to 180 °C and the contents were stirred for 48 hours.

After cooling to room temperature, triethylamine was slowly added dropwise into the flask containing the reactants to terminate the reaction, and ethyl alcohol was added to obtain a product through precipitation and filtration.

The obtained solid was purified by column chromatography using MC and n-hexane, and then recrystallized using toluene and acetone to obtain intermediate 35-4 (yield: 14%).

### (5) Synthesis of compound 35

The Intermediate 35-4 (1 eq), carbazole (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and an organic layer was separated.

The obtained organic layer was dried over MgSO₄, and then dried under reduced pressure. Compound 35 was obtained by purification with column chromatography using MC and n-hexane (yield: 76%).

### Synthesis Example 3: Synthesis of compound 43

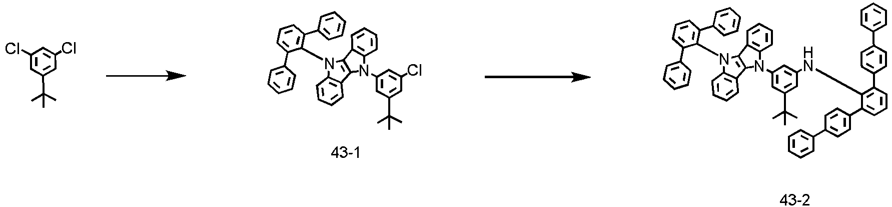

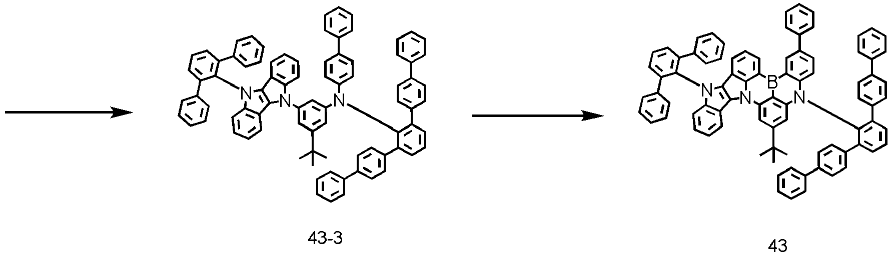

### (1) Synthesis of intermediate 43-1

5-([1,1':3',1"-terphenyl]-2'-yl)-5,10-dihydroindolo[3,2-b]indole (1 eq), 1-(tert-butyl)-3,5-dichlorobenzene (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and then an organic layer was separated.

The obtained organic layer was dried over MgSO₄, and then dried under reduced pressure. Intermediate 43-1 was obtained by purification with column chromatography using MC and n-hexane (yield: 75%).

### (2) Synthesis of intermediate 43-2

The intermediate 43-1 (1 eq), [1,1':4',1":3",1‴:4‴,1ʺʺ-quinquephenyl]-2"-amine (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and then an organic layer was separated.

The obtained organic layer was dried over MgSO₄, and then dried under reduced pressure. Intermediate 43-2 was obtained by purification with column chromatography using MC and n-hexane (yield: 80%).

### (3) Synthesis of intermediate 43-3

The intermediate 43-2 (1 eq), 4-iodo-1,1'-biphenyl (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and then an organic layer was separated.

The obtained organic layer was dried over MgSO₄, and then dried under reduced pressure. Intermediate 43-3 was obtained by purification with column chromatography using MC and n-hexane (yield: 54%).

### (4) Synthesis of compound 43

The intermediate 43-3 (1 eq) was dissolved in ortho-dichlorobenzene and cooled to 0 °C. BBr₃ (3 eq) was slowly injected in a nitrogen atmosphere. Thereafter, the temperature was increased to 180 °C and the contents were stirred for 48 hours.

After cooling to room temperature, triethylamine was slowly added dropwise into the flask containing the reactants to terminate the reaction, and then ethyl alcohol was added to obtain a product through precipitation and filtration. The obtained solid was purified with column chromatography using MC and n-hexane, and then compound 43 was obtained by recrystallization using toluene and acetone (yield: 14%).

### Synthetic Example 4: Synthesis of Compound 102

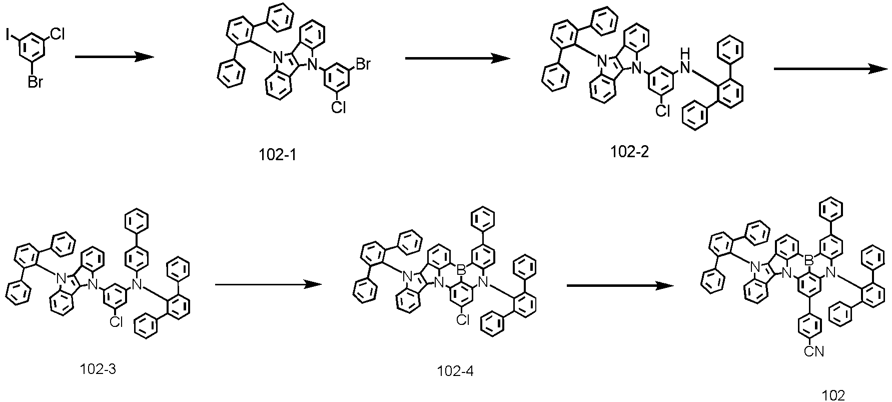

### (1) Synthesis of intermediate 102-1

5-([1,1':3',1"-terphenyl]-2'-yl)-5,10-dihydroindolo[3,2-b]indole (1 eq), 1-bromo-3-chloro-5-iodobenzene (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and an organic layer was separated.

The obtained organic layer was dried over MgSO₄, and then dried under reduced pressure. Intermediate 102-1 was obtained by purification with column chromatography using MC and n-hexane (yield: 71%).

### (2) Synthesis of intermediate 102-2

The intermediate 102-1 (1 eq), [1,1':3',1"-terphenyl]-2'-amine (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and an organic layer was separated.

The obtained organic layer was dried over MgSO₄, and then dried under reduced pressure. Intermediate 102-2 was obtained by purification with column chromatography using MC and n-hexane (yield: 83%).

### (3) Synthesis of intermediate 102-3

The intermediate 102-2 (1 eq), 4-iodo-1,1'-biphenyl (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and an organic layer was separated.

The obtained organic layer was dried over MgSO₄, and then dried under reduced pressure. Intermediate 102-3 was obtained by purification with column chromatography using MC and n-hexane (yield: 54%).

### (4) Synthesis of compound 102-4

The intermediate 102-3 (1 eq) was dissolved in ortho-dichlorobenzene, and then cooled to 0 °C. BBr₃ (3 eq) was slowly input in a nitrogen atmosphere. Thereafter, a temperature was increased to 180 °C and the contents were stirred for 48 hours.

After cooling to room temperature, triethylamine was slowly added dropwise into the flask containing the reactants to terminate the reaction, and then ethyl alcohol was added to obtain a product through precipitation and filtration. The obtained solid was purified by column chromatography using MC and n-hexane, and then recrystallized using toluene and acetone to obtain compound 102 (yield: 14%).

### (5) Synthesis of compound 102

Intermediate 102-4 (1eq), Potassium Ferrocyanide (1eq), Di-tert-butyl(4-dimethylaminophenyl)phosphine (0.1eq), and Sodium carbonate (4eq) were dissolved in DMF and then stirred at 160 °C for 12 hours. After cooling the solution, it was washed three times with ethyl acetate and water, and then powdered to obtain an organic layer. The obtained organic layer was dried at MgSO4 and then dried under reduced pressure. Purification with column chromatography with MC and n-Hexane gave compound 102.

### Synthetic Example 5: Synthesis of Compound 138

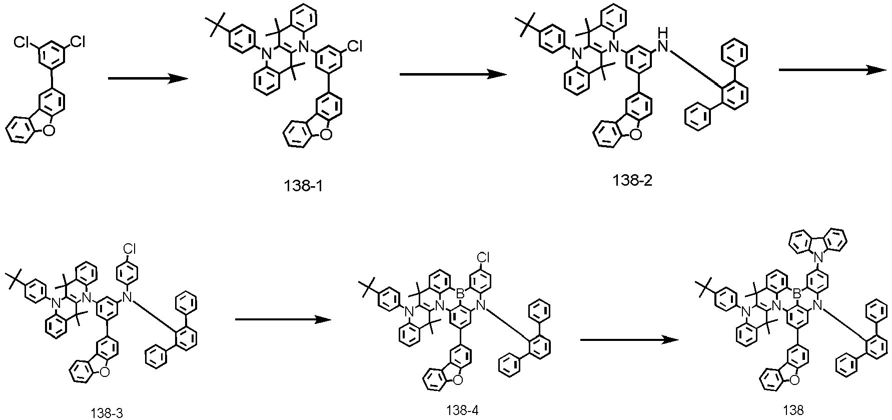

### (1) Synthesis of intermediate 138-1

5-(4-(tert-butyl)phenyl)-6,6,12,12-tetramethyl-5,6,11,12-tetrahydrodibenzo[b,g][1,5]naphthyridine (1 eq), 2-(3,5-dichlorophenyl)dibenzo[b,d]furan (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and an organic layer was separated.

The obtained organic layer was dried with MgSO₄, and then dried under reduced pressure. Intermediate 138-1 was obtained by purification with column chromatography using MC and n-hexane (yield: 78%).

### (2) Synthesis of intermediate 138-2

The intermediate 138-1 (1 eq), [1,1':3',1"-terphenyl]-2'-amine (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and an organic layer was separated.

The obtained organic layer was dried over MgSO₄, and then dried under reduced pressure. Intermediate 138-2 was obtained by purification with column chromatography using MC and n-hexane (yield: 83%).

### (3) Synthesis of intermediate 138-3

The intermediate 138-2 (1 eq), 1-chloro-4-iodobenzene (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and the organic layer was separated.

The obtained organic layer was dried over MgSO₄, and then dried under reduced pressure. Intermediate 138-3 was obtained by purification with column chromatography using MC and n-hexane.

### (4) Synthesis of intermediate 138-4

The intermediate 138-3 (1 eq) was dissolved in ortho-dichlorobenzene and cooled to 0 °C. BBr₃ (3 eq) was slowly added under a nitrogen atmosphere. Thereafter, the temperature was increased to 180 °C and the contents were stirred for 48 hours.

After cooling to room temperature, triethylamine was slowly added dropwise into the flask containing the reactants to terminate the reaction, and ethyl alcohol was added to obtain a product through precipitation and filtration. The obtained solid was purified by column chromatography using MC and n-hexane, and then recrystallized using toluene and acetone to obtain intermediate 138-4 (yield: 17%).

### (5) Synthesis of compound 138

The intermediate 138-4 (1 eq), carbazole (1 eq), tris(dibenzylideneacetone)dipalladium(0) (0.05 eq), tri-tert-butylphosphine (0.1 eq), and sodium tert-butoxide (1.2 eq) were dissolved in toluene and stirred at 100 °C for 10 hours. After cooling to room temperature, the mixture was washed three times with ethyl acetate and water, and the organic layer was separated.

The obtained organic layer was dried over MgSO₄, and then dried under reduced pressure. Compound 138 was obtained by purification with column chromatography using MC and n-hexane (yield: 75%).

### Fabrication of light-emitting device

As the anode, a glass substrate (Corning product) on which a 15 Ω/cm² (1200 Å) ITO electrode was formed was cut into a size of 50 millimeters (mm) x 50 mm x 0.7 mm, and the cut substrate was ultrasonically cleaned for 5 minutes using isopropyl alcohol and deionized (DI) water. The ultrasonically cleaned substrate was irradiated with an ultraviolet ray for 30 minutes and exposed to ozone, and then mounted on a vacuum deposition device.

Thereafter, HT-1 was vacuum-deposited on the anode to form a hole transport layer having a thickness of 600 Å. HT-2 was vacuum-deposited on the hole transport layer to form an electron blocking layer having a thickness of 100 Å.

A host mixture in which a first host (HTH) and a second host (ETH) were mixed in a weight ratio of 1:1, a phosphorescent sensitizer (S1), and a condensed heterocyclic compound of Table 1 were co-deposited in a weight ratio of 85:14:1 on the hole transport layer to form an emission layer having a thickness of 300 Å.

ET-1 was vacuum-deposited on the emission layer to form a hole blocking layer having a thickness of 50 Å. ET-2:Liq (a weight ratio of 5:5) was vacuum-deposited on the hole blocking layer to form an electron transport layer having a thickness of 300 Å. LiF was vacuum-deposited on the electron transport layer to form an electron injection layer having a thickness of 10 Å.

Al was vacuum-deposited on the electron injection layer to form a cathode having a thickness of 1000 Å, thereby manufacturing a light-emitting device.

The compounds as used above are represented by chemical formulae below.

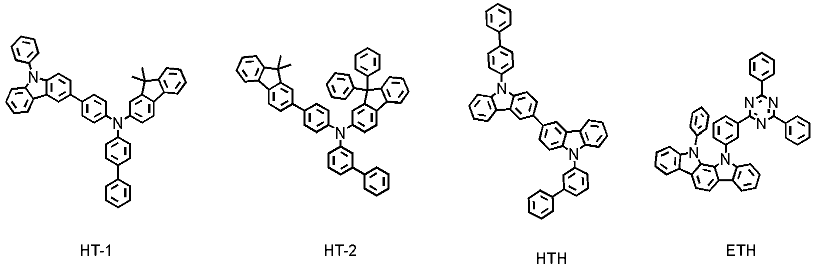

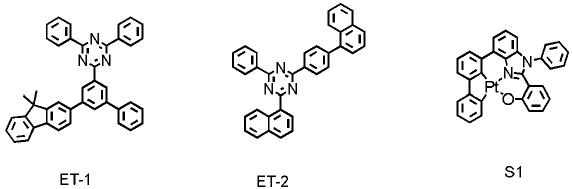

The compounds used in Comparative Examples are as follows.

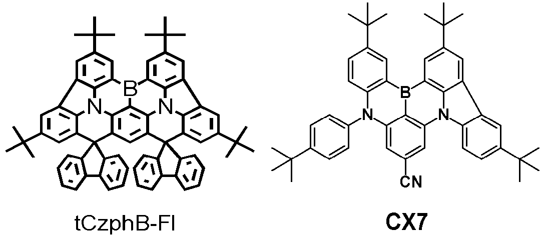

Properties of the light-emitting devices manufactured according to the Examples and the Comparative Examples were measured at a current density of 10 mA/cm² based on V7000 OLED IVL Test System (Polaronix).

Specifically, a driving voltage (V) at a luminance of 1000 cd/m² was measured using a source meter (Keithley Instrument, SMU 236), and a luminous efficiency (Cd/A) was measured using a luminance meter PR-650 (Photo Research 650). The driving voltage of each light-emitting device was expressed as a relative value based on driving voltage of the light-emitting device using the compound of Comparative Example 1.

A time (T₉₅) until a luminance decreased to 95% of an initial luminance was measured while continuously driving the light-emitting devices at a current density of 10 mA/cm². The T₉₅ value of each light-emitting device was expressed as a relative value based on T₉₅ of the light-emitting device using the compound of Comparative Example 1.

The results are shown in Table 1.

**Table 1**

| | host | phosphorescent sensitizer | condensed heterocyclic compound | driving voltage (%) | efficiency (cd/A) | life-span (%) |
|---|---|---|---|---|---|---|
| Example 1 | HTH/ETH | S1 | 13 | 95 | 132 | 195 |
| Example 2 | HTH/ETH | S1 | 35 | 92 | 148 | 225 |
| Example 3 | HTH/ETH | S1 | 43 | 97 | 137 | 207 |
| Example 4 | HTH/ETH | S1 | 102 | 93 | 120 | 147 |
| Example 5 | HTH/ETH | S1 | 138 | 98 | 115 | 130 |
| Comparative Example 1 | HTH/ETH | S1 | tCzphB-Fl | 100 | 107 | 100 |
| Comparative Example 2 | HTH/ETH | S1 | CX7 | 102 | 70 | 65 |

Referring to Table 1, in the Examples using the condensed heterocyclic compound represented by Chemical Formula 1 as a dopant material in the emission layer, the driving voltage of the light-emitting device was lowered and the luminous efficiency and life-span properties were improved.

The light-emitting device according to Comparative Examples provided a higher driving voltage, a lower luminous efficiency, and a lesser life-span than those from the light-emitting devices of the Examples.

While aspects of embodiments have been particularly shown and described, it will be understood that various changes in form and details may be made therein without departing from the scope of the following claims.

## Claims

1. A condensed heterocyclic compound represented by Chemical Formula 1 : 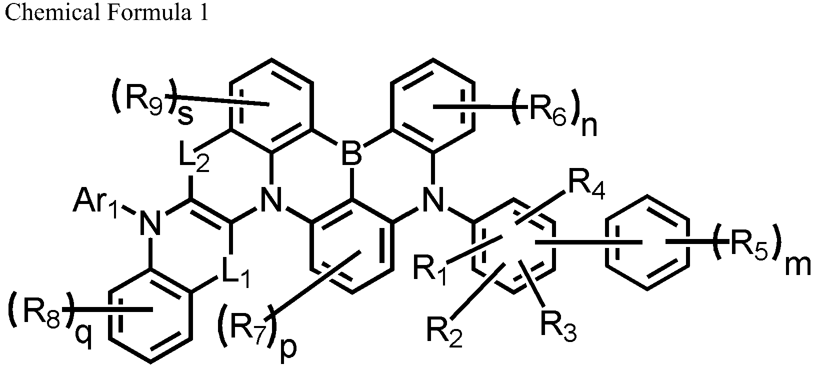 wherein, in Chemical Formula 1,
L₁ and L₂ are each independently a direct bond or CR₁₀;
Ar₁ is a substituted or unsubstituted C₆-C₆₀ aryl group or a substituted or unsubstituted C₁-C₆₀ heteroaryl group;
one of R₁ to R₄ is a substituted or unsubstituted C₆-C₆₀ aryl group, or a substituted or unsubstituted C₁-C₆₀ heteroaryl group; or two adjacent ones of R₁ to R₄ are combined with each other to form a substituted or unsubstituted C₆-C₆₀ aryl group, or a substituted or unsubstituted C₁-C₆₀ heteroaryl group;
a remainder of R₁ to R₄, and R₅ to R₁₀ are each independently hydrogen, deuterium, halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₆-C₆₀ aryloxy group, a substituted or unsubstituted C₆-C₆₀ arylthio group, a substituted or unsubstituted C₁-C₆₀ heteroaryloxy group, a substituted or unsubstituted C₁-C₆₀ heteroarylthio group, a substituted or unsubstituted C₈-C₆₀ condensed polycyclic group, - SiRR'R", -PRR', -P(=O)RR', -NRR', -BRR', -C(=O)R, -S(=O)R, or -S(=O)₂R;
two or more adjacent ones of the remainder of R₁ to R₄, and R₅ to R₁₀ are optionally combined with each other to form a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, or a substituted or unsubstituted C₁-C₆₀ heteroaryl group;
R, R', and R" are each independently hydrogen, deuterium, halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₆-C₆₀ aryloxy group, a substituted or unsubstituted C₆-C₆₀ arylthio group, a substituted or unsubstituted C₁-C₆₀ heteroaryloxy group, a substituted or unsubstituted C₁-C₆₀ heteroarylthio group, or a substituted or unsubstituted C₈-C₆₀ condensed polycyclic group;
m is an integer from 0 to 5, n and q are each independently an integer from 0 to 4, and p and s are each independently an integer from 0 to 3; and
when n, m, p, q, and s are each independently 2 or more, each of R₅ to R₉ is independently the same as or different from each other.

2. The condensed heterocyclic compound of claim 1, wherein the condensed heterocyclic compound is represented by Chemical Formula 1-1 or 1-2: 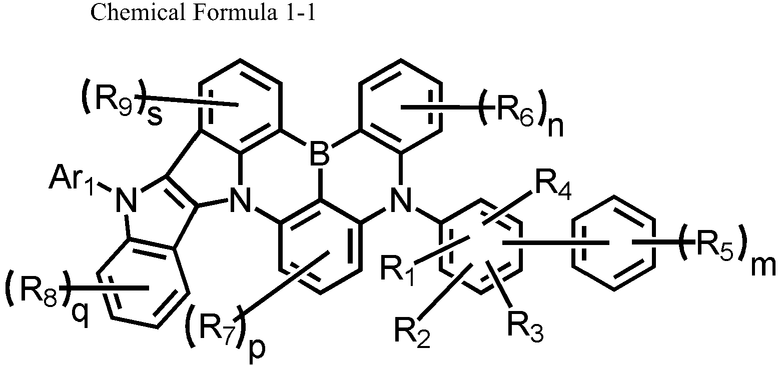 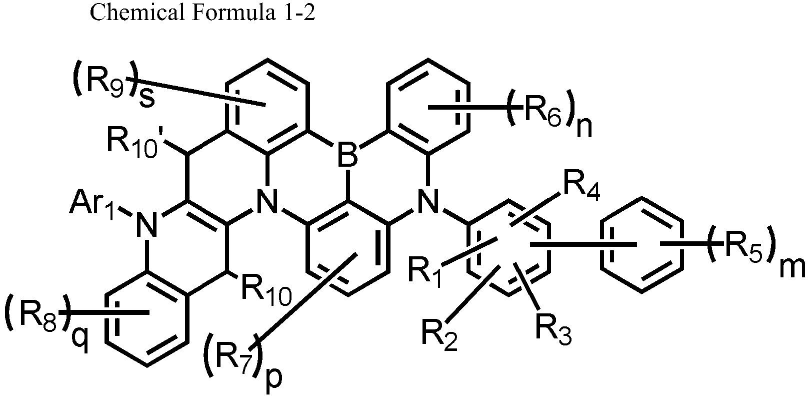 wherein, in Chemical Formulae 1-1 and 1-2,
Ar₁, R₁ to R₁₀, n, m, p, q and s are the same as those defined in claim 1;
R₁₀' is hydrogen, deuterium, halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₆-C₆₀ aryloxy group, a substituted or unsubstituted C₆-C₆₀ arylthio group, a substituted or unsubstituted C₁-C₆₀ heteroaryloxy group, a substituted or unsubstituted C₁-C₆₀ heteroarylthio group, a substituted or unsubstituted C₈-C₆₀ condensed polycyclic group, -SiRR'R", -PRR', -P(=O)RR', -NRR', -BRR', -C(=O)R, - S(=O)R, or -S(=O)₂R;
R₁₀' is optionally combined with an adjacent group to form a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, or a substituted or unsubstituted C₂-C₆₀ heteroaryl group; and
R, R', and R" are the same as those defined in claim 1.

3. The condensed heterocyclic compound of claim 1, wherein the condensed heterocyclic compound is represented by Chemical Formula 1-3: 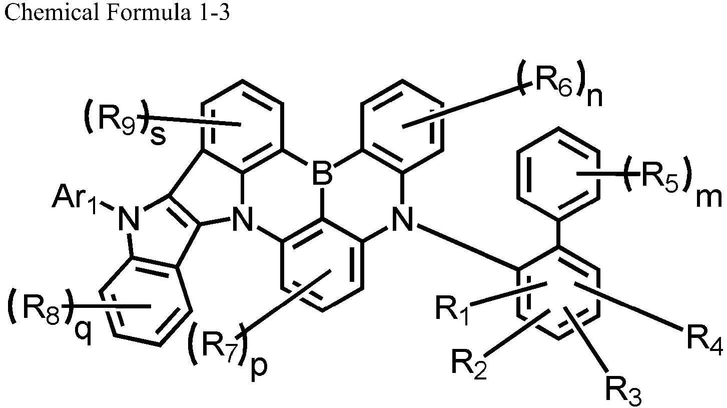 wherein, in Chemical Formula 1-3, Ar₁, R₁ to R₉, n, m, p, q and s are the same as those defined in claim 1.

4. The condensed heterocyclic compound of claim 1, wherein the condensed heterocyclic compound is represented by Chemical Formula 1-4 or 1-5: 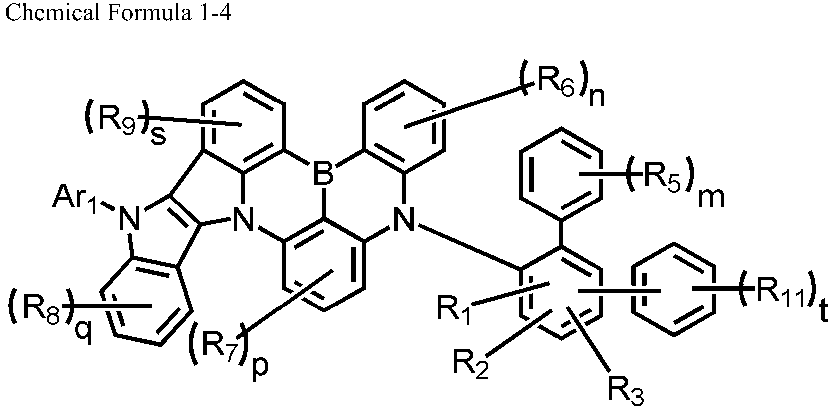 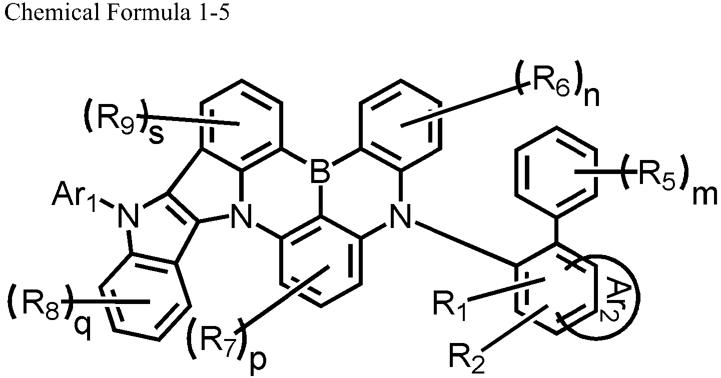 wherein, in Chemical formulae 1-4 and 1-5,
Ar₁, R₁ to R₉, n, m, p, q and s are the same as those defined in claim 1;
Ar₂ is a substituted or unsubstituted C₆-C₆₀ aryl group, or a substituted or unsubstituted C₂-C₆₀ heteroaryl group;
R₁₁ is hydrogen, deuterium, halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₆-C₆₀ aryloxy group, a substituted or unsubstituted C₆-C₆₀ arylthio group, a substituted or unsubstituted C₁-C₆₀ heteroaryloxy group, a substituted or unsubstituted C₁-C₆₀ heteroarylthio group, a substituted or unsubstituted C₈-C₆₀ condensed polycyclic group, -SiRR'R", -PRR', -P(=O)RR', -NRR', -BRR', -C(=O)R, - S(=O)R or -S(=O)₂R, or
R₁₁ is combined with an adjacent group to form a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, or a substituted or unsubstituted C₂-C₆₀ heteroaryl group;
R, R', and R" are the same as those defined in claim 1;
t is an integer from 0 to 5; and
when t is 2 or more, each R₁₁ is the same as or different from each other.

5. The condensed heterocyclic compound of claim 4, wherein the condensed heterocyclic compound is represented by Chemical Formula 1-6 or Chemical Formula 1-7: 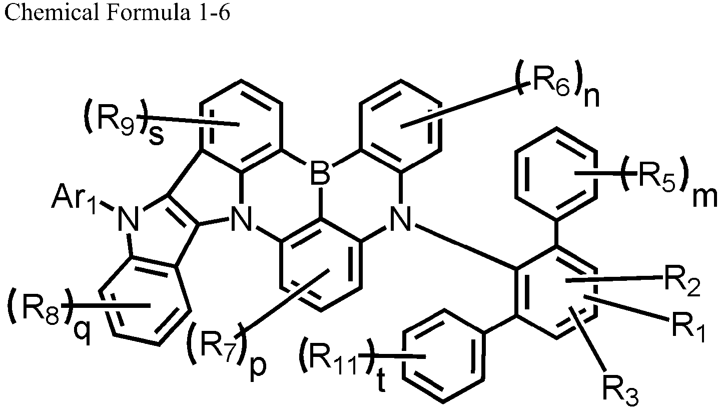 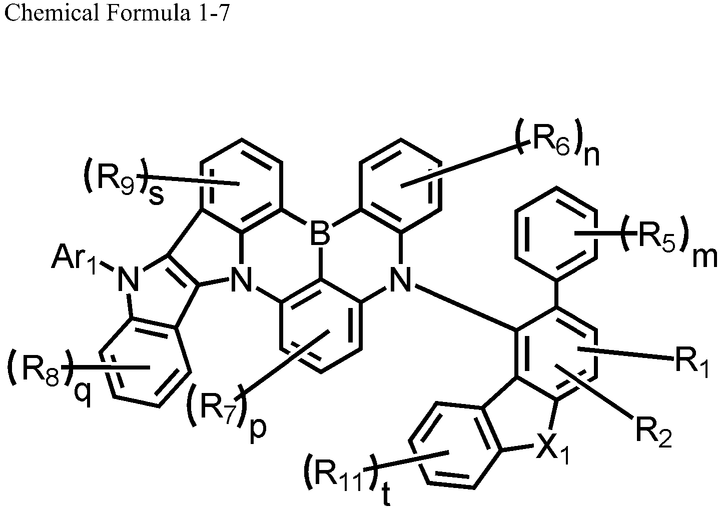 wherein, in Chemical Formulae 1-6 and 1-7,
Ar₁, R₁ to R₉, R₁₁, n, m, p, q, s, and t are the same as those defined in claim 4, and
X₁ is O or S.

6. The condensed heterocyclic compound of any one of claims 1 to 5, wherein, in Chemical Formula 1, Ar₁ is represented by Chemical Formula 2: 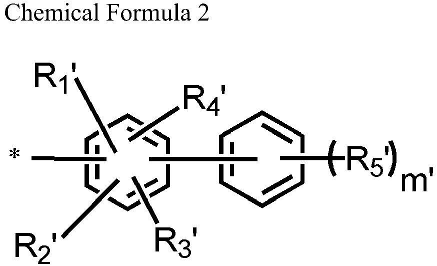 wherein, in Chemical Formula 2,
one of R₁' to R₄' is a substituted or unsubstituted C₆-C₆₀ aryl group, or a substituted or unsubstituted C₁-C₆₀ heteroaryl group, or two adjacent ones of R₁' to R₄' are combined with each other to form a substituted or unsubstituted C₆-C₆₀ aryl group, or a substituted or unsubstituted C₁-C₆₀ heteroaryl group;
a remainder of R₁' to R₄', and R₅' are each be independently hydrogen, deuterium, halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₆-C₆₀ aryloxy group, a substituted or unsubstituted C₆-C₆₀ arylthio group, a substituted or unsubstituted C₁-C₆₀ heteroaryloxy group, a substituted or unsubstituted C₁-C₆₀ heteroarylthio group, a substituted or unsubstituted C₈-C₆₀ condensed polycyclic group, -SiRR'R", -PRR', - P(=O)RR', -NRR', -BRR', -C(=O)R, -S(=O)R, or -S(=O)₂R;
two or more adjacent ones of the remainder of R₁' to R₄' and R₅' are optionally combined with each other to form a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group or a substituted or unsubstituted C₂-C₆₀ heteroaryl group;
R, R', and R" are the same as those defined in claim 1;
m' is an integer from 0 to 5;
when m is 2 or more, each R₅' is independently the same as or different from each other; and
* is a bonding point with a nitrogen atom.

7. The condensed heterocyclic compound of any one of claims 1 to 6, wherein, in Chemical Formula 1, R₈ and R₉ are each independently hydrogen or deuterium.

8. The condensed heterocyclic compound of claim 1, wherein the condensed heterocyclic compound comprises at least one compound represented by Compounds 1 to 156:

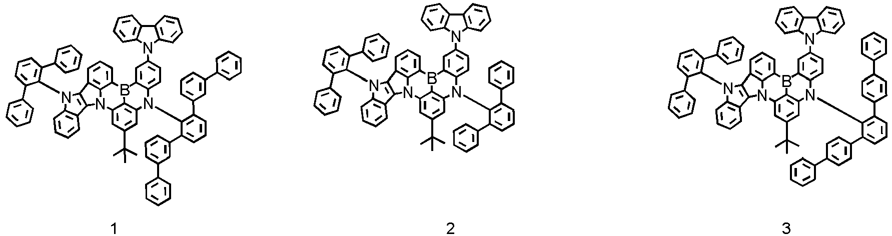

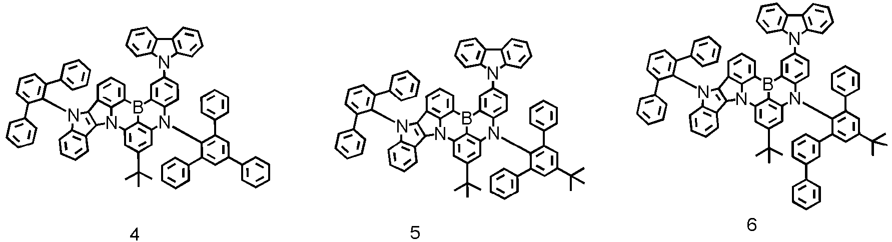

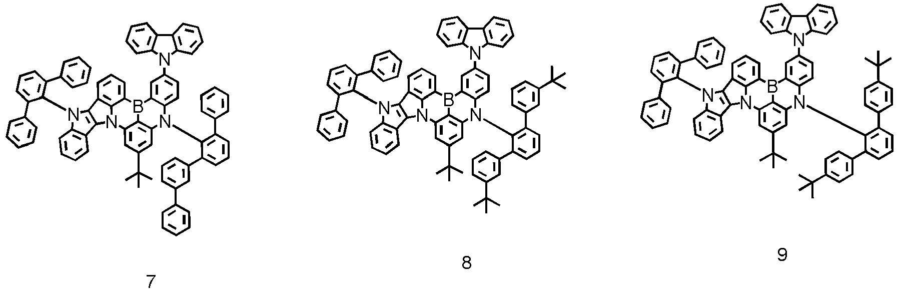

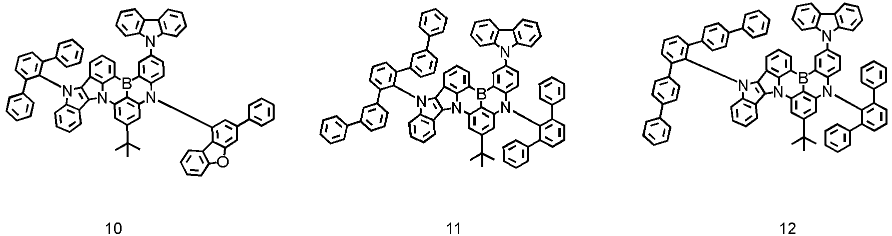

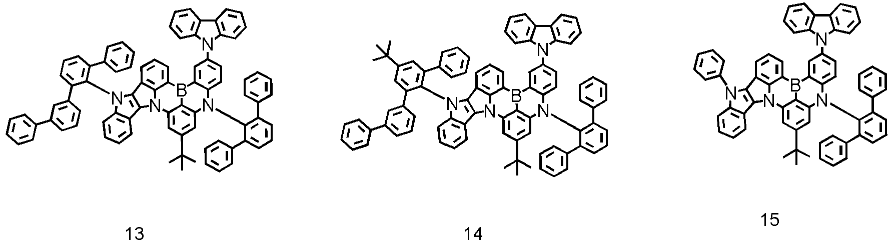

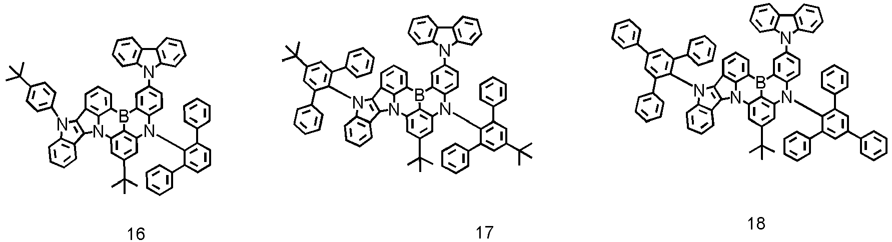

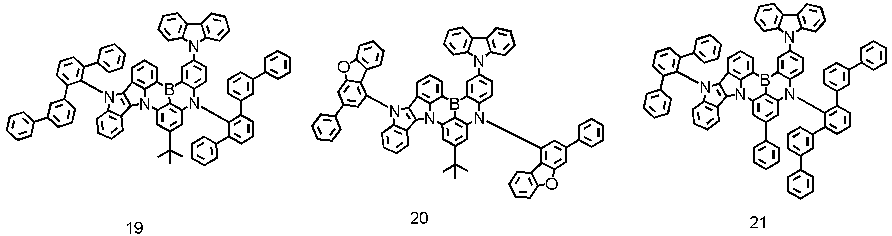

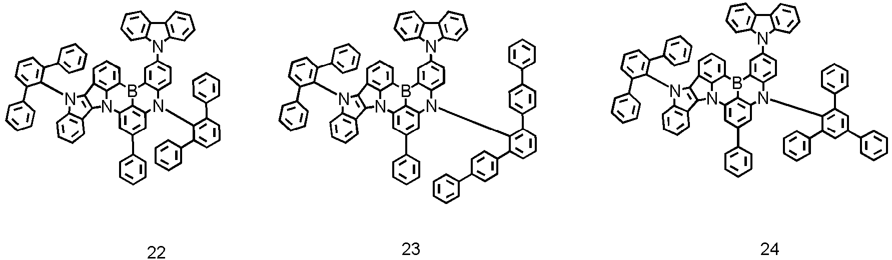

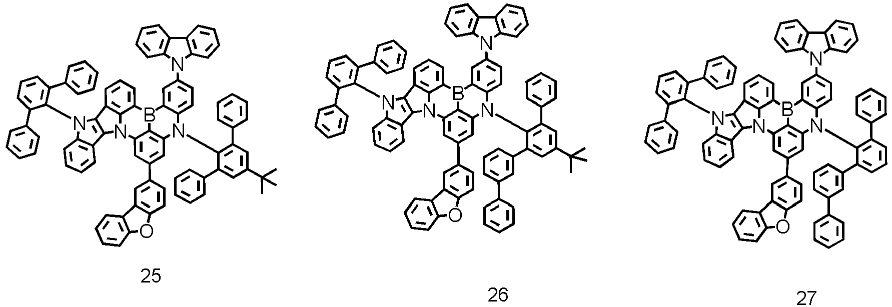

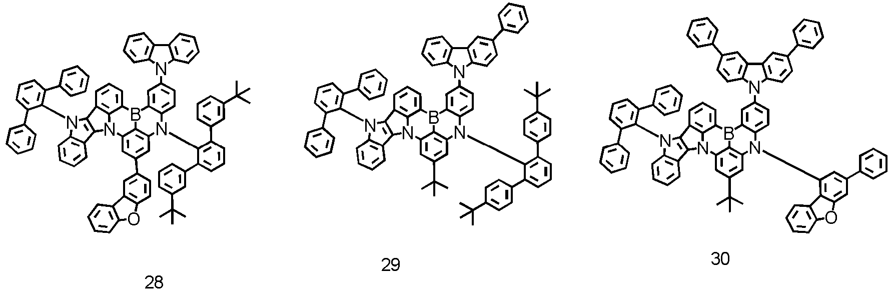

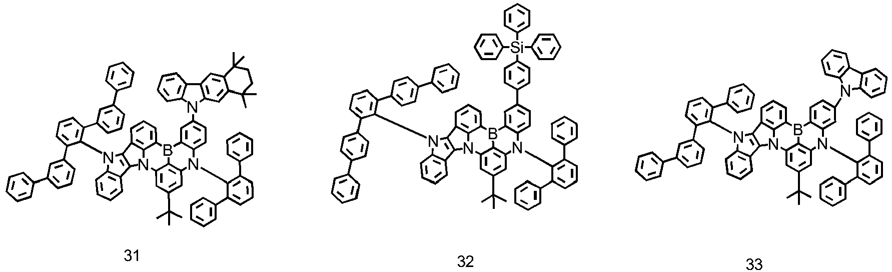

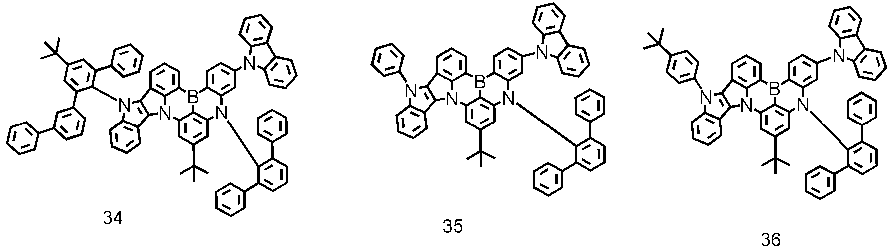

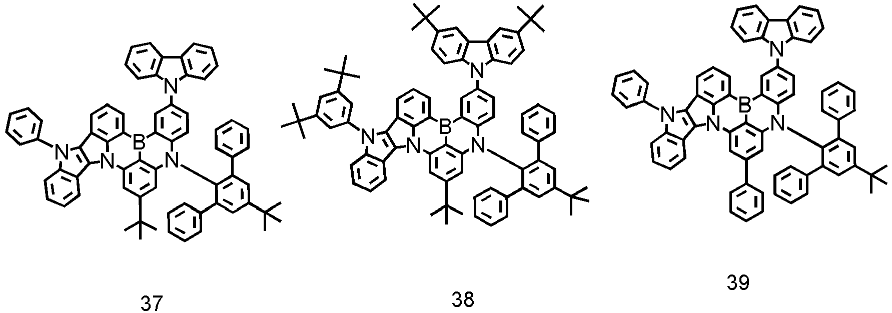

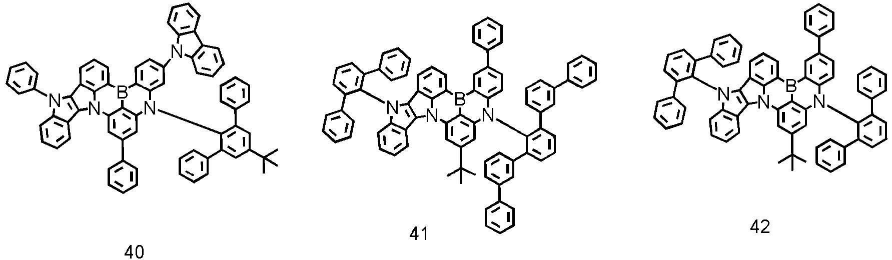

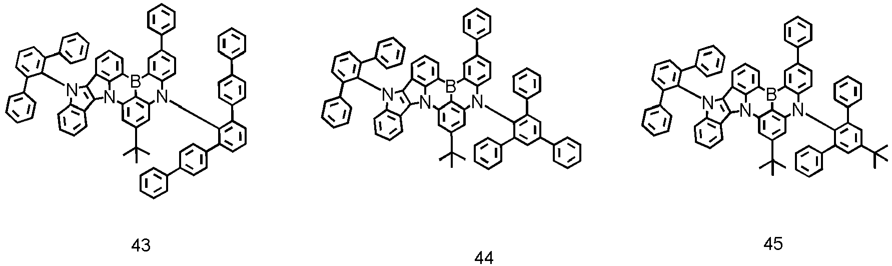

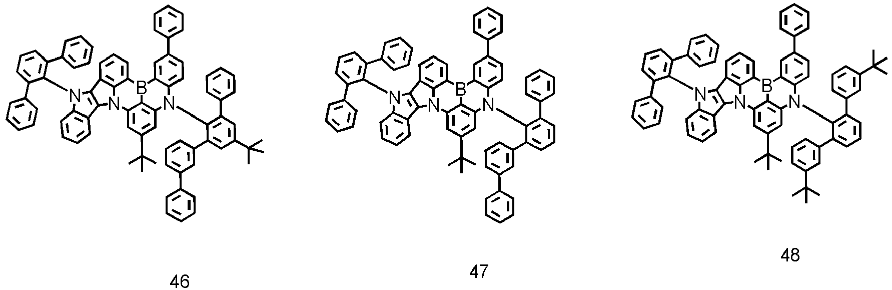

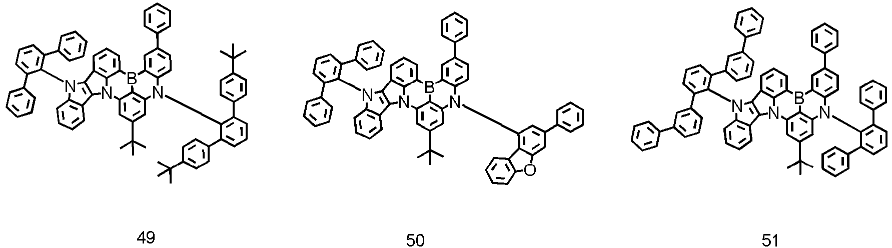

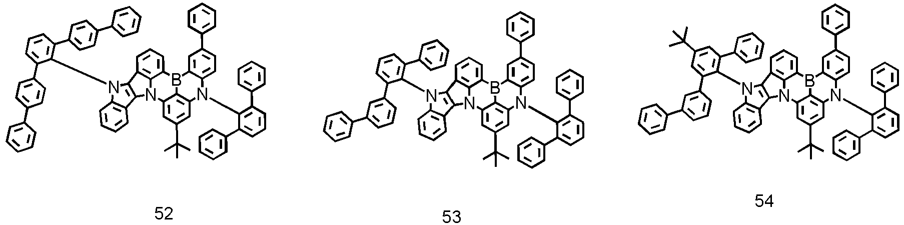

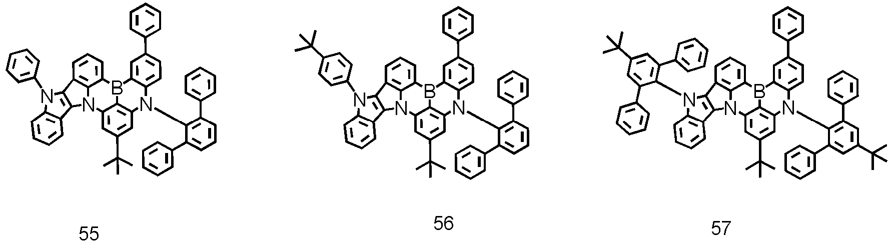

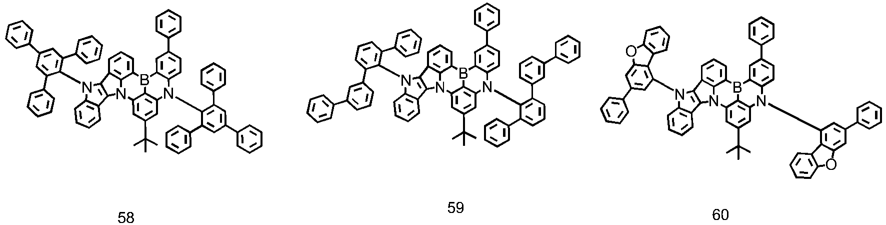

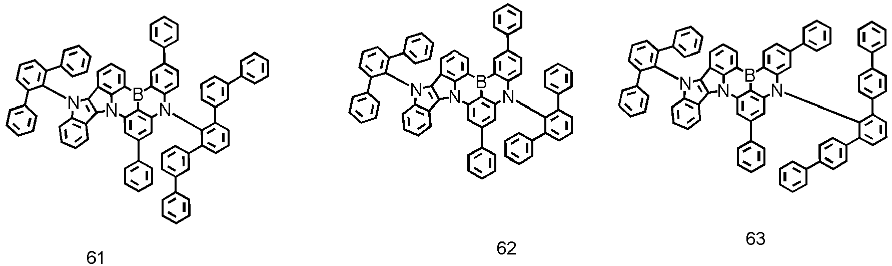

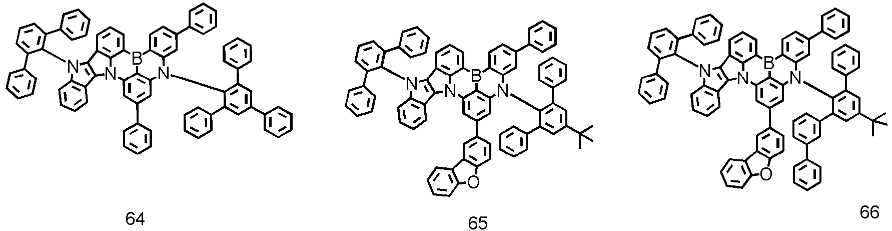

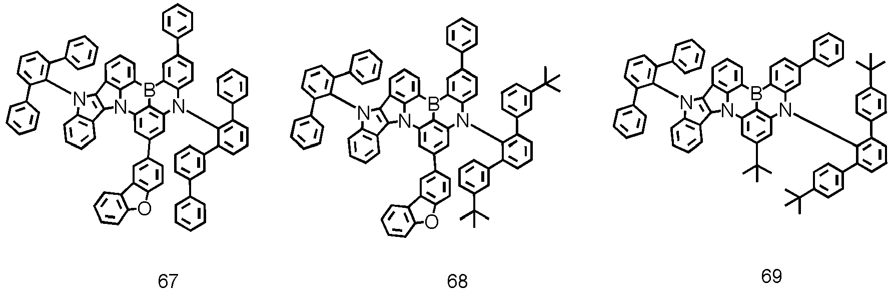

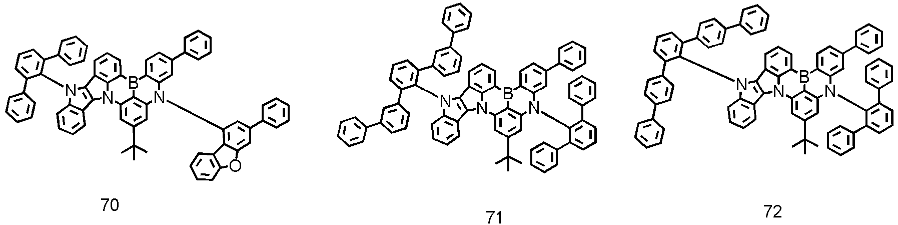

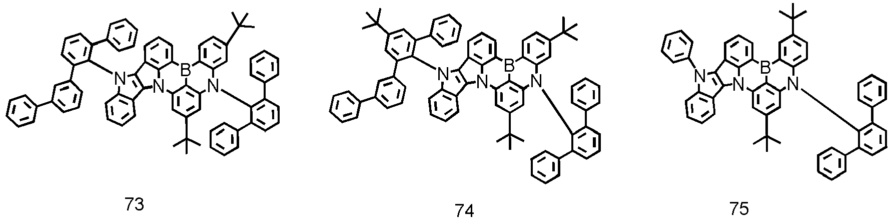

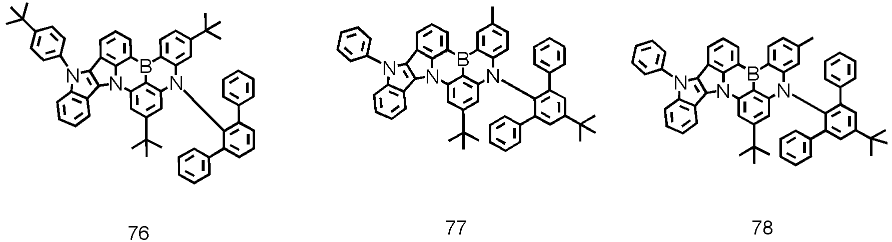

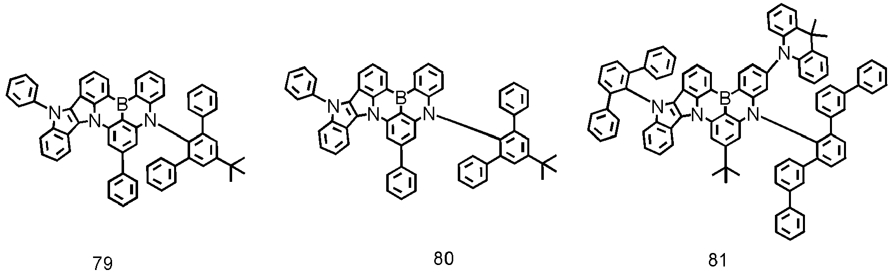

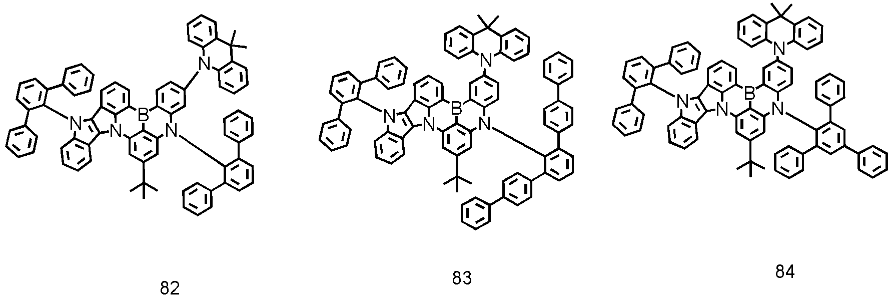

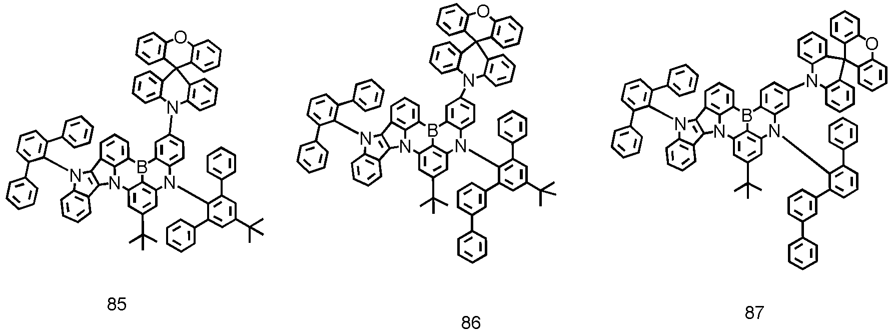

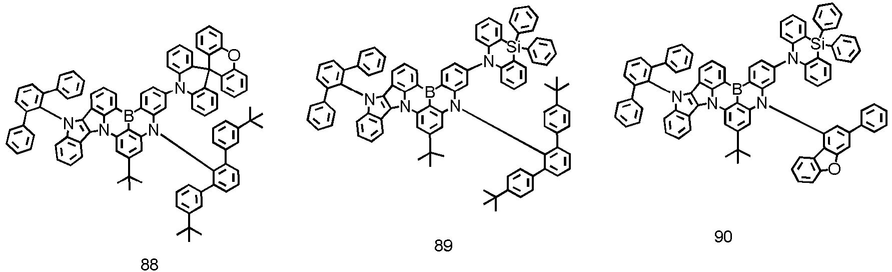

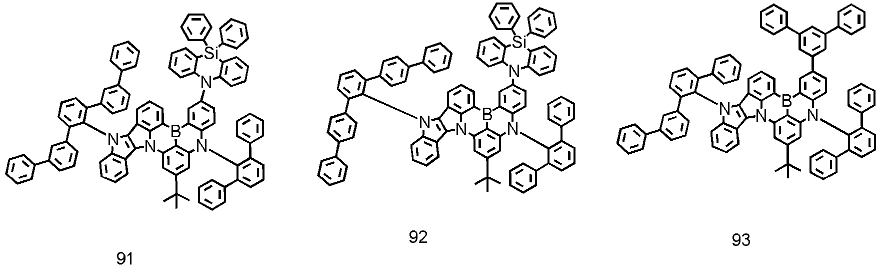

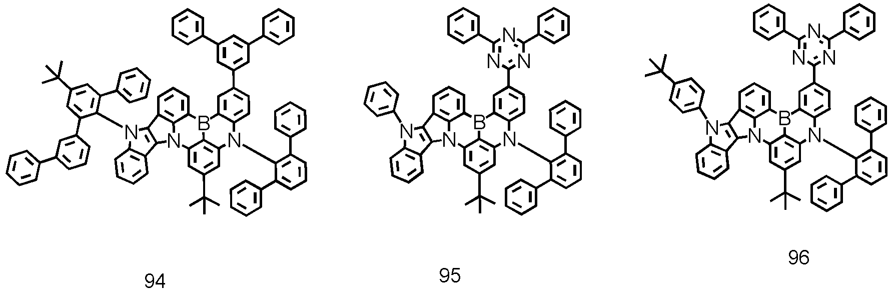

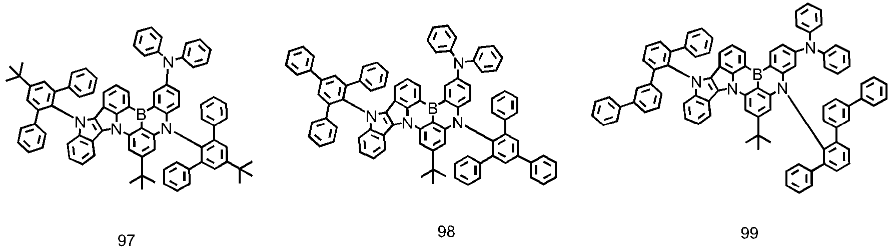

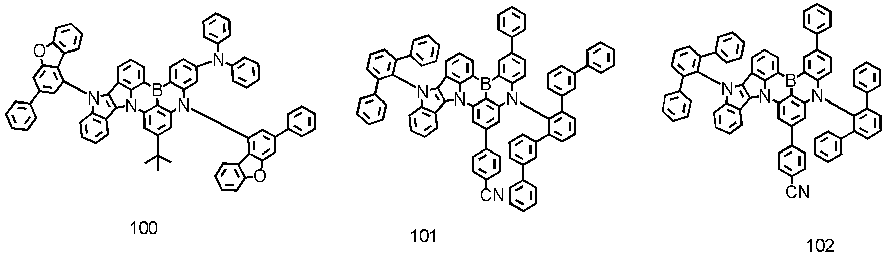

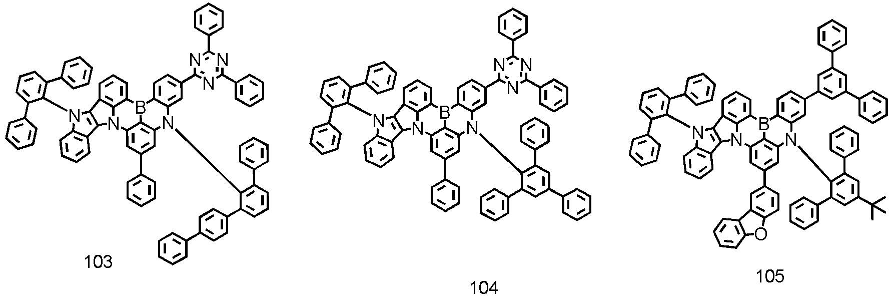

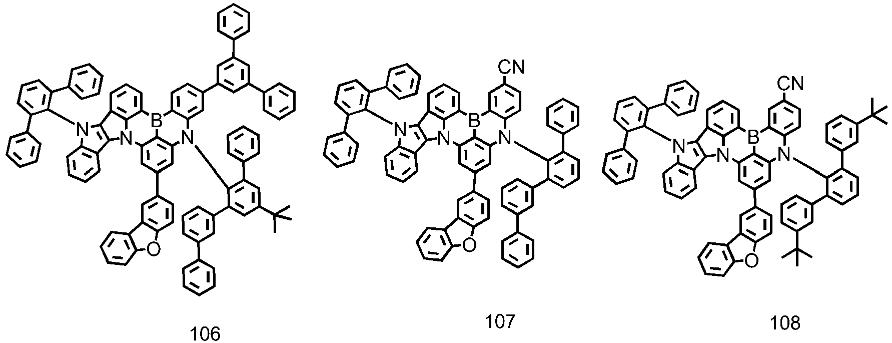

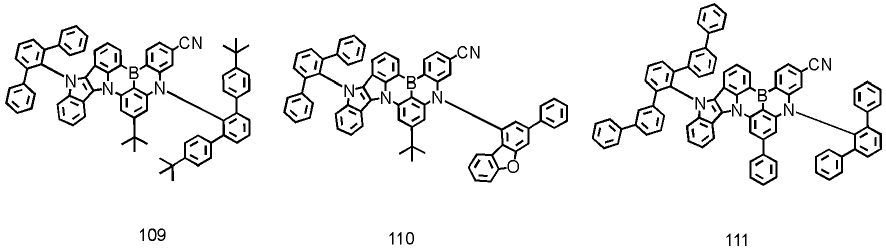

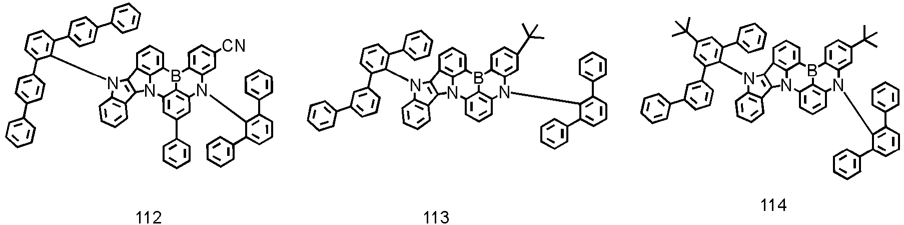

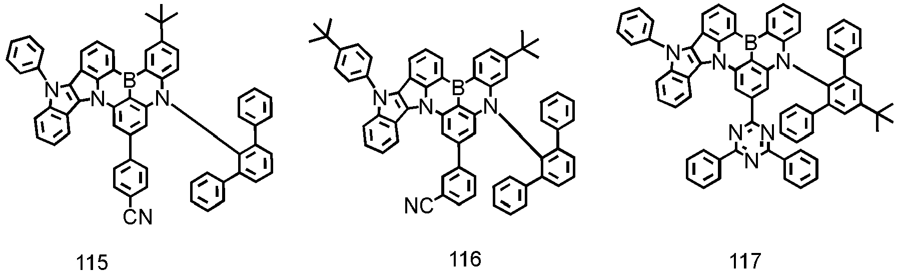

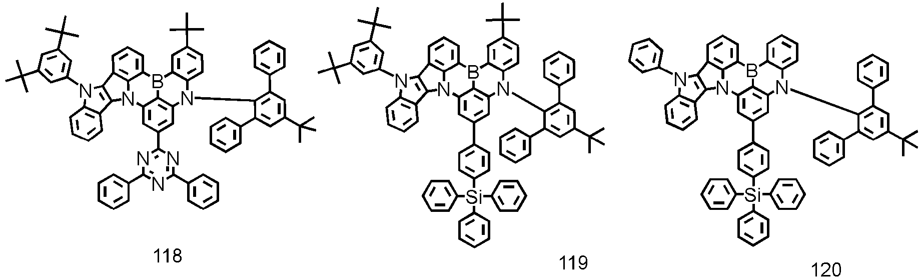

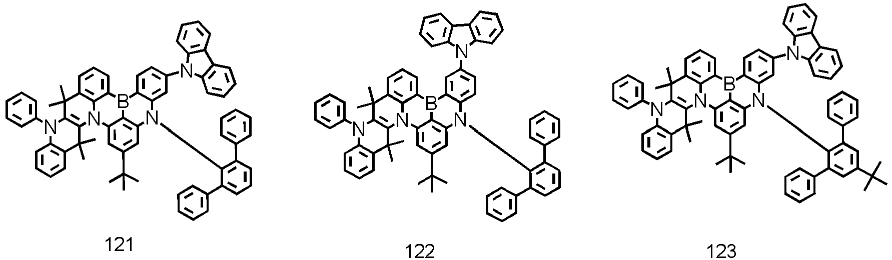

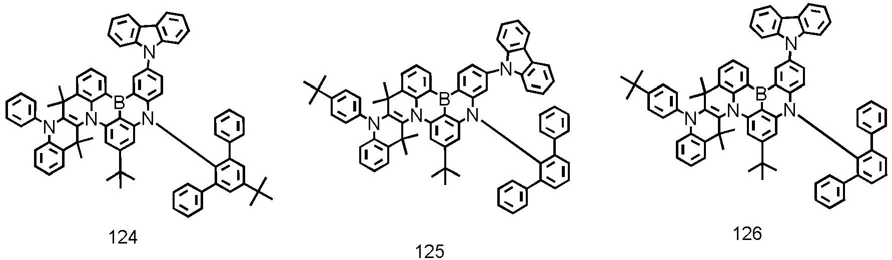

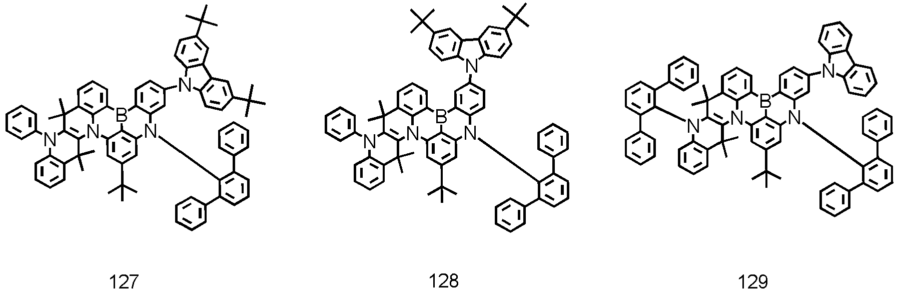

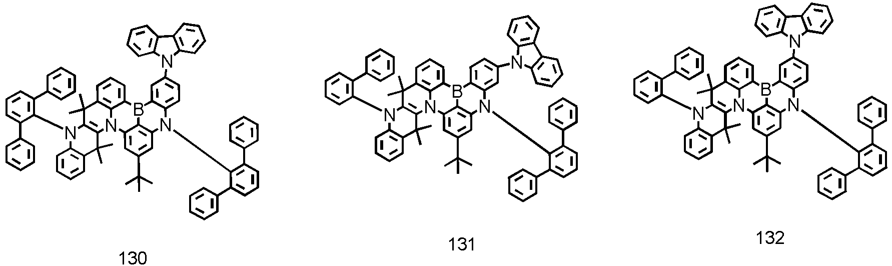

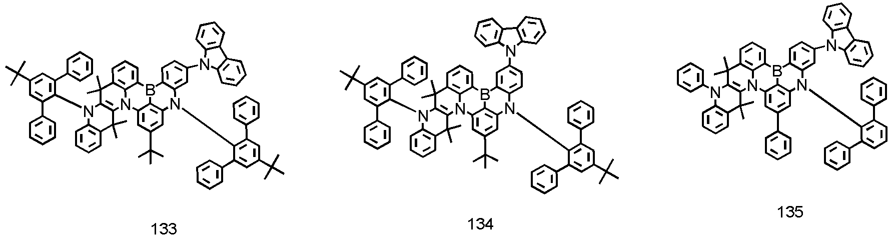

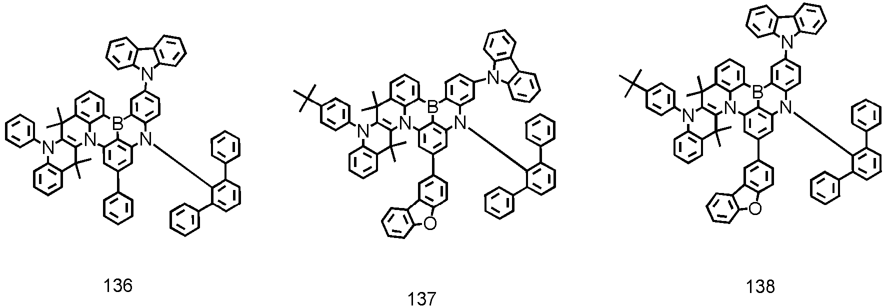

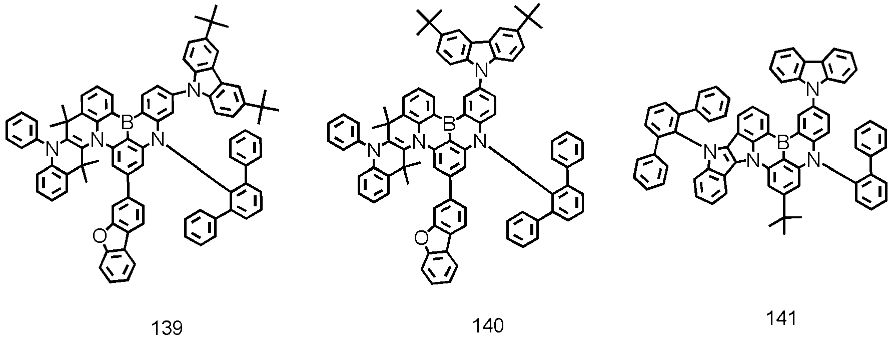

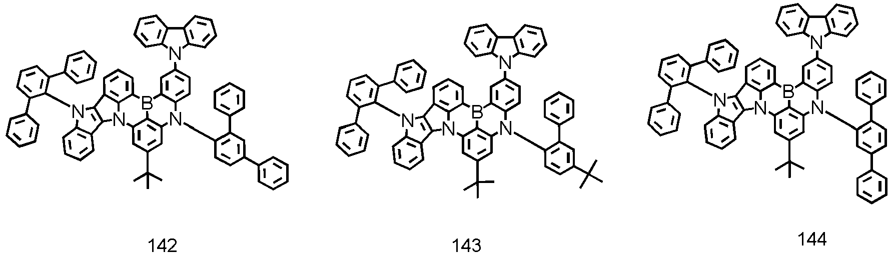

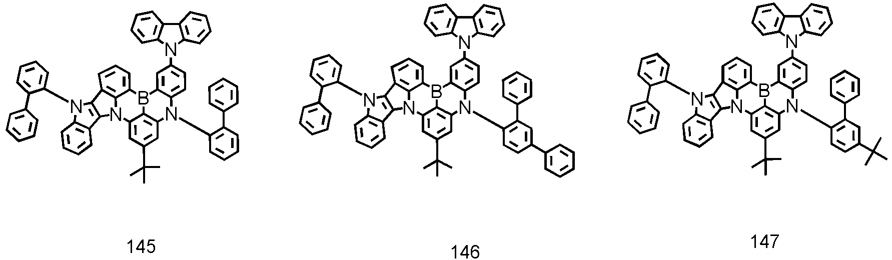

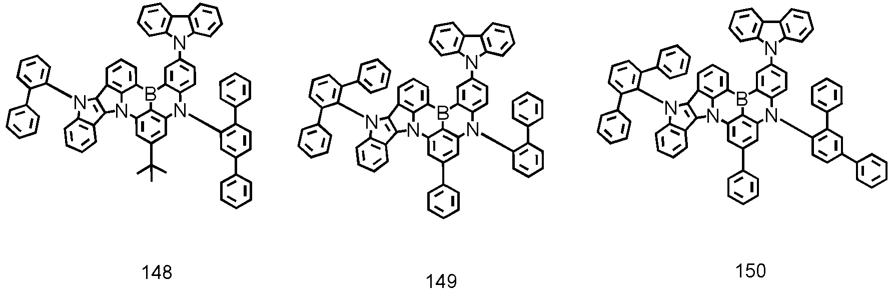

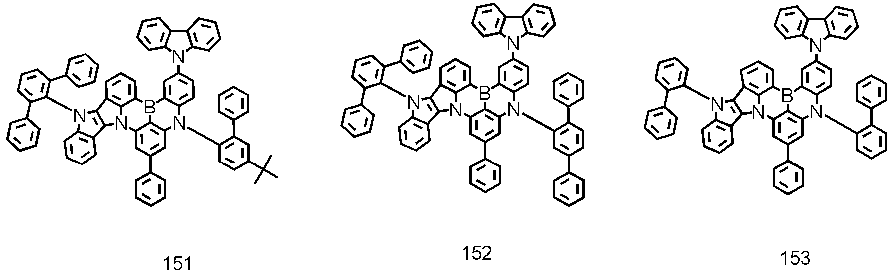

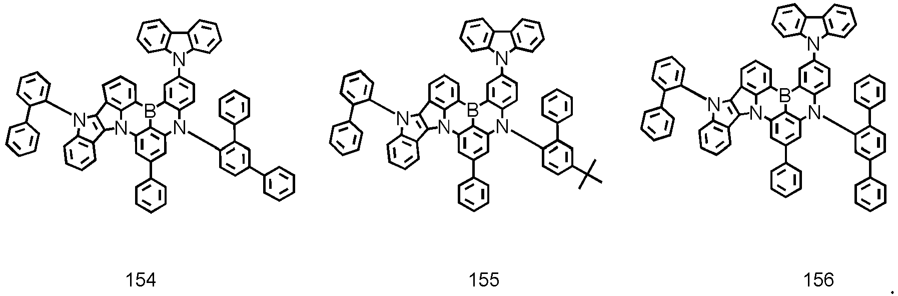

9. A light-emitting device (ED), comprising:
a first electrode (110);
a second electrode (150); and
an intermediate layer (ITL) arranged between the first electrode (110) and the second electrode (150),
wherein the intermediate layer (ITL) comprises at least one condensed heterocyclic compound represented by Chemical Formula 1: 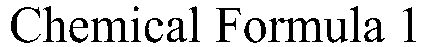 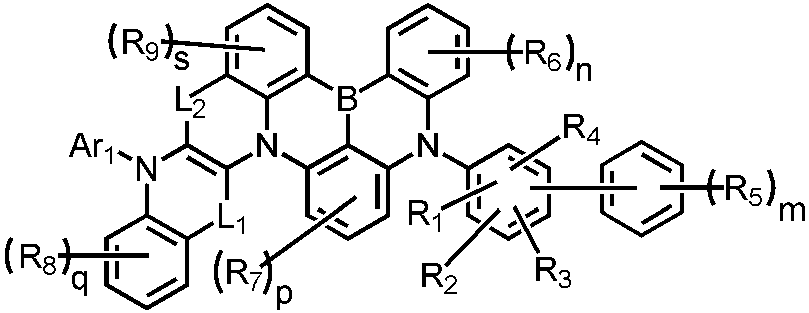
wherein, in Chemical Formula 1,
L₁ and L₂ are each independently a direct bond or CR₁₀;
Ar₁ is a substituted or unsubstituted C₆-C₆₀ aryl group or a substituted or unsubstituted C₁-C₆₀ heteroaryl group;
one of R₁ to R₄ is a substituted or unsubstituted C₆-C₆₀ aryl group, or a substituted or unsubstituted C₁-C₆₀ heteroaryl group; or two adjacent ones of R₁ to R₄ are combined with each other to form a substituted or unsubstituted C₆-C₆₀ aryl group, or a substituted or unsubstituted C₂-C₆₀ heteroaryl group;
a remainder of R₁ to R₄, and R₅ to R₁₀ are each independently hydrogen, deuterium, halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₆-C₆₀ aryloxy group, a substituted or unsubstituted C₆-C₆₀ arylthio group, a substituted or unsubstituted C₁-C₆₀ heteroaryloxy group, a substituted or unsubstituted C₁-C₆₀ heteroarylthio group, a substituted or unsubstituted C₈-C₆₀ condensed polycyclic group, - SiRR'R", -PRR', -P(=O)RR', -NRR', -BRR', -C(=O)R, -S(=O)R, or -S(=O)₂R;
two or more adjacent ones of the remainder of R₁ to R₄, and R₅ to R₁₀ are optionally combined with each other to form a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, or a substituted or unsubstituted C₂-C₆₀ heteroaryl group;
R, R', and R" are each independently hydrogen, deuterium, halogen, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₆₀ cycloalkyl group, a substituted or unsubstituted C₅-C₆₀ cycloalkenyl group, a substituted or unsubstituted C₃-C₆₀ heterocycloalkyl group, a substituted or unsubstituted C₁-C₆₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₆-C₆₀ aryloxy group, a substituted or unsubstituted C₆-C₆₀ arylthio group, a substituted or unsubstituted C₁-C₆₀ heteroaryloxy group, a substituted or unsubstituted C₁-C₆₀ heteroarylthio group, or a substituted or unsubstituted C₈-C₆₀ condensed polycyclic group;
m is an integer from 0 to 5, n and q are each independently an integer from 0 to 4, and p and s are each independently an integer from 0 to 3; and
when n, m, p, q and s are each independently 2 or more, each of R₅ to R₉ are independently the same as or different from each other.

10. The light-emitting device (ED) of claim 9, wherein
the intermediate layer (ITL) comprises an emission layer (130) and an organic layer, and
at least one of the emission layer (130) or the organic layer comprises the at least one condensed heterocyclic compound of Chemical Formula 1.

11. The light-emitting device (ED) of claim 10, wherein the organic layer comprises:
a hole transfer region (120) comprising at least one of a hole injection layer (122), a hole transport layer (124), or an electron blocking layer (126); and
an electron transfer region (140) facing the hole transfer region (120) with the emission layer (130) interposed therebetween, the electron transfer region (140) comprising at least one of a hole blocking layer (146), an electron transport layer (144), or an electron injection layer (142),
wherein at least one of the hole transfer region (120), the emission layer (130), or the electron transfer region (140) comprises the at least one condensed heterocyclic compound of Chemical Formula 1.

12. The light-emitting device (ED) of claims 10 or 11, wherein the emission layer (130) comprises a host and a dopant, and the dopant comprises the at least one condensed heterocyclic compound of Chemical Formula 1.

13. The light-emitting device (ED) of claim 12, wherein the dopant further comprises a phosphorescent dopant.

14. An electronic device (10), comprising a display module (11) that comprises the light-emitting device (ED) according to any one of claims 9 to 13.

15. The electronic device (10) of claim 14, wherein the electronic device (10) is one of a flat panel display, a curved display, a computer monitor, a medical monitor, a television, a billboard, a light for indoor or outdoor lighting, a signal lighting, a head-up display, a full or partial transparent display, a flexible display, a rollable display, a foldable display, a stretchable display, a laser printer, a phone, a mobile phone, a tablet, a phablet, a personal information terminal (PDA), a wearable device, a laptop computer, a digital camera, a camcorder, a viewfinder, a micro display, a 3D display, a virtual reality or augmented reality display, a vehicle, a video wall including multiple displays tiled together, a theater or stadium screen, a phototherapy device, or a signage.
